Europäisches Patentamt

European Patent Office

Office européen des brevets

(19)

(11) Veröffentlichungsnummer: **0 345 493 B1**

(12) **EUROPÄISCHE PATENTSCHRIFT**

(45) Veröffentlichungstag der Patentschrift: **09.03.94**

(21) Anmeldenummer: **89108800.7**

(22) Anmeldetag: **17.05.89**

(51) Int. Cl.5: **H05K 7/14**, H04Q 9/14, H05B 37/02

(54) **Anordnung zur Überwachung, Steuerung und Regelung einer betriebstechnischen Anlage eines Gebäudeautomationssystems.**

(30) Priorität: **08.06.88 CH 2178/88**

(43) Veröffentlichungstag der Anmeldung:
**13.12.89 Patentblatt 89/50**

(45) Bekanntmachung des Hinweises auf die Patenterteilung:
**09.03.94 Patentblatt 94/10**

(84) Benannte Vertragsstaaten:
**CH DE FR GB LI SE**

(56) Entgegenhaltungen:
EP-A- 0 262 685    DE-A- 3 124 965
DE-A- 3 603 750    DE-A- 3 612 034
FR-A- 2 535 133    FR-A- 2 553 950
FR-A- 2 568 389    GB-A- 2 014 367

LANDIS & GYR-MITTEILUNGEN, Band 26, Nr. 1, 1979, Seiten 2-12; P. SCHNEIDER et al.: "VISONI-ZLT-System: Anwendung, Aufbau, Funktionen und Möglichkeiten zur Energieeinsparung"

ELEKTRONIK, Band 33, Nr. 21, 19. Oktober 1984, Seite 30, München, DE; H. LEMME: "Zwei Drähte ersetzen Kabelgewirr"

MACHINE DESIGN, Band 59, Nr. 13, 11. Juni 1987, Seiten 122,124, Cleveland, Ohio, US; D. BABIN: "Simplified remote control circuits"

(73) Patentinhaber: **Landis & Gyr Business Support AG**

**CH-6301 Zug(CH)**

(72) Erfinder: **Hilber, Josef**
**Dorfring 18c**
**CH-6319 Allenwinden(CH)**
Erfinder: **Jost, Fritz**
**Unt. Bahnhofstrasse 28**
**CH-8932 Mettmenstetten(CH)**
Erfinder: **Leuthold, Otto**
**Hofstrasse 35**
**CH-6300 Zug(CH)**

EP 0 345 493 B1

## Beschreibung

Die Erfindung bezieht sich auf eine Anordnung zur Überwachung, Steuerung und Regelung einer betriebstechnischen Anlage eines Gebäudeautomationssystems gemäss dem Oberbegriff des Anspruchs 1.

Der Begriff Gebäudeautomationssystem umfasst folgende nicht erschöpfende Liste von Anlagen:
- Heizungs-, Kälte-, Lüftungs- und Klima-Anlagen,
- Anlagen zur Versorgung mit elektrischer Energie, Gas, Wasser, Dampf usw.,
- Anlagen zur Entsorgung (Abwasser, Abfall, Abgas usw.),
- Sicherheitsanlagen (Einbruch, Feuer, Glas usw.),
- Transportanlagen (Aufzüge, Rolltreppen usw.),
- Beleuchtungsanlagen und
- Öffnungsanlagen für Ein/Ausgänge von Gebäuden oder einzelnen Räumen usw.

Der Begriff betriebstechnische Anlage umfasst alle starkstromtechnischen, hydraulischen und pneumatischen Einrichtungen eines Gebäudeautomationssystems inklusive deren Steuer- und Rückmeldeorgane, jedoch ohne die eigentliche Steuerung und Rückmeldung. Die Steuer- und Rückmeldeorgane sind dabei Fühler, z. B. Temperatur- und/oder Druckfühler, Stellglieder für z. B. Mischventile und/oder Motoren von Pumpen, Kompressoren, Gebläse-Brennern und Ventilatoren, oder Schaltelemente, die z. B. aus Schützenspulen und Rückmeldekontakten bestehen.

Die eingangs genannte Anordnung realisiert hauptsächlich folgende vier Funktionen:

1. Überwachung: Diese beinhaltet zentrale Meldungen (Anzeige, Protokollierung, Alarmierung usw.) von aussergewöhnlichen Anlagenzuständen sowie Wartungsmeldungen an das Betriebspersonal.

2. Steuerung: Diese beinhaltet Ein-/Ausschaltungen von Anlagen oder Anlageteilen sowie Sollwertverstellungen durch Programme oder manuelle Eingriffe ab einer Bedienstation.

3. Optimierung des Gesamtbetriebs durch energieoptimale Koordination der einzelnen Teilanlagen. Die im System enthaltenen Rechenprogramme ermöglichen über arithmetische oder logische Verknüpfungen von Zustandsgrössen des Gebäudes (Temperatur, Feuchtigkeit, Tourenzahl, Betriebsstunden usw.) sowie von Vorgabewerten (z. B. Energiekosten pro Energieeinheit, maximaler Wirkungsgrad, Leistungsgrenze usw.) eine Koordination der verschiedenen in einem Gebäude installierten Anlagen und damit eine Optimierung der Betriebskosten.

4. Unterstützung des Gebäudemanagements z. B. durch Betriebsstundenüberwachung, Störstatistik, Wächterrundenüberwachung, Zutrittskontrolle usw.

In der Zeitschrift "Landis & Gyr Mitteilungen", 26. Jahrgang (1979), 1-79, Seiten 2 bis 12, "Visonik-ZLT-System", P. Schneider und J. B. Lumpert, sowie in der Broschüre "Building Management Systems, Einführung in die Systemfamilie Visogyr/Visonik", August 1987, Bestell-Nr. ZXGU 0100D, Landis & Gyr, CH 6301 Zug, Schweiz, ist zur Erfüllung dieser Erfordernisse ein mittels zentraler Leittechnik aufgebautes ZLT-Gebäudeautomationssystem beschrieben, welches es gestattet, eine Zentrale über eine mehradrige Ringleitung mit mehreren, als Unterstationen bezeichneten Subsystemen übertragungstechnisch zu verbinden. Alle Steuer- und Meldeeinrichtungen eines Subsystems sind dabei z. B. in einem Anlagenschrank oder einem Schaltkasten angeordnet.

In diesem bekannten ZLT-Gebäudeautomationssystem wird eine Busschiene verwendet. Der Aufbau dieser Busschiene ist in der Patentschrift GB-PS 2 014 367 beschrieben. Diese Busschiene bildet im ZLT-Gebäudeautomationssystem eine elektrische Busverbindung zwischen einem Kontrollmodul und mehreren Funktionsmodulen eines gleichen Subsystems und enthält eine Vielzahl paralleler, gegeneinander isolierter, elektrischer Leiter, nämlich 33 Stück, zur parallelen Mehrbit-Übertragung von Adressen und Digitalwerten über je einen getrennten Bus, sowie zur analogen Übertragung von Analogwerten und Versorgungsspannungen. Eine Umwandlung der Analogwerten in Digitalwerten erfolgt relativ langsam erst in einem zentralseitigen Computer in und/oder ausserhalb des Kontrollmoduls, so dass der Computer diesbezüglich stark mit zeitaufwendigen Umwandlungsarbeiten belegt ist. Die Positionen, in denen die einzelnen Funktionsmodulen angeordnet sind, sind mit einer codierten Adresse versehen, so dass die einzelnen Funktionsmodule ohne Hardware- und/oder Software-Änderung nur in ganz bestimmte Positionen angeordnet werden können.

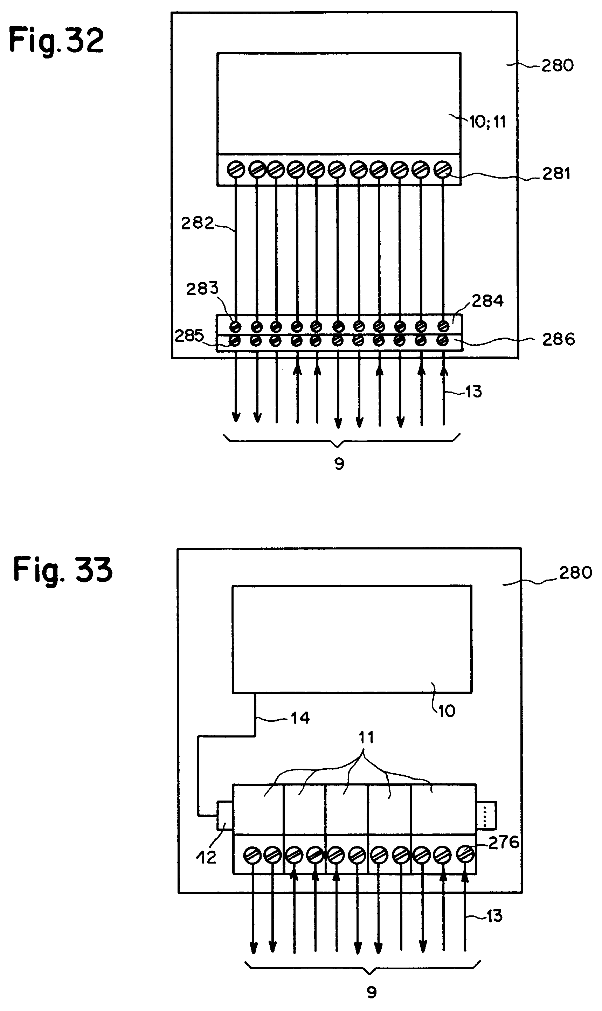

Die Busschiene ist selber modular aufgebaut und besteht aus einer Vielzahl von Anschlussplatten, die seitlich mit ihren gegeneinander stossenden schmalkantigen Längsseiten elektrisch zusammensteckbar sind zwecks Bildung einer langen flachen Busschiene. Zu diesem Zweck sind zwei gegenüberliegende schmalkantige Längsseiten einer jeden Anschlussplatte mit je einem weiblichen bzw. männlichen Steckerteil versehen, die je soviele Anschlusskontakte besitzen wie die Busschiene parallele elektrische Leiter aufweist. Beim Zusammenstecken der Anschlussplatten verbinden die zusammengesteckten Steckerteile parallele elektrische Leiter, die in jeder Anschlussplatte enthalten sind, elektrisch mit gleichnamigen Leitern der benachbarten Anschlussplatten. Je eine grossflächige Seite der Anschlussplatten ist mit weiblichen Steckerteilen versehen, in denen mindestens ein Kontrollmodul oder ein Funktionsmodul, die alle mit männlichen Steckerteilen versehen sind, gesteckt werden kann. Die flache Busschiene ist ihrerseits auf eine Tragschiene montiert oder aufgeschnappt. Ausserdem kann sie unterbrochen, mit mindestens einem Verbindungskabel versehen und - in parallelen Busschienen aufgeteilt - auf mehreren Ebenen in dem Anlagenschrank bzw. Schaltkasten angeordnet werden. Die Funktionsmodule sind somit in Steckerteilen gesteckt, die mit andern Steckerteilen elektrisch verbunden sind, die ihrerseits über Drahtverbindungen mit Anlagenschrank-Klemmen verbunden sind, die an einem Rand, z. B. am unteren Rand, im Innern des Anlagenschrankes angeordnet sind, so dass die Verbindungen zwischen den Funktionsmodulen und der betriebstechnischen Anlage immer über diese Anlagenschrank-Klemmen erfolgen muss (siehe auch Fig. 32), was einen grossen und teuren Klemmen-, Verdrahtungs- und Montageaufwand erfordert.

Der Erfindung liegt die Aufgabe zugrunde, das bekannte ZLT-Gebäudeautomationssystem, möglichst noch unter Verbesserung von dessen Vorteile, derart abzuändern, dass ein noch universelleres ZLT-Gebäudeautomationssystem ensteht, in dem der Verdrahtungs-, Klemmen-, Verbindungsstellen- und Montageaufwand innerhalb des Anlagenschrankes bzw. Schaltkastens auf ein Minimum reduziert ist und in dem eine aufwendige Rangierverdrahtung wegfällt, da die Anschlüsse der betriebstechnischen Anlage nicht an Trennklemmen, sondern direkt an Sockelklemmen der Funktionsmodule angeschlossen sind zwecks Realisierung einer grossen Kosten- und Zeitersparnis.

Die genannte Aufgabe wird erfindungsgemäss durch die im Kennzeichen des Anspruchs 1 angegebenen Merkmale gelöst.

Besonders vorteilhafte Ausführungsformen der Erfindung sind in weiteren Ansprüchen gekennzeichnet.

Zusätzliche Vorteile mindestens einiger dieser Ausführungsformen sind:

- eine hohe Flexibilität der Anordnung hinsichtlich Änderungen und Ausbau des Systems durch eine vollkommen freie Austauschbarkeit von Funktionsmodulen, die ohne Rücksicht auf die eigene Funktionsmodulart und ohne Rücksicht auf die früher einmal am gleichen Ort gesteckte Funktionsmodulart, an beliebigen Orten auf einer Busschiene steckbar sind,
- eine Verminderung der Störanfälligkeit der Anordnung durch Verwirklichung einer weniger störanfälligen Übertragungsverbindung zwischen Kontrollmodul und Funktionsmodulen,
- eine Minimierung der Anzahl Leiter in der Busschiene und dadurch die Möglichkeit, unter Verwendung einer optimal dünnen Kabel-Busverbindung zwischen der Busschiene und dem Kontrollmodul, letzteres auf die Tür seines Anlagenschrankes oder Schaltkastens statt unmittelbar auf die Busschiene anzuordnen, so dass seine Bedien- und Anzeigeelemente direkt von aussen zugänglich sind, ohne dass diese Tür geöffnet werden muss,
- eine Reduktion der Anzahl Fehlerquellen, da die Inbetriebsetzung und das Austesten der Anlage hinsichtlich des Vorhandenseins von Verdrahtungsfehlern vereinfacht ist,
- eine Reduktion des Projektierungsaufwandes bei der Aufstellung von Stromlaufplänen, Drahtzugslisten usw.,
- eine hohe Installations- und Service-Freundlichkeit,
- ein geringer Platzbedarf mit einem hohen Ausnützungsgrad,
- eine sekundenschnelle Umwandlung von Analogwerten in Digitalwerten unter Entlastung eines zentralseitigen Computers in und/oder ausserhalb des Kontrollmoduls von allen zeitaufwendigen Umwandlungsarbeiten und
- eine Verringerung der Anzahl der im Feld konfektionierten Kabelbäume.

Ein Ausführungsbeispiel der Erfindung ist in der Zeichnung dargestellt und wird im folgenden näher beschrieben.

Es zeigen:

Fig. 1    eine bekannte Anordnung zur Überwachung und Steuerung einer betriebstechnischen Anlage eines Gebäudeautomationssystems,

Fig. 2    eine erfindungsgemässe Abänderung der in der Fig. 1 dargestellten Anordnung,

Fig. 3    ein elektrisches Blockschaltbild eines in der Fig. 2 dargestellten Subsystems,

Fig. 4    ein Blockschaltbild eines mit zahlreichen Funktionsmodulen ausgerüsteten Übertragungssystems,

Fig. 5    ein Schaltbild eines mit einem einzigen Funktionsmodul ausgerüsteten Übertragungssystems,

Fig. 6    ein Schaltbild einer Steuereinheit zu einer Pegelanpass-Schaltung,

Fig. 7    ein Blockschaltbild einer Eingangsschaltung eines Kontrollmoduls,

Fig. 8    ein Blockschaltbild einer Interfaceschaltung des Kontrollmoduls,

Fig. 9    ein Blockschaltbild einer Interface-

Fig.10 ein Blockschaltbild eines Steuergerätes,

Fig.11 ein Blockschaltbild einer ersten Steuereinheit des Steuergerätes,

Fig.12 ein Blockschaltbild einer zweiten Steuereinheit des Steuergerätes,

Fig.13 ein Schaltbild eines Adressenkomparators,

Fig.14 ein Schaltbild eines Funktionsdecodierers,

Fig.15 ein Schaltbild einer Ausgangsstufe,

Fig.16 ein Schaltbild eines Zufallscodegenerators,

Fig.17 ein Schaltbild eines Eingangsfilters,

Fig.18 ein Schaltbild eines CRC-Generators,

Fig.19 ein Schaltbild eines Multiplexers,

Fig.20 ein Schaltbild eines Mithör-Fehlerdetektors,

Fig.21 ein Schaltbild eines Taktsynchronisierers,

Fig.22 ein Schaltbild eines Taktsignal-Statusspeichers,

Fig.23 ein Blockschaltbild einer Ausgangsschaltung einer ersten Variante des Funktionsmoduls,

Fig.24 ein Blockschaltbild einer Ausgangsschaltung einer zweiten Variante des Funktionsmoduls,

Fig.25 ein Blockschaltbild einer Ausgangsschaltung einer dritten Variante des Funktionsmoduls,

Fig.26 eine symbolische Darstellung eines Schreibzyklus eines Datentelegramms,

Fig.27 eine symbolische Darstellung eines Lesezyklus eines Datentelegramms,

Fig.28 ein Schaltbild eines Beispiels der Ansteuerung einer betriebstechnischen Anlage durch eine Ausgangsschaltung,

Fig.29 eine symbolische Darstellung einer erweiterten Busschiene,

Fig.30 eine räumliche Darstellung eines Speisemoduls,

Fig.31 eine räumliche Darstellung von Funktionsmodulen,

Fig.32 eine schematische Darstellung eines räumlichen Aufbaus einer konventionellen Anordnung,

Fig.33 eine schematische Darstellung eines räumlichen Aufbaus einer erfindungsgemässen Anordnung und

Fig.34 eine schematische Darstellung eines räumlichen Aufbaus eines erfindungsgemässen Anlagenschrankes.

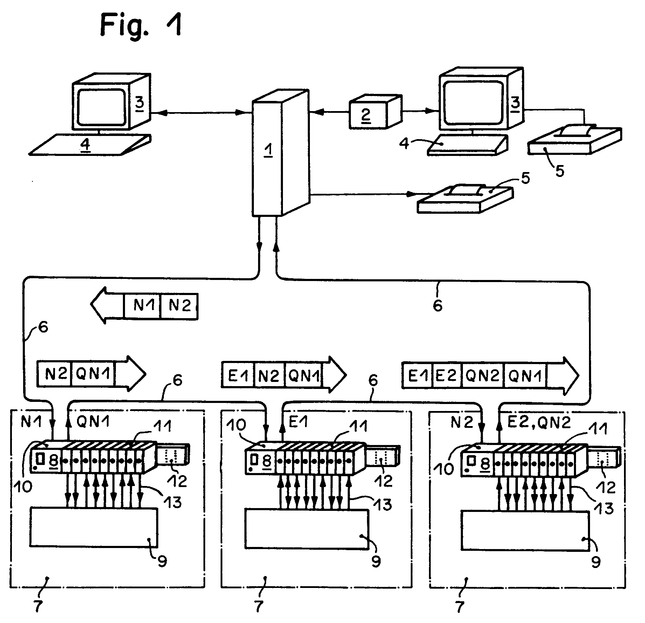

Zum besseren Verständnis des Unterschiedes zwischen der Erfindung und dem obengenannten Stand der Technik ist das bekannte ZLT-Gebäudeautomationssystem in der Fig. 1 noch einmal dargestellt.

Die Zentrale enthält dementsprechend einen zentralen Rechner 1, der direkt und/oder über eine Anpass-Schaltung 2 mit einem oder mehreren Bedienterminal 3; 4 verbunden ist, die je aus einem Sichtgerät 3 (Bildschirm) und einer Tastatur 4 bestehen. Ausserdem ist in der Regel der Rechner 1 und/oder eines der Bedienterminal 3; 4 an einem Drucker 5 angeschlossen. Eine Ringleitung 6 verbindet den Rechner 1 mit einem oder mehreren Subsystemen 7. Jedes Subsystem 7 befindet sich vorzugsweise in einem oder mehreren eigenen Schaltschränken. In der Fig. 1 wurde das Vorhandensein von drei Subsystemen 7 angenommen. Jedes Subsystem 7 enthält eine sogenannte elektronische Klemmleiste 8 und eine betriebstechnische Anlage 9. Die elektronische Klemmleiste 8 besteht mindestens aus je einem Kontrollmodul 10, einem Funktionsmodul 11 und einer Busschiene 12. Die Busschiene 12 weist eine Vielzahl von gegeneinander isolierten parallelen elektrischen Leitern auf, die in der Fig. 1 nicht dargestellt sind. Der Rechner 1 und die Kontrollmodule 10 aller Subsysteme 7 bilden mit Hilfe der Ringleitung 6 einen elektrischen Ring, d. h. alle Kontrollmodule 10 sind elektrisch in Kaskade geschaltet, wobei ein Ausgang des Rechners 1 mit einem Eingang des ersten Kontrollmoduls 10 der Kaskadenschaltung und der Ausgang des letzten Kontrollmoduls 10 der Kaskadenschaltung mit einem Eingang des Rechners 1 verbunden ist.

Binäre Daten werden vorzugsweise frequenzmoduliert, z. B. mittels einer Frequenzumtastung ("Frequency Shift Keying": FSK), in einer Richtung vom Ausgang des Rechners 1 über die Ringleitung 6 und die Kontrollmodule 10 zum Eingang des Rechners 1 übertragen. Der Datenfluss ist in der Fig. 1 durch breite Pfeile symbolisch dargestellt. Es werden z. B. Befehle als Nachrichten N1 und N2 vom Rechner 1 zu dem ersten bzw. dritten Subsystem 7 übertragen, entsprechend zugehörige Nachrichten-Quittungen QN1 bzw. QN2 werden dann vom ersten bzw. dritten Subsystem 7 jeweils zum Rechner 1 übermittelt. Ausserdem werden Ereignisse E1 und E2, die Zustandsänderungen in den betriebstechnischen Anlagen 9 der zugehörigen Subsysteme 7 darstellen, vom zweiten bzw. dritten Subsystem 7 zum Rechner 1 hin übertragen. Die übertragenen Datentelegramme sind mit einem zyklischen Paritycode ("Cyclic redundancy code": CRC) gesichert. Bei vorhandenen Übertragungsfehlern wird die Existenz eines Fehlers erkannt und das gesendete zugehörige Datentelegramm noch einmal wiederholt.

Alle Kontrollmodule 10 sind identisch aufgebaut und enthalten beim bekannten ZLT-Gebäudeautomationssystem unter anderem je einen Frequenzdemodulator, einen Frequenzmodulator, einen Mikrocomputer, einen Analog/Digital-Wandler sowie ein Speisegerät für die elektronische Klemmleiste 8. Die Kontrollmodule 10 enthalten ausserdem je eine "Watchdog"-Schaltung (Wachthundschaltung) zur Eigenüberwachung. Ein Ansprechen der Eigenüberwachung wird am zugehörigen Kontrollmodul 10 angezeigt und auf einem Drucker 5 protokolliert. Auf den Frontplatten der Kontrollmodule 10 befinden sich Indikatoren für die Eigenüberwachung sowie Buchsen zum Anschliessen eines nicht dargestellten örtlichen Bediengerätes. Das Kontrollmodul 10 eines jeden Subsystems 7 steuert und überwacht für seinen Bereich vollkommen unabhängig den gesamten Datenverkehr innerhalb seiner elektronischen Klemmenleiste 8, aber auch zu seinem örtlichen Bediengerät und zum Rechner 1.

Räumlich neben dem Kontrollmodul 10 sind auf der Busschiene 12 in einer Reihe nebeneinander Funktionsmodule 11 eines gleichen Subsystems 7 elektrisch steckbar angeordnet. Die Steckkontakte der Busschiene 12 sind, soweit sichtbar, in der Fig. 1 nur symbolisch durch Punkte dargestellt. Die Funktionsmodule 11 sind z. B. Meldungs-Module, Messwert-Module, Zählwert-Module, Schaltbefehls-Module und Stellbefehls-Module, also Ein-/Ausgabemodule, die unterschiedlich aufgebaut sein können. Jedes Funktionsmodul 11 ist über mindestens eine getrennte Kabelverbindung 13, die nach örtlichen Installationsvorschriften erstellt wird, mit den Steuer- und Rückmeldeorganen der betriebstechnischen Anlage 9 seines Subsystems 7 verbunden. Die Funktionsmodule 11 stellen somit elektrische Verbindungen her zwischen der betriebstechnischen Anlage 9 und der Busschiene 12 und damit zwischen den Prozessgrössen der als Peripherie dienenden betriebstechnischen Anlage 9 und dem zugehörigen Kontrollmodul 10. Informationsdaten, wie z. B. Meldungen, analoge Messwerte, digitale Zählwerte, Schaltbefehle oder Stellbefehle, werden über die Kabelverbindungen 13 in der einen oder anderen Richtung zwischen der betriebstechnischen Anlage 9 und den zugehörigen Funktionsmodulen 11 des gleichen Subsystems 7 übertragen.

Die Prozessgrössen der betriebstechnischen Anlage 9 werden z. B. periodisch in einem schnellen Zyklus abgefragt und allfällige Zustandsänderungen zum Rechner 1 übertragen, wobei die analogen Messwerte eines Subsystems 7 jeweils zentral im zugehörigen Kontrollmodul 10 des Subsystems 7 digitalisiert werden. Die Hauptaufgabe der elektronischen Klemmleiste 8 ist somit:

- Ein periodisches Erfassen der Zustandsänderungen der angeschlossenen betriebstechnischen Anlage 9 und

- eine Ausgabe von Nachrichten (Befehlen) an die betriebstechnische Anlage 9.

Die Funktionsmodule 11 bereiten dabei die Signale der betriebstechnischen Anlage 9 auf und stellen mit Hilfe der Busschiene 12 Verbindungen her zwischen dem Kontrollmodul 10 und den Prozessgrössen der betriebstechnischen Anlage 9.

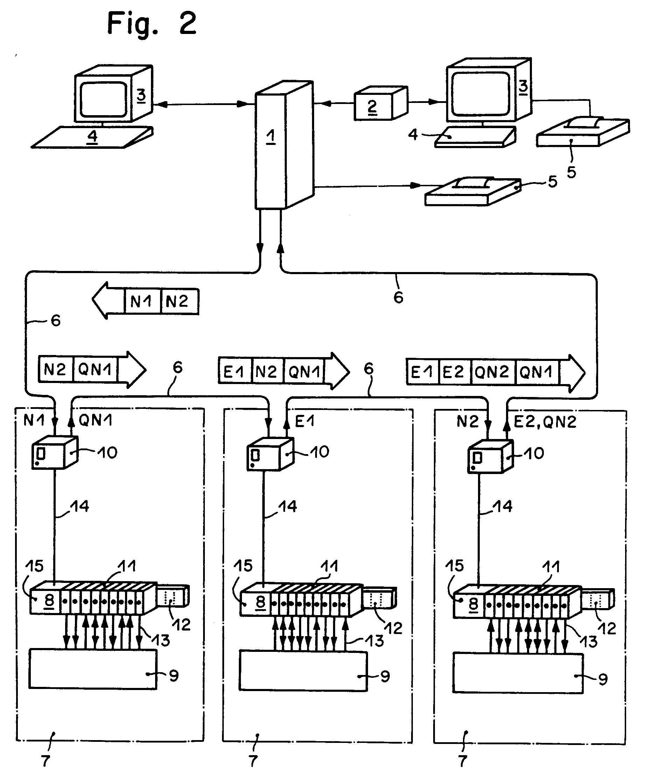

Die in der Fig. 2 dargestellte erfindungsgemässe Anordnung unterscheidet sich von der in der Fig. 1 dargestellten bekannten Anordnung dadurch, dass in jedem Subsystem 7 räumlich das Kontrollmodul 10 nicht mehr unmittelbar neben den zugehörigen Funktionsmodulen 11 auf einer Busschiene 12 gesteckt ist, sondern dass es räumlich getrennt und entfernt von jeder Busschiene 12 und den Funktionsmodulen 11 angeordnet ist, und somit nicht mehr auf eine der Busschienen 12 gesteckt ist. Das Kontrollmodul 10 ist dabei z. B. auf eine andere parallele Busschiene gesteckt, auf einen Schwenkrahmen montiert oder vorzugsweise auf die Tür eines Anlagenschrankes oder Schaltkastens angeordnet. Letzeres hat den Vorteil, dass alle Bedien- und Meldeelemente, die auf der Frontplatte der Kontrollmodule 10 angeordnet sind, von aussen erreichbar sind, ohne dass die Tür dabei geöffnet werden muss. Die Kontrollmodule 10 sind in der Anordnung der Fig. 2 über mindestens je eine Kabel-Busverbindung 14 mit mindestens einem Speisemodul 15 verbunden, welches jeweils neben oder zwischen den zugehörigen Funktionsmodulen 11 auf deren Busschiene 12 elektrisch gesteckt ist zwecks elektrischem Anschluss mindestens einer Kabel-Busverbindung 14 an die Busschiene 12. Die elektronische Klemmleiste 8 wird diesmal gebildet durch das Speisemodul 15, die zugehörigen Funktionsmodule 11 und die zugehörige Busschiene 12. Die Kabel-Busverbindung 14 hat in einer ersten Variante jeweils genau soviele elektrische Leiter wie die Busschiene 12. Das Kontrollmodul 10 eines jeden Subsystems 7 ist über dessen Kabel-Busverbindung 14, das zugehörige Speisemodul 15 und die zugehörige Busschiene 12 mit den Funktionsmodulen 11 dieses Subsystems 7 elektrisch verbunden.

Im erfindungsgemässen Gebäudeautomationssystem müssen die Zentrale 1; 2; 3; 4; 5 und die Ringleitung 6 nicht unbedingt so aufgebaut sein, wie sie in den Figuren 1 und 2 dargestellt sind, sondern sie können auch auf eine andere Art realisiert werden.

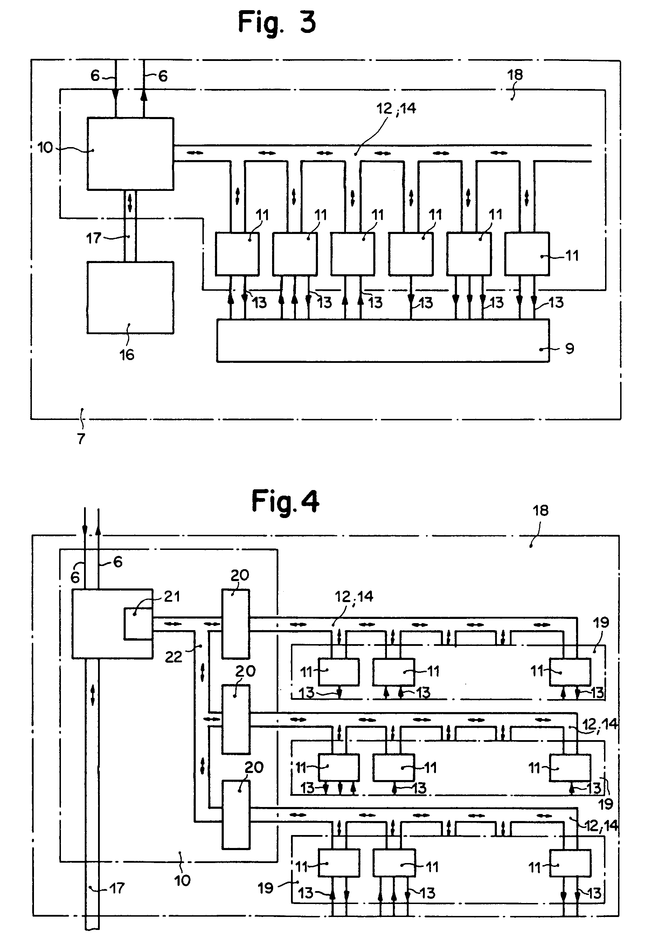

In der Fig. 3 ist - unter Weglassung des Speisemoduls 15 und der elektrischen Steckerteile der Busschiene 12 - das elektrische Blockschaltbild eines der erfindungsgemässen Subsysteme 7 der in der Fig. 2 dargestellten Anordnung wiedergegeben. Das Kontrollmodul 10 und die Funktionsmodule 11 sind dabei über mindestens eine bidirektionelle Busverbindung 12; 14 verbunden, wobei die Busanschlüsse der Kontroll- und Funktionsmodule 10 und 11 elektrisch miteinander verbunden sind zwecks Übertragung von Adressen, Daten und Versorgungsspannungen. Die Busverbindung 12; 14 enthält mindestens je eine Busschiene 12 und Kabel-Busverbindung 14. Sie besteht somit mindestens teilweise aus einer Busschiene 12, auf der mindestens eines der Funktionsmodule 11 elektrisch steckbar angeordnet ist, welches einerseits mit Leitern dieser Busschiene 12 und anderseits zwecks Übertragung von Prozessgrössen mit Steuer- und/oder Meldeeinrichtungen der betriebstechnischen Anlage 9 elektrisch verbunden ist. Jedes Funktionsmodul 11 besitzt zu diesem letzten Zweck Kabelanschlüsse, über die es mittels Kabelverbindungen 13 mit Ein- und Ausgängen der als Peripherie dienenden betriebstechnischen Anlage 9 verbunden ist. Eine Bedieneinrichtung 16 ist über eine eigene Busverbindung 17 an das Kontrollmodul 10 angeschlossen. Alle Kontroll- und Funktionsmodule 10 und 11 enthalten je einen Sender/Empfänger und bilden zusammen mit der als Übertragungskanal dienenden Busverbindung 12; 14 ein Übertragungssystem 18, in dem das bedienseitige Kontrollmodul 10 immer als Master-Sender-Empfänger und die Funktionsmodule 11 immer als Slave-Sender-Empfänger arbeiten und wobei das Übertragungssystem 18 dem Zweck der Übertragung von Adressen, Daten und Versorgungsspannungen dient.

Wenn zahlreiche Funktionsmodule 11 vorhanden sind, z. B. mehr als 32 Stück, dann werden diese aus Gründen der verbrauchten elektrischen Leistung vorzugsweise in mehreren Gruppen unterteilt. In der Fig. 4 wurde das Vorhandensein dreier solcher Funktionsmodul-Gruppen 19 angenommen mit total höchstens 96 Funktionsmodulen 11. Jede Funktionsmodul-Gruppe 19 wird vorzugsweise von einer eigenen Pegelanpass-Schaltung 20 über eine eigene Busverbindung 12; 14 angesteuert. In der Darstellung der Fig. 4 sind somit drei Pegelanpass-Schaltungen 20 und drei Busverbindungen 12; 14 vorhanden. Das gemeinsame Kontrollmodul 10 enthält dann unter anderem eine Ausgangsschaltung, die mindestens aus einer Pegelanpass-Schaltung 20 pro Kontrollmodul 10 und einer dieser vorgeschalteten gemeinsamen Interfaceschaltung 21 besteht, wobei Ein-/Ausgänge der Interfaceschaltung 21 über einen eigenen bidirektionellen Bus 22 mit parallelgeschalteten Ein-/Ausgängen der Pegelanpass-Schaltungen 20 verbunden sind. Die Pegelanpass-Schaltungen 20 sind alle identisch aufgebaut.

Nachfolgend wird aus Gründen der zeichnerischen Einfachheit immer angenommen, dass nur eine einzige Funktionsmodulgruppe 19 vorhanden ist, so dass das Kontrollmodul 10 in diesem Fall nur eine einzige Pegelanpass-Schaltung 20 aufweist.

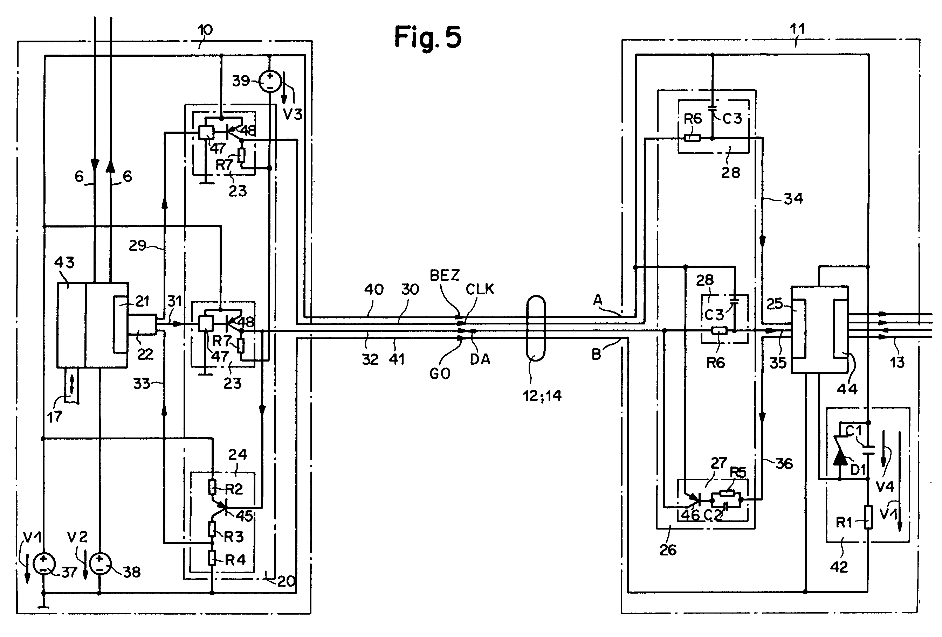

Jedem Funktionsmodul 11 ist eine positionsunabhängige Adresse zugeordnet, die mechanisch und/oder elektrisch beliebig einstellbar ist. Innerhalb der Busverbindung 12; 14 ist ein einziger Bus vorhanden zur Übertragung von Datensignalen DA, welche sowohl die zu übertragenden Daten als auch diese Adressen der Funktionsmodule 11 enthalten. Die Datensignale DA sind binäre Datentelegramme, wobei die Adressen und Daten zeitseriell übertragen werden. Der einzige Bus, der der Übertragung der Datensignalen DA dient, besteht vorzugsweise aus einem einzigen Leiter (siehe Leiter 32 in der Fig. 5).

Da alle Funktionsmodule 11 busschienenseitig identisch aufgebaut sind und sie an ihren Busanschlüssen parallel geschaltet sind, genügt es zur Erläuterung der Funktionsweise des Übertragungssystems eine mit nur einem einzigen Funktionsmodul 11 ausgerüstete Anordnung zu beschreiben. Ein solches, in der Fig. 5 dargestelltes Übertragungssystem enthält mindestens ein Kontrollmodul 10, welches über eine Busverbindung 12; 14 mit einem einzigen Funktionsmodul 11 verbunden ist. Die Interfaceschaltung 21 des Kontrollmoduls 10 ist innerhalb des letzten mit Hilfe von drei Leitern, die zusammen einen Bus 22 bilden, mit je einem Anschluss der Pegelanpass-Schaltung 20 des Kontrollmoduls 10 verbunden. Jede Pegelanpass-Schaltung 20 besteht aus zwei Sendeschaltungen 23, eine für ein Taktsignal CLK und eine für Datensignale DA, und einer Empfangsschaltung 24 für die Datensignale DA. Jedes Funktionsmodul 11 besitzt unter anderem an seinem Eingang eine Anpass-Schaltung 26 und eine dieser nachgeschaltete Interfaceschaltung 25, die beide für alle Funktionsmodule 11 identisch aufgebaut sind. Jede Anpass-Schaltung 26 der Funktionsmodule 11 besteht aus einer Sendeeinheit 27 für die Datensignale DA und zwei Empfangseinheiten 28, eine für das Taktsignal CLK und eine für die Datensignale DA. Ein erster Leiter 29 des Busses 22 verbindet im Kontrollmodul 10 einen ersten Ausgang der Interfaceschaltung 21 mit einem Eingang einer ersten der beiden Sendeschaltungen 23 der Pegelanpass-Schaltung 20. Ein Ausgang dieser ersten Sendeschaltung 23 ist über einen Leiter 30 der Busverbindung 12; 14 auf einen Eingang einer ersten der beiden Empfangseinheiten 28 der Anpass-Schaltung 26 des Funktionsmoduls 11 geführt. Der Leiter 30 ist ein Synchronisationsleiter und dient der Übertragung des Taktsignals CLK ("CLOCK") vom Kontrollmodul 10 zu allen Funktionsmodulen 11. Ein zweiter Leiter 31 des Busses 22 verbindet im Kontrollmodul 10 einen zweiten Ausgang der Interfaceschaltung 21 mit einem Eingang der zweiten Sendeschaltung 23 der Pegelanpass-Schaltung 20. Ein Ausgang dieser zweiten Sendeschaltung 23 ist über einen Leiter 32 der Busverbindung 12; 14 auf einen Eingang der zweiten Empfangseinheit 28 sowie auf einen Ausgang der Sendeeinheit 27 jeweils der Anpass-Schaltung 26 des Funktionsmoduls 11 geführt und ausserdem im Kontrollmodul 10 direkt mit einem Eingang der Empfangsschaltung 24 der Pegelanpass-Schaltung 20 verbunden. Der dritte Leiter 33 des Busses 22 verbindet im Kontrollmodul 10 einen Ausgang der Empfangsschaltung 24 der Pegelanpass-Schaltung 20 mit einem Eingang der Interfaceschaltung 21. Der Leiter 32 der Busverbindung 12; 14 ist ein Datenleiter und dient als einziger Leiter der zeitseriellen Übertragung in beiden Richtungen der Datensignale DA zwischen den Kontroll- und Funktionsmodulen 10 und 11. Ein Ausgang der ersten Empfangseinheit 28 ist im Funktionsmodul 11 über einen Leiter 34, ein Ausgang der zweiten Empfangseinheit 28 über einen Leiter 35 und ein Eingang der Sendeeinheit 27 über einen Leiter 36 mit je einem Anschluss der Interfaceschaltung 25 verbunden.

Im Kontrollmodul 10 ist ausserdem noch eine erste Gleichspannungsquelle 37, eine zweite Gleichspannungsquelle 38 und pro Funktionsmodul-Gruppe 19, d. h. auch pro Pegelanpass-Schaltung 20, je eine dritte Gleichspannungsquelle 39 vorhanden. Die Gleichspannungsquelle 37 besitzt z. B. eine Ausgangsgleichspannung von ca 21 Volt, während die Gleichspannungsquellen 38 und 39 vorzugsweise je eine Ausgangsspannung V2 bzw. V3 von ca 5 Volt aufweisen. Alle Gleichspannungsquellen 37 bis 39 bestehen z. B. je aus einem Netzgerät, das von einer Netzwechselspannung von 220 Volt oder 110 Volt gespeist ist. Die niedrigeren Ausgangsgleichspannungen V2 und V3 der Gleichspannungsquellen 38 und 39 können aber auch von der höheren Ausgangsgleichspannung der Gleichspannungsquelle 37 abgeleitet werden. In diesem Fall werden alle Gleichspannungsquellen 38 und 39 mit der Ausgangsgleichspannung der Gleichspannungsquelle 37 gespeist. Die Gleichspannungsquellen 38 und 39 bestehen dann je aus einem Vorwiderstand und einer nachgeschalteten Parallelschaltung einer Zenerdiode und eines Kondensators (siehe in der Fig. 5 den identischen Aufbau einer Gleichspannungsquelle 42 des Funktionsmoduls 11). Der gemeinsame Pol des Vorwiderstandes, des Kondensators und der Zenerdiode bilden in diesem Fall den Ausgang der Gleichspannungsquellen 38 und 39. Die Spannungen des Gesamtsystems, der Kontrollmodule 10 und der Geräte der betriebstechnischen Anlage 9 sind auf ein gemeinsames Potential GO bezogen, welches als gemeinsames Bezugspotential (Nullwert) dient. Die negativen Pole der beiden Gleichspannungsquellen 37 und 38 sind miteinander verbunden und liegen am gemeinsamen Potential GO. Die positiven Pole aller Gleichspannungsquellen 37 und 39 sind ebenfalls miteinander verbunden. An ihnen steht ein elektrisches Potential BEZ an und sie bilden zusammen den positiven Pol einer Versorgungsgleichspannung V1 der Funktionsmodule 11. Diese Versorgungsgleichspannung V1 ist gleich der Ausgangsgleichspannung der Gleichspannungsquelle 37, so dass der negative Pol der Versorgungsgleichspannung V1 am Potential GO liegt. Die positiven Pole der Gleichspannungsquellen 37 und 39 sind als erste Pole zwecks Speisung der Funktionsmodule 11 mit ihrer Versorgungsgleichspannung V1 mit dem zweiten Leiter 40 des Leiterpaares 40; 41 der Busverbindung 12; 14 und über diesen mit einem positiven Speisepol A der Funktionsmodule 11 verbunden. Die miteinander verbundenen negativen Pole der Gleichspannungsquellen 37 und 38 sind zum gleichen Zweck über einen Leiter 41 der Busverbindung 12; 14 mit einem negativen Speisepol B der Funktionsmodule 11 verbunden, der deren Masseanschluss bildet. Die Gleichspannungsquelle 38 speist unter Ausnahme der Pegelanpass-Schaltung 20 die Elektronik des Kontrollmoduls 10, die Gleichspannungsquelle 39 speist dagegen über ihren zweiten Pol den Speisepol aller Sendeschaltungen 23 ihrer eigenen Pegelanpass-Schaltung 20, während die Gleichspannungsquelle 37 ihrerseits ausser alle Funktionsmodule 11 noch die Empfangsschaltung 24 aller Pegelanpass-Schaltungen 20 speist.

In jedem Funktionsmodul 11 befindet sich eine eigene Gleichspannungsquelle 42, die vorzugsweise ein Gleichspannungswandler ("DC/DC-Converter") ist, der über die beiden Leiter 40 und 41 der Busverbindung 12; 14 und die beiden Speisepole A und B der Funktionsmodule 11 mit der Versorgungsgleichspannung V1 der Gleichspannungsquelle 37 gespeist wird. Jede Gleichspannungsquelle 42 besteht vorzugsweise aus einer Reihenschaltung eines Vorwiderstandes R1 und einer Parallelschaltung einer Zenerdiode D1 und eines Kondensators C1. Die auf den positiven Speisepol A bezogene Ausgangsgleichspannung V4 der Gleichspannungsquelle 42 wird am gemeinsamen Pol des Vorwiderstandes R1, des Kondensators C1 und der Zenerdiode D1 abgegriffen und speist die Elektronik des zugehörigen Funktiondsmoduls 11. Die Ausgangsgleichspannung V4 der Gleichspannungsquelle 42 besitzt vorzugsweise einen Wert von ca 5 Volt. Wenn in einem Funktionsmodul 11 ein Analog/Digital-Wandler oder ein Digital/Analog-Wandler vorhanden ist, dann ist zu dessen Speisung in diesem Funktionsmodul 11 noch die Existenz einer nicht dargestellten weiteren Gleichspannungsquelle notwendig, die gleich aufgebaut sein kann wie die erste, jedoch eine Ausgangsgleichspannung von ca 10 Volt aufweist.

Das Kontrollmodul 10 ist über die Ringleitung 6 mit dem in der Fig. 5 nicht mehr dargestellten Rechner 1 (siehe Fig. 2) verbunden. Ausser der Pegelanpass-Schaltung 20 und der Interfaceschaltung 21 besitzt das Kontrollmodul 10 noch eine Eingangsschaltung 43, die über die Busverbindung 17 auf der, in der Fig. 5 ebenfalls nicht mehr dargestellten Bedieneinrichtung 16 (siehe Fig. 3) geführt ist.

Ausser der Anpass-Schaltung 26 und der Interfaceschaltung 25 besitzt jedes Funktionsmodul 11 noch eine Ausgangsschaltung 44, die über Kabelverbindungen 13 mit der in der Fig. 5 nicht mehr dargestellten betriebstechnischen Anlage 9 (siehe Fig. 2) verbunden ist. In der Ausgangsschaltung 44 sind nicht dargestellte Relaisausgangsschaltungen vorhanden, die z. B. direkt von der Versorgungsgleichspannung V1 der Funktionsmodule 11 gespeist sind.

Die Empfangsschaltungen 24 der Pegelanpass-Schaltungen 20 des Kontrollmoduls 10 bestehen jeweils aus einem Transistor 45, der z. B. ein bipolarer PNP-Transistor ist, und drei Widerständen R2, R3 und R4. Die Basis des Transistors 45 bildet den Eingang der Empfangsschaltung 24, sein Emitter liegt über den Widerstand R2 am positiven Pol der Gleichspannungsquelle 37, während sein Kollektor über den Widerstand R3 mit dem Ausgang der Empfangsschaltung 24 verbunden ist, der seinerseits über den Widerstand R4 auf den negativen Pol der Gleichspannungsquellen 37 und 38 geführt ist.

Die Sendeeinheit 27 der Anpass-Schaltung 26 eines jeden Funktionsmoduls 11 besteht aus einem Transistor 46, der z. B. ein bipolarer PNP-Transistor ist, und einer Parallelschaltung R5; C2 eines Widerstandes R5 und eines Kondensators C2. Innerhalb der Sendeeinheit 27 ist deren Eingang über die Parallelschaltung R5; C2 auf die Basis des Transistors 46 geführt, dessen Kollektor den Ausgang der Sendeeinheit 27 bildet und dessen Emitter mit dem positiven Speisepol A des zugehörigen Funktionsmoduls 11 verbunden ist.

Die Empfangseinheiten 28 der Anpass-Schaltung 26 eines jeden Funktionsmoduls 11 bestehen aus der Reihenschaltung eines Widerstandes R6 und eines Kondensators C3, wobei der gemeinsame Pol dieser beiden Bauelemente R6 und C3 den Ausgang und der andere Pol des Widerstandes R6 den Eingang jeweils der Empfangseinheit 28 bildet. Der andere Pol des Kondensators C3 ist jeweils mit dem positiven Speisepol A des zugehörigen Funktionsmoduls 11 verbunden.

Die Sendeschaltungen 23 der Pegelanpass-Schaltungen 20 des Kontrollmoduls 10 bestehen jeweils aus einer Steuereinheit 47, einem Transistor 48, der z. B. ein bipolarer PNP-Transistor ist, und einem Widerstand R7, wobei die Steuereinheit 47 jeweils im Kontrollmodul 10 durch die Versorgungsgleichspannung V1 gespeist ist. Der Eingang der Steuereinheit 47 bildet den Eingang der Sendeschaltung 23, während der Ausgang der Steuereinheit 47 auf die Basis des Transistors 48 geführt ist. Der Emitter des Transistors 48 ist jeweils mit dem positiven Pol der Gleichspannungsquellen 37 und 39 verbunden, während sein Kollektor über den Widerstand R7 auf einen Speisepol der Sendeschaltung 23 geführt ist, der seinerseits jeweils mit dem als zweiten Pol dienenden negativen Pol der Gleichspannungsquelle 39 verbunden ist. Der Kollektor des Transistors 48 bildet ausserdem den Ausgang der Sendeschaltung 23.

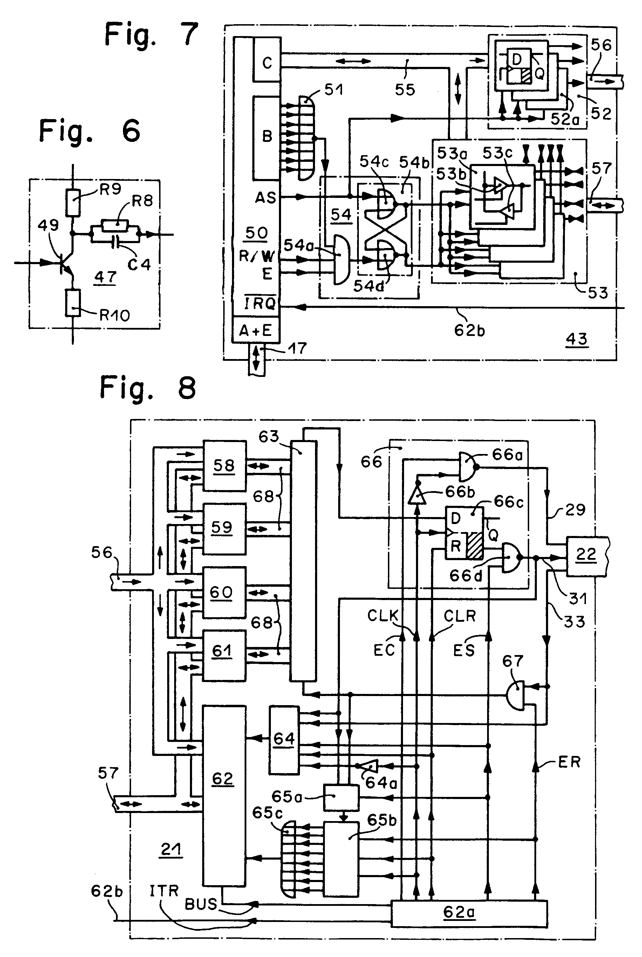

Der Aufbau der Steuereinheit 47 ist aus der Fig. 6 ersichtlich und besteht aus einem Transistor 49, der z. B. ein bipolarer NPN-Transistor ist, einer Parallelschaltung C4; R8 eines Kondensators C4 und eines Widerstandes R8, einem Widerstand R9 und einem Widerstand R10. Die Basis des Transistors 49 bildet den Eingang der Steuereinheit 47, sein Kollektor ist einerseits über den Widerstand R9 mit dem positiven Pol der Gleichspannungsquellen 37 und 39 und anderseits über die Parallelschaltung C4; R8 mit dem Ausgang der Steuereinheit 47 verbunden. Der Emitter des Transistors 49 ist über den Widerstand R10 auf den negativen Pol der Gleichspannungsquellen 37 und 38 geführt. Der Kondensator C4 sowie der Kondensator C2 der Sendeeinheit 27 (siehe Fig. 5) dienen jeweils dazu, die Flankensteilheit der übertragenen Impulse zu verbessern. Der Transistor 49 und die Transistoren 45, 46 und 48 (siehe Fig. 5) arbeiten jeweils als Schalter.

Die Busverbindung 12; 14 enthält somit gemäss der Fig. 5 mindestens vier elektrische Leiter 30, 32, 40 und 41, wovon ein Leiterpaar 40; 41 bestehend aus einem ersten Leiter 41 und einem zweiten Leiter 40 der zweipoligen Übertragung der Versorgungsgleichspannung V1 vom Kontrollmodul 10 zu den Funktionsmodulen 11 dient, wobei der erste Leiter 41 am Potential G0 liegt. Die Busverbindung 12; 14 enthält ausserdem einen dritten elektrischen Leiter 30 zur Übertragung eines periodischen Taktsignals CLK ebenfalls vom Kontrollmodul 10 zu den Funktionsmodulen 11. Ausser allen Versorgungsspannungsleitern 40 und 41 sowie dem Taktleiter 30 ist in der Busverbindung 12; 14 nur noch ein einziger, vierter elektrischer Leiter 32 vorhanden zwecks einer serieller Übertragung von binären Daten des Datensignals DA zwischen den Kontroll- und Funktionsmodulen 10 und 11. Das Taktsignal CLK ist vorzugsweise periodisch rechteckförmig und dient der Synchronisation von unmoduliert übertragenenen binären Datentelegrammen, die das Datensignal DA bilden.

Der als Gesamtsystem-Masseleiter dienende Leiter 41 kann ausserhalb der Busschiene 12 einzeln und räumlich von den drei anderen Leitern 30, 32 und 40 getrennt verlegt sein, während die drei letztgenannten Leiter zusammen ausserhalb der Busschiene 12 zusammen vorzugsweise ein dreipoliges Flachband- oder Rundkabel bilden.

Das auf dem zweiten Leiter 40 des Leiterpaares 40; 41 anstehende Potential BEZ ist dasjenige des positiven Pols der Versorgungsgleichspannung V1 und ist gleichzeitig das gemeinsame Potential (Nullwert), auf das die Spannungen der übertragenen Signale DA und CLK bei ihrer Übertragung über die Busverbindung 12; 14 sowie die Spannungen der Elektronik der Funktionsmodule 11 bezogen sind, statt dass sie auf das Potential GO des ersten Leiters 41 des Leiterpaares 40; 41 bezogen sind. Durch Verwendung des Potentials BEZ des Leiters 40 als Bezugspotential für die Übertragung statt des Potentials GO des Leiters 41, wird der Störabstand der Übertragung stark verbessert, da das Potential GO der Gesamtsystemmasse und damit des Leiters 41 weit davon entfernt ist, ideal konstant zu sein. Über die Gesamtsystemmasse fliessen nämlich in der Regel starke Schalt- und Wechselströme, die im Leiter 41 hohe ohmsche und/oder induktive Spannungsabfälle verursachen können. Beide Signale DA und CLK besitzen binäre Werte, wobei der Logikwert "O" einem Wert von annähernd Null Volt und der Logikwert "1" einem Wert von annähernd -5 Volt entspricht, d. h. beide Signale DA und CLK werden logisch invertiert übertragen und weisen somit eine "negative Logik" auf. Null Volt entspricht dabei, wie bereits erwähnt, dem auf dem Bezugsleiter 40 anstehenden Potential BEZ.

Die Sendeschaltungen 23 der Pegelanpass-Schaltung 20 dienen hauptsächlich dazu, die internen digitalen 5 Volt-Signalspannungen des Kontrollmoduls 10, die alle auf die Gesamtsystemmasse und damit auf das Potential GO des Leiters 41 bezogen sind, mit der richtigen Polarität in gleich starke digitale 5 Volt-Signalspannungen umzuwandeln, die nicht mehr auf das Potential GO, sondern auf das Potential BEZ des Leiters 40 bezogen sind. Zusätzlich dienen die Sendeschaltungen 23 noch dazu, das Kontrollmodul 10 mit einem Ausgang zu versehen, der ohne weiteres allen an der Busverbindung 12; 14 angeschlossenen Anschlüssen der Funktionsmodule 11 parallelgeschaltet werden kann. Liegt z. B. ein auf die Systemmasse bezogener Logikwert "1" am Eingang der Sendeschaltung 23 und damit am Eingang der Steuereinheit 47, dann schaltet der Transistor 49 in der Steuereinheit 47 (siehe Fig. 6) durch, so dass über den Widerstand R8 die volle Spannung V1 an der Basis-Emitter-Strecke des Transistors 48 (siehe Fig. 5) ansteht und dieser ebenfalls durchschaltet, wodurch das Potential BEZ, welches einem Logikwert "O" entspricht, am Ausgang der Sendeschaltung 23 und damit auf dem Leiter 30 bzw. 32 der Busverbindung 12; 14 erscheint. Die Sendeschaltung 23 arbeitet somit auch als Inverter.

Die Empfangsschaltung 24 der Pegelanpass-Schaltung 20 wandelt dagegen die auf das Potential BEZ bezogenen digitalen 5 Volt-Signalspannungen, die auf dem Leiter 32 der Busverbindung 12; 14 anstehen, mit der richtigen Polarität um in gleich starke 5 Volt-Signalspannungen des Kontrollmoduls 10, die ihrerseits auf das Potential GO bezogen sind. Liegt z. B. ein Logikwert "1", d. h. -5 Volt gegenüber dem Potential BEZ, am Eingang der Empfangsschaltung 24 und damit an der Basis des Transistors 45 (siehe Fig. 5), dann ist der Transistor 45 leitend und die volle Versorgungsgleichspannung V1 liegt an der Reihenschaltung der Widerstände R3 und R4, die als Spannungsteiler arbeiten und die die Versorgungsgleichspannung V1 auf 5 Volt reduzieren, wobei diese 5 Volt-Spannung und die Versorgungsgleichspannung V1 auf das Potential GO bezogen sind.

Die Empfangseinheiten 28 der Anpass-Schaltung 26 arbeiten als Tiefpassfilter zur Eliminierung hochfrequenter Störer, die auf der Busverbindung 12; 14 vorhanden sein können, während die Sendeeinheit 27 der Anpass-Schaltung 26 nur dazu dient, einen "Open collector"-Ausgang für das Funktionsmodul 11 zu realisieren, damit die Sendeeinheiten 27 aller Funktionsmodule 11 ausgangsseitig parallelgeschaltet werden können, ohne sich gegenseitig zu behindern.

Das Kontrollmodul 10 enthält einen von einem Mikrocomputer 50 gesteuerter digitaler Funktionsblock, der beim Vorhandensein mehrerer Funktionsmodule 11 den übertragungsmässigen Anschluss derselben an die Busverbindung 12; 14 verwaltet. Der digitale Funktionsblock enthält seinerseits eine Interfaceschaltung 21 und mindestens eine der Interfaceschaltung 21 nachgeschaltete Pegelanpass-Schaltung 20.

Die in der Fig. 7 dargestellte Eingangsschaltung 43 des Kontrollmoduls 10 besteht aus dem Mikrocomputer 50, einem Nor-Gatter 51, einem Adressenspeicher 52, einem bidirektionellen Datentreiber 53 und einem Richtungs-Kontrollgerät 54. Der Mikrocomputer 50 ist z. B. ein Mikrocomputer vom Typ MC68HC11 der Firma Motorola und ist in deren Datenbuch ausführlich beschrieben. Er besitzt dann ein "Port A" und ein "Port E", deren Anschlüsse auf die Busverbindung 17 geführt sind, ein "Port C", dessen Anschlüsse über eine Busverbindung 55 mit einem ersten Busanschluss des Datentreibers 53 und mit einem Buseingang des Adressenspeichers 52 verbunden sind, sowie ein "Port B", dessen Ausgänge auf je einem Eingang des Nor-Gatters 51 geführt sind, welches z. B. acht Eingänge besitzt. An den acht Eingängen des Nor-Gatters 51 stehen die acht hochwertigsten Bit einer 16Bit-Adresse des Mikrocomputers 50 an, welche für das Kontrollmodul 10 bedeutungslos sind und daher alle einen Logikwert "0" aufweisen, wenn das Kontrollmodul 10 in Betrieb ist. Nur wenn alle diese hochwertigsten Bit einen Logikwert "0" aufweisen, erscheint am Ausgang des Nor-Gatters 51 ein Logikwert "1", der ein im Richtungs-Kontrollgerät 54 enthaltenes Und-Gatter 54a freigibt.

Der Adressenspeicher 52 weist soviele Flip Flop 52a auf, wie die Busverbindung 55 dem Adressenspeicher 52 Busleiter zur Verfügung stellt. Nachfolgend wird angenommen, dass z. B. drei Busleiter der Busverbindung 55, welche total 8 Busleiter aufweist, am Buseingang des Adressenspeichers 52 angeschlossen sind und dieser somit aus drei Flip Flop 52a besteht. Die D-Eingänge dieser Flip Flop 52a bilden den Buseingang und ihre Q-Ausgänge den Busausgang des Adressenspeichers 52. Der Busausgang des Adressenspeichers 52 ist im Kontrollmodul 10 über einen Adressenbus 56 mit der nachgeschalteten Interfaceschaltung 21 verbunden. Die Takteingänge der Flip Flop 52a sind alle miteinander verbunden und bilden einen Takteingang des Adressenspeichers 52.

Der Datentreiber 53 weist soviele "Tri-State"-Treiber 53a auf, wie die Busverbindung 55 Busleiter besitzt, also vorzugsweise 8 Stück. In der Fig. 7 wurden aus Gründen der zeichnerischen Einfachheit nur vier "Tri-State"-Treiber 53a dargestellt. Jeder "Tri-State"-Treiber 53a besteht aus je einem Treiber 53b bzw. 53c pro Übertragungsrichtung, wobei der Ausgang des einen jeweils mit dem Eingang des andern verbunden ist. Die Steuereingänge der Treiber 53b sind alle miteinander verbunden und bilden einen ersten Steuereingang des Datentreibers 53, der die Übertragung in Richtung vom Mikrocomputer 50 zur Interfaceschaltung 21 freigibt. Die Steuereingänge der Treiber 53c sind ebenfalls alle miteinander verbunden und bilden einen zweiten Steuereingang des Datentreibers 53, der die Übertragung in Richtung von der Interfaceschaltung 21 zum Mikrocomputer 50 freigibt. Die Eingänge der Treiber 53b und damit auch die Ausgänge der Treiber 53c bilden den ersten, an der Busverbindung 55 angeschlossenen Busanschluss des Datentreibers 53. Die Eingänge der Treiber 53c und damit auch die Ausgänge der Treiber 53b bilden einen zweiten Busanschluss des Datentreibers 53, der im Kontrollmodul 10 über einen bidirektionellen Datenbus 57 mit der Interfaceschaltung 21 verbunden ist.

Das Richtungs-Kontrollgerät 54 dient der Festlegung der Übertragungsrichtung des Datentreibers 53 und besteht aus dem Und-Gatter 54a und einem RS-Flip Flop 54b, der selber aus zwei Nor-Gattern 54c und 54d gebildet ist. Innerhalb des RS-Flip Flops 54b ist jeder Ausgang eines Nor-Gatters 54c bzw. 54d mit einem ersten Eingang des andern Nor-Gatters 54d bzw. 54c verbunden, während deren zweiter Eingang jeweils einen R- bzw. S-Eingang des RS-Flip Flops 54b bildet. Die Ausgänge der beiden Nor-Gatter 54c und 54d bilden den Q- und den invertierten Q-Ausgang des RS-Flip Flops 54b und des Richtungs-Kontrollgerätes 54.

Der Mikrocomputer 50 weist einen Ausgang auf, an dem ein "Address Strobe"-Signal AS ansteht, der einpolig mit dem Takteingang des Adressenspeichers 52 und dem zweiten Eingang des Nor-Gatters 54c verbunden ist. Der Ausgang des Nor-Gatters 54c und damit ein erster Ausgang des Richtungs-Kontrollgerätes 54 ist seinerseits auf denjenigen Steuereingang des Datentreibers 53 geführt, der mit den Steuereingängen der Treiber 53c verbunden ist. Zwei Ausgänge des Mikrocomputers 50, an denen ein "Write/Read"-Signal R/W bzw. ein "Enable"-Signal E ansteht, sowie der Ausgang des Nor-Gatters 51 sind einpolig auf je einen Eingang des Und-Gatters 54a geführt, dessen Ausgang seinerseits mit dem zweiten Eingang des Nor-Gatters 54d verbunden ist. Der Ausgang des Nor-Gatters 54d und damit ein zweiter Ausgang des Richtungs-Kontrollgerätes 54 ist auf denjenigen Steuereingang des Datentreibers 53 geführt, der mit den Steuereingängen der Treiber 53b verbunden ist.

Das Kontrollmodul 10 ist interruptaktiv und arbeitet unter Kontrolle des Mikrocomputers 50 vollkommen selbständig, um mit den Funktionsmodulen 11 ein binäres Telegramm auszutauschen. Die Arbeitsweise des Mikrocomputers 50 und seiner Zubehörschaltungen ist ausführlich in den Unterlagen der Firma Motorola beschrieben. Auf der Busverbindung 55 sind im Zeitmultiplexverfahren entweder Adressen oder Daten vorhanden, die unter Anleitung des Mikrocomputers 50 auf folgender Weise demultiplexiert werden. Die Adressen werden mit jeder steigenden Flanke des Signals AS in die Flip Flop 52a des Adressenspeichers 52 geladen und dort abgespeichert. Gleichzeitig wird, wenn das Signal R/W oder E niedrig und das Und-Gatter 54a somit gesperrt ist, das RS-Flip Flop 54b durch das Signal AS auf Null zurückgestellt, d. h. am Ausgang des Nor-Gatters 54c erscheint ein Logikwert "0", wodurch die Treiber 53c gesperrt und die Treiber 53b freigegeben werden. Der Datentreiber 53 ist somit in Senderichtung geschaltet. Wenn der Mikrocomputer 50 einen Schreibzyklus veranlassen möchte, gibt er dem Signal R/W einen Logikwert "0", was den augenblicklichen Zustand des RS-Flip Flops 54b bestätigt, da das Und-Gatter 54a gesperrt bleibt. Der Datentreiber 53 ist somit - wie gewünscht - weiterhin in Senderichtung geschaltet. Wird dagegen vom Mikrocomputer 50 ein Lesezyklus veranlasst, dann gibt er dem Signal R/W einen Logikwert "1", wodurch das RS-Flip Flop 54b mit der nächsten steigenden Flanke des Signals E umgeschaltet wird, da dann das Ausgangssignal des Und-Gatters 54a einen Logikwert "1" annimmt. Durch das Umschalten des RS-Flip Flops 54b erscheint ein Logikwert "1" am Ausgang des Nor-Gatters 54c, wodurch die Treiber 53c freigegeben und die Treiber 53 b gesperrt werden, so dass der Datentreiber 53 - wie gewünscht - in Empfangsrichtung geschaltet ist. Das Signal R/W des Mikrocomputers 50 bestimmt somit mit Hilfe des Signals E und des Richtungs-Kontrollgerätes 54, ob die am "Port C" des Mikrocomputers 50 anstehenden Daten vom "Port C" über die Busverbindung 55, die Treiber 53b des Datentreibers 53 und den Datenbus 57 zur Interfaceschaltung 21 oder, ob umgekehrt die von der Interfaceschaltung 21 gelieferten Daten über den Datenbus 57, die Treiber 53c des Datentreibers 53 und die Busverbindung 55 zum "Port C" des Mikrocomputers 50 übertragen werden.

Die in der Fig. 8 dargestellte Interfaceschaltung 21 des Kontrollmoduls 10 besteht aus einem Adressenregister 58, einem Funktionsregister 59, wenn ein Funktionsbyte zu übertragen ist, mindestens einem Datenregister 60 bzw. 61, einem Statusregister 62, einem Kontrollgerät 62a als Steuergerät, einem Schieberegister 63, einem Mithör-Fehlerdetektor 64, einem Inverter 64a, einem Multiplexer 65a, einem CRC-Generator 65b, einem Oder-Gatter 65c, einer Sendeeinheit 66 und einem Und-Gatter 67, das als Empfangseinheit dient. Der Multiplexer 65a, der CRC-Generator 65b und das Oder-Gatter 65c sind nur vorhanden, wenn ein CRC-Byte übertragen und ausgewertet werden soll. Vorzugsweise sind wie nachfolgend angenommen zwei Datenregister 60 und 61 vorhanden, da vorzugsweise auch zwei Datenbyte im Datentelegramm übertragen werden. Der Bus 56 ist auf je einen Buseingang der fünf Register 58 bis 62 geführt. Desgleichen ist der Bus 57 an je einem ersten Busanschluss der fünf Register 58 bis 62 angeschlossen. Je eine Busverbindung 68, die vorzugsweise 8 Busleiter aufweist, verbindet einen zweiten Busanschluss der vier Register 58 bis 61 mit einem Paralleleingang/-ausgang, der 32 Bit aufweist, des Schieberegisters 63, dessen serieller Ausgang einpolig auf einen Eingang der Sendeeinheit 66 geführt ist. Das Schieberegister 63 ist ein 32Bit-Schieberegister und alle vier Busverbindungen 68 bilden zusammen einen 32Bit-Bus. Der Ausgang des Und-Gatters 67 ist mit einem ersten Eingang des Multiplexers 65a und mit einem seriellen Eingang des Schieberegisters 63 verbunden. Der Ausgang des Multiplexers 65a ist auf einen Signaleingang des CRC-Generators 65b und dessen Parallelausgänge sind auf die Eingänge des Oder-Gatters 65c geführt. Je ein Ausgang des Mithör-Fehlerdetektors 64 und des Oder-Gatters 65c ist mit je einem Eingang des Statusregisters 62 verbunden. Die Sendeeinheit 66 besitzt ein Nand-Gatter 66a, einen Inverter 66b, ein Flip Flop 66c und ein Nand-Gatter 66d. Der D-Eingang des Flip Flops 66c bildet den Eingang der Sendeeinheit 66, deren Takteingang, der ausserdem mit dem Eingang des Inverters 66b verbunden ist, gebildet wird durch den Takteingang des Flip Flops 66c. Der Ausgang des Inverters 66b ist auf einen ersten Eingang des Nand-Gatters 66a geführt, dessen zweiter Eingang einen ersten Steuereingang und dessen Ausgang einen ersten Ausgang jeweils der Sendeeinheit 66 bildet. Der invertierte Q-Ausgang des Flip Flops 66c ist mit einem ersten Eingang des Nand-Gatters 66d verbunden, dessen zweiter Eingang einen zweiten Steuereingang und dessen Ausgang einen zweiten Ausgang jeweils der Sendeeinheit 66 bildet. Die zwei Ausgänge der Sendeeinheit 66 sind je auf den Leiter 29 bzw. 31 des Busses 22 geführt, während dessen Leiter 33 mit je einem ersten Eingang des Und-Gatters 67 und des Mithör-Fehlerdetektors 64 verbunden ist. Der Ausgang des Nand-Gatters 66d ist ausserdem auf je einen zweiten Eingang des Mithör-Fehlerdetektors 64 und des Multiplexers 65a geführt. Ein erster Steuerausgang des Kontrollgerätes 62a, an dem ein Signal EC ("Enable Clock") ansteht, ist mit dem ersten Steuereingang und ein zweiter Steuerausgang des Kontrollgerätes 62a, an dem ein Signal ES ("Enable Send") ansteht, mit dem zweiten Steuereingang jeweils der Sendeeinheit 66 verbunden. Der zweite Steuerausgang des Kontrollgerätes 62a ist ausserdem noch auf je einen Steuereingang des Mithör-Fehlerdetektors 64 und des Multiplexers 65a geführt. Ein dritter Steuerausgang des Kontrollgerätes 62a, an dem ein Signal ER ("Enable Reception") ansteht, ist mit einem zweiten Eingang des Und-Gatters 67 und einem Steuereingang des CRC-Generators 65b verbunden. Ein Rückstellausgang des Kontrollgerätes 62a, an dem ein Rückstellsignal CLR ("Clear") ansteht, ist auf je einen Rückstelleingang der Sendeeinheit 66, des Mithör-Fehlerdetektors 64 und des CRC-Generators 65b geführt, wobei der Rückstelleingang der Sendeeinheit 66 gebildet ist durch den Rückstelleingang des Flip Flops 66c. Ein Taktausgang des Kontrollgerätes 62a, an dem ein Taktsignal CLK ("CLOCK") ansteht, ist mit je einem Takteingang der Sendeeinheit 66, des CRC-Generators 65b, und - über den Inverter 64a - des Mithör-Fehlerdetektors 64 verbunden. Ein vierter Steuerausgang des Kontrollgerätes 62a, an dem ein Signal BUS ("Busy") ansteht, ist auf einen weiteren Eingang des Statusregisters 62 geführt, während ein fünfter Steuerausgang des Kontrollgerätes 62a, an dem ein Signal ITR ("Interrupt") ansteht, über einen Leiter 62b und einen weiteren Ausgang der Interfaceschaltung 21 mit einem "Interrupt"-Eingang "IRQ invertiert" des Mikrocomputers 50 verbunden ist (siehe Fig. 7).

Eine im Adressenspeicher 52 (siehe Fig. 7) gespeicherte 3Bit-Adresse erreicht über den Adressenbus 56 die Register 58 bis 62 (siehe Fig. 8) und wählt eines der vier ersten Register 58 bis 61 aus zum Abspeichern der nachfolgenden 8Bit-Daten, die vom "Port C" über die Busverbindung 55, die Treiber 53b und den Datenbus 57 (siehe Fig. 7) ebenfalls die Register 58 bis 62 erreichen, wo sie in dem durch die Adresse ausgewählten Register 58, 59, 60 oder 61 abgespeichert werden. Diese 8Bit-Daten können Funktionsmodul-Adressen sein und werden dann als ein Adressenbyte im Adressenregister 58 abgespeichert. Sie können aber auch für die Funktionsmodule 11 bestimmte Funktionsangaben sein, dann werden sie als ein Funktionsbyte im Funktionsregister 59 abgespeichert. Die eigentlichen Daten bestehen vorzugsweise aus zwei Datenbyte, nämlich einem höherwertigen ersten Datenbyte und einem niederwertigen zweiten Datenbyte. Während eines sogenannten Schreibzyklus werden diese beiden Datenbyte vom Kontrollmodul 10 zu den Funktionsmodulen 11 übertragen und zu diesem Zweck vorher im Datenregister 60 bzw. 61 abgespeichert. Die Reihenfolge, in der diese vier Byte in die verschiedenen Register 58 bis 61 geladen werden, ist mit Ausnahme des Adressebytes, welches immer als letztes geladen werden muss, beliebig. Unmittelbar nach dem Laden des Adressebytes in das Register 58 wird der Inhalt aller vier Register 58 bis 61 über die Busverbindungen 68 als 32Bit-Wort parallel in das Schieberegister 63 geladen. Durch das Laden des Adressenbytes in das Adressenregister 58 wird somit eine Telegrammübertragung gestartet unter der Bedingung, dass seit dem Ende des zuletzt übertragenen Telegramms mindestens 25$\mu$s verstrichen sind. Dies wird angezeigt durch einen Logikwert "1" des Signals BUS, welches im Kontrollgerät 62a erzeugt wird und an dessem vierten Steuerausgang ansteht. Ist dies nicht der Fall, dann wartet die Interfaceschaltung 21 mit dem Start des Telegramms solange, bis dass das Signal BUS einen Logikwert "1" annimmt. Sind alle Startbedingungen erfüllt, dann werden direkt anschliessend die im Schieberegister 63 gespeicherten Byte zeitseriell über den seriellen Ausgang aus dem Schieberegister 63 hinausgeschoben und über die Sendeeinheit 66 und den Bus 22 zur Pegelanpass-Schaltung 20 hin übertragen. Das Schieberegister 63 arbeitet hier somit als Parallel/Serie-Wandler. Bei einem sogenannten Schreibzyklus werden jeweils das Adressenbyte, das Funktionsbyte, das höherwertige Datenbyte und das niederwertige Datenbyte in der angegebenen Reihenfolge aus dem Schieberegister 63 hinausgeschoben und als vier erste Byte eines binären Datentelegramms, welches total 5 Byte aufweist, zu den Funktionsmodulen 11 übertragen. Das fünfte Byte dieses Telegramms wird dagegen als sogenanntes CRC-Byte nach Empfang des vierten Bytes durch das adressierte Funktionsmodul 11 in umgekehrter Richtung von diesem zum Kontrollmodul 10 gesendet. Bei einem sogenannten Lesezyklus werden nur das Adressenbyte und das Funktionsbyte in der angegeben Reihenfolge aus dem Schieberegister 63 hinausgeschoben und als zwei erste Byte eines Telegramms, welches wieder 5 Byte aufweist, zu den Funktionsmodulen 11 übertragen. Das höherwertige Datenbyte, das niederwertige Datenbyte und das CRC-Byte werden dann in der angegeben Reihenfolge nach Empfang des zweiten Bytes als die drei letzten Byte des Telegramms in umgekehrter Richtung vom adressierten Funktionsmodul 11 zum Kontrollmodul 10 gesendet.

Die vom Kontrollmodul 10 empfangenen Byte des Telegramms, nämlich das CRC-Byte während eines Schreibzyklus und die beiden Datenbyte sowie das CRC-Byte während eines Lesezyklus, erreichen zeitlich nacheinander über die Pegelanpass-Schaltung 20, den Bus 22 und den Leiter 33 einen Eingang des Mithör-Fehlerdetektors 64 sowie über das Und-Gatter 67 einen Eingang des Multiplexers 65a und den seriellen Eingang des Schieberegisters 63. Die während eines Lesezyklus empfangenen beiden Datenbyte werden zeitseriell in das Schieberegister 63 hineingeschoben, aus dem sie anschliessend parallel über die Busverbindungen 68 in die zugehörigen Register 60 und 61 geladen werden. Das Schieberegister 63 arbeitet hier somit als Serie/Parallel-Wandler. Da die Funktionsmodule 11 keine Adressen- und Funktionsbyte senden, werden in den Registern 58 und 59 keine empfangenen Byte abgespeichert. In der Fig. 8 wurde aus Gründen der zeichnerischen Einfachheit angenommen, dass die Parallelausgänge und die Paralleleingänge des Schiebregisters 63 identisch sind.

Im Statusregister 62 ist der Status des Kontrollmoduls 10 gespeichert. Während der Telegrammübertragung werden fortlaufend Mithör- und CRC-Fehlerkontrollen durchgeführt. Ein bei diesen beiden Fehlerkontrollen entdeckter Fehler in der Telegrammübertragung ergibt spätestens beim Telegrammende einen Logikwert "1" am Ausgang des Mithör-Fehlerdetektors 64 bzw. des Oder-Gatters 65c. Der Status dieser beiden Ausgänge wird in zwei der z. B. vier Bit des Statusregisters 62 lesbar abgespeichert, da der Ausgang des Mithör-Fehlerdetektors 64 und des Oder-Gatters 65c mit je einem Eingang des Statusregisters 62 verbunden ist. Das Kontrollmodul 10 ist in der Regel mit einer in der Zeichnung des Kontrollmoduls 10 nicht dargestellten "Watch dog"-Schaltung ("Wachthundschaltung") ausgerüstet. In einem dritten Bit der vier Bit des Statusregisters 62 wird durch einen Logikwert "1" elektrisch lesbar angezeigt, dass die "Watch dog"-Schaltung eingreifen musste. Die Ablaufsteuerung innerhalb der Interfaceschaltung 21 wird durch das Kontrollgerät 62a bewerkstelligt. Der Status des Kontrollgerätes 62a steht als Logikwert "1" des Signals BUS im vierten der vier Bit des Statusregisters 62 lesbar zur Verfügung. Das Kontrollgerät 62a meldet sich ausserdem am Ende eines jeden Telegramms mittels eines Interruptsignals ITR beim Mikrocomputer 50.

Das im Kontrollgerät 62a erzeugte Taktsignal CLK wird mit Hilfe des Inverters 66b invertiert und das invertierte Taktsignal mit Hilfe des Nand-Gatters 66a und des Signals EC, welches ebenfalls im Kontrollgerät 62a erzeugt wird, freigegeben zur Übertragung des Taktsignals CLK über den Leiter 29 des Busses 22.

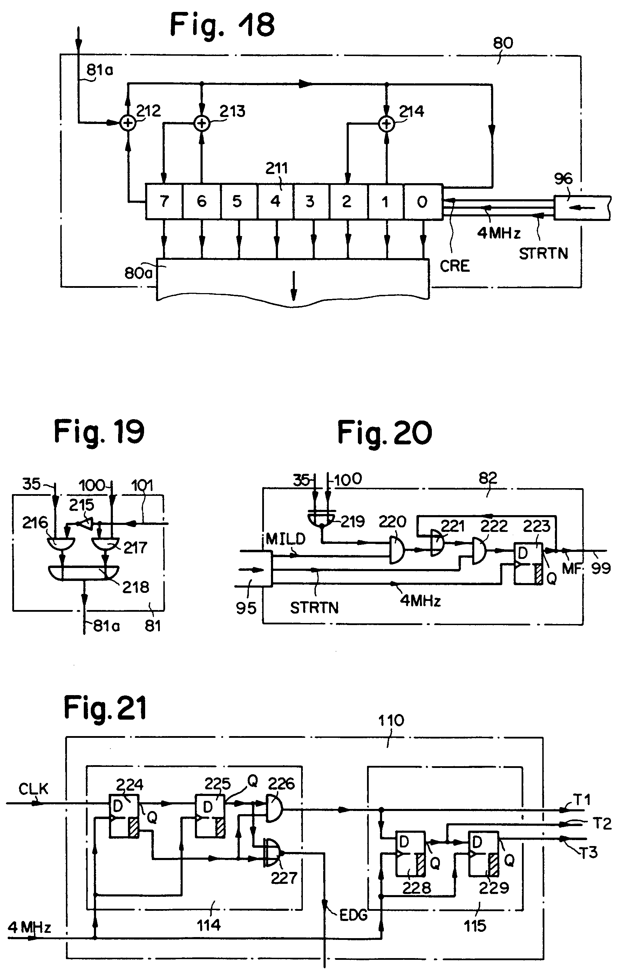

Das zeitserielle Ausgangssignal des Schieberegisters 63 wird mit Hilfe des Taktsignals CLK und des Flip Flops 66c synchronisiert und anschliessend invertiert auf das Nand-Gatter 66d gegeben, welches beim Vorliegen eines Schreibzyklus während der vier ersten und beim Vorliegen eines Lesezyklus während der zwei ersten Byte des Telegramms mit Hilfe des Signals ES, welches ebenfalls im Kontrollgerät 62a erzeugt wird, freigegeben wird. Der Mithör-Fehlerdetektor 64 wertet nur die vom Kontrollmodul 10 ausgesendeten Byte aus. Diese von der Sendeeinheit 66 ausgesendeten Byte erreichen über zwei verschiedenen Wege je einen Eingang des Mithör-Fehlerdetektors 64, nämlich einerseits innerhalb der Interfaceschaltung 21 direkt vom Ausgang der Sendeeinheit 66d her und anderseits (siehe Fig. 5) über den Leiter 31 des Busses 22, eine der beiden Sendeschaltungen 23 der Pegelanpass-Schaltung 20, die Empfangsschaltung 24 und den Leiter 33. Das Kontrollmodul 10 hört somit seine eigene Sendungen mit und vergleicht mit Hilfe des Mithör-Fehlerdetektors 64 die gesendeten Daten, die den letzten auf unterschiedelichem Weg erreichen, um bei Nichtübereinstimmung einen Alarm auszulösen mit dem Ziel das Telegramm unverzüglich zu unterbrechen und eine Sendewiederholung desselben zu veranlassen. Der Aufbau des Mithör-Fehlerdetektors 64 ist in der Fig. 20 dargestellt und seine Arbeitsweise wird später anlässlich der Beschreibung der Fig. 20 näher erläutert.

Das Und-Gatter 67 wird mit Hilfe des Signals ER, welches auch im Kontrollgerät 62a erzeugt wird, während des Empfangs des letzten Bytes beim Vorliegen eines Schreibzyklus und während des Empfangs der drei letzten Byte des Telegramms beim Vorliegen eines Lesezyklus freigegeben.

Das letzte sowohl in einem Schreib- als auch in einem Lesezyklus übertragene Byte ist immer ein CRC-Byte, welches in beiden Zyklen vom adressierten Funktionsmodul 11 ausgesendet wird, um vom Kontrollmodul 10 empfangen zu werden. Diesem CRC-Byte ist in der Interfaceschaltung 21 kein Register zugeordnet, sondern es wird nur im CRC-Generator 65b ausgewertet, den es über den Multiplexer 65a erreicht. Der Aufbau des Multiplexers 65a und des CRC-Generators 65b ist jeweils in der Fig. 19 bzw. Fig. 18 dargestellt. Die Bedeutung des CRC-Bytes sowie die Arbeitsweise des Multiplexers 65a und des CRC-Generators 65b werden später anlässlich der Beschreibung der Figuren 18 und 19 näher erläutert. Es sei hier nur darauf hingewiesen, da das Und-Gatter 67 durch das Signal ER nur dann freigegeben ist, wenn das Kontrollmodul 10 die von einem Funktionsmodul 11 ausgesandten Byte empfängt, dass letztere über das freigegebene Und-Gatter 67 einen Eingang des Multiplexers 65a erreichen, während anderseits die vom Kontrollmodul 10 selber gesandten Byte direkt vom Ausgang der Sendeeinheit 66 einem anderen Eingang des Multiplexers 65a zugeführt werden. Der Multiplexer 65a leitet die beiden Bytearten unverzüglich weiter an den CRC-Generator 65b.

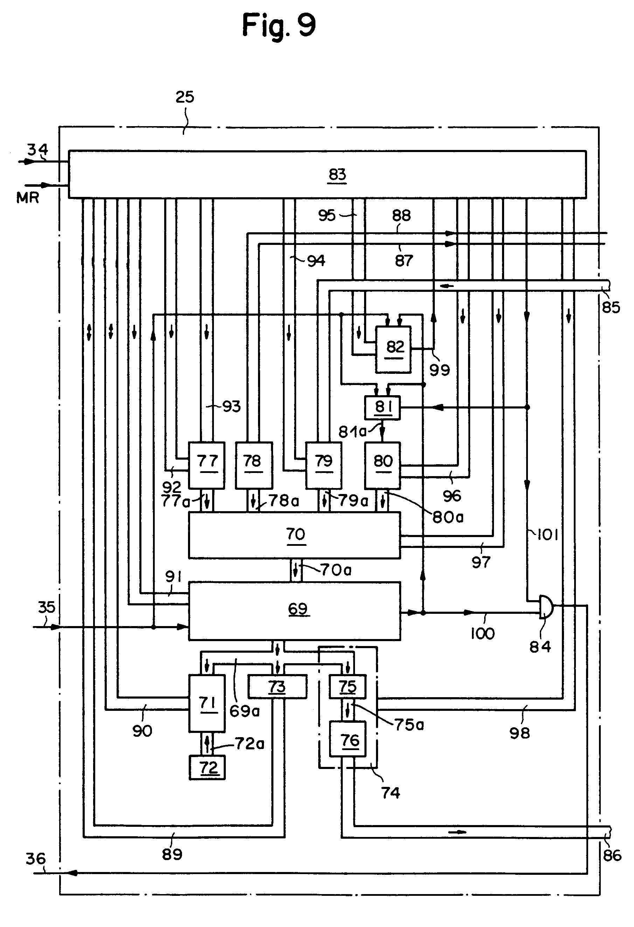

Die in der Fig. 9 dargestellte Interfaceschaltung 25 des Funktionsmoduls 11 besteht aus einem Schieberegister 69, einem Bus-Multiplexer 70, einem Adressenkomparator 71, einem Adressencodierer 72, einem Funktionsdecodierer 73, falls ein empfangenes Funktionsbyte auszuwerten ist, einer Ausgangsstufe 74, die ihrerseits aus einem Zwischenspeicher 75 und einem mittels eines Busses 75a nachgeschalteten Ausgangsregister 76 besteht, einem Zufallscodegenerator 77, einem Modulinformations-Codierer 78, einem fakultativ vorhandenen Eingangsfilter 79, einem CRC-Generator 80, falls ein CRC-Byte zu übertragen ist, einem Multiplexer 81, einem Mithör-Fehlerdetektor 82, einem Steuergerät 83 und einem Ausgangs-Freigabegatter 84. Die Interfaceschaltung 25 ist über einen Eingangsbus 85 und einen Ausgangsbus 86 mit der Ausgangsschaltung 44 seines Funktionsmoduls 11 verbunden. Innerhalb der Interfaceschaltung 25 ist in der anegebenen Reihenfolge der Eingangsbus 85 entweder direkt oder über das Eingangsfilter 79, einen Bus 79a, den Bus-Multiplexer 70 und einen Bus 70a auf einen Paralleleingang des Schieberegisters 69 geführt. Zwei Ausgänge des Modulinformations-Codierers 78 sind einpolig über je eine Steuerleitung 87 bzw. 88 mit je einem Steuereingang der Ausgangsschaltung 44 verbunden. Der Ausgang des Zufallscodegenerators 77 ist über einen Bus 77a, derjenige des Modulinformations-Codierers 78 über einen Bus 78a, derjenige des Eingangsfilters 79, falls vorhanden, über den Bus 79a und derjenige des CRC-Generators 80 über einen Bus 80a an je einem Buseingang des Bus-Multiplexers 70 angeschlossen, dessen Ausgang seinerseits über den Bus 70a auf einen Paralleleingang des Schieberegisters 69 geführt ist. Ein Bus 69a verbindet einen Parallelausgang des Schieberegisters 69 mit je einem Buseingang des Adressenkomparators 71, des Funktionsdecodierers 73 und der Ausgangsstufe 74. Innerhalb der Ausgangsstufe 74 ist der Bus 69a auf einen Daten-Buseingang des Zwischenspeichers 75 geführt, dessen Datenausgang über den Bus 75a mit einem Daten-Buseingang des Ausgangsregisters 76 verbunden ist, dessen Datenausgang seinerseits den Daten-Busausgang der Ausgangsstufe 74 bildet, der wiederum auf den Ausgangsbus 86 geführt ist. Der Adressencodierer 72 ist über einen Bus 72a mit einem zweiten Buseingang des Adressenkomparators 71 verbunden. Das Steuergerät 83 ist über einen ersten Steuerbus 89 auf einen Steuer-Busanschluss des Funktionsdecodierers 73, über einen zweiten Steuerbus 90 auf einen Steuer-Busanschluss des Adressenkomparators 71, über einen dritten Steuerbus 91 auf einen Steuer-Busanschluss des Schieberegisters 69, über einen vierten Steuerbus 92 auf einen ersten Steuer-Busanschluss des Zufallscodegenerators 77, über einen fünften Steuerbus 93 auf einen zweiten Steuer-Busanschluss des Zufallscodegenerators 77, über einen sechsten Steuerbus 94 auf einen Steuer-Busanschluss des Eingangsfilters 79, über einen siebten Steuerbus 95 auf einen Steuer-Busanschluss des Mithör-Fehlerdetektors 82, über einen achten Steuerbus 96 auf einen Steuer-Busanschluss des CRC-Generators 80, über einen neunten Steuerbus 97 auf einen Steuer-Busanschluss des Bus-Multiplexers 70 und über einen zehnten Steuerbus 98 auf einen Steuer-Busanschluss der Ausgangsstufe 74 geführt. Ein Ausgang des Mithör-Fehlerdetektors 82 ist über einen Eingangsleiter 99 mit einem ersten einpoligen Eingang des Steuergerätes 83 verbunden. Der von einem Ausgang der Anpass-Schaltung 26 herkommende Leiter 35 ist mit einem seriellen Eingang des Schieberegisters 69 und mit je einem ersten Eingang des Multiplexers 81 und des Mithör-Fehlerdetektors 82 verbunden, während ein serieller Ausgang des Schieberegisters 69 über eine Drahtverbindung 100 auf einen ersten Eingang des Ausgangs-Freigabegatters 84 sowie auf je einen zweiten Eingang des Multiplexers 81 und des Mithör-Fehlerdetektors 82 geführt ist. Ein Ausgang des Multiplexers 81 ist über eine Drahtverbindung 81a mit einem seriellen Eingang des CRC-Generators 80 verbunden, während ein einpoliger Ausgang des Steuergerätes 83 über eine Drahtverbindung 101 auf einen dritten Eingang des Multiplexers 81 und einen zweiten Eingang des Ausgangs-Freigabegatters 84 geführt ist, der ein Und-Gatter ist und dessen Ausgang am Leiter 36 angeschlossen ist, der zur Anpass-Schaltung 26 hinführt. Der von der Anpass-Schaltung 26 herkommende Leiter 34 ist auf einen weiteren einpoligen Eingang des Steuergerätes 83 geführt, welches noch zusätzlich einen einpoligen Eingang besitzt, an dem ein Rückstellsignal MR ("Master Reset") angeschlossen ist.

Der Bus-Multiplexer 70 enthält vier Gruppen Bustreiber, wovon je eine den Bussen 77a des Zufallscodegenerators 77, 78a des Modulinformations-Codierers 78, 79a des Eingangsfilters 79 und 80a des CRC-Generators 80 zugeordnet ist. Jede Gruppe enthält soviele Bustreiber wie der zugehörige Bus 77a, 78a, 79a und 80a Busleiter aufweist. Jeder Bustreiber ist ein "Tri-State"-Treiber und besitzt einen Steuereingang, mit dem er ein- und ausgeschaltet werden kann. Die Eingänge der Bustreiber einer Gruppe sind innerhalb des Bus-Multiplexers 70 jeweils mit den Busleitern des zugehörigen Busses 77a, 78a, 79a bzw. 80a verbunden, während ihre Ausgänge jeweils auf einen Busleiter des Ausgangsbusses 70a geführt sind, der für alle Gruppen gemeinsam ist.

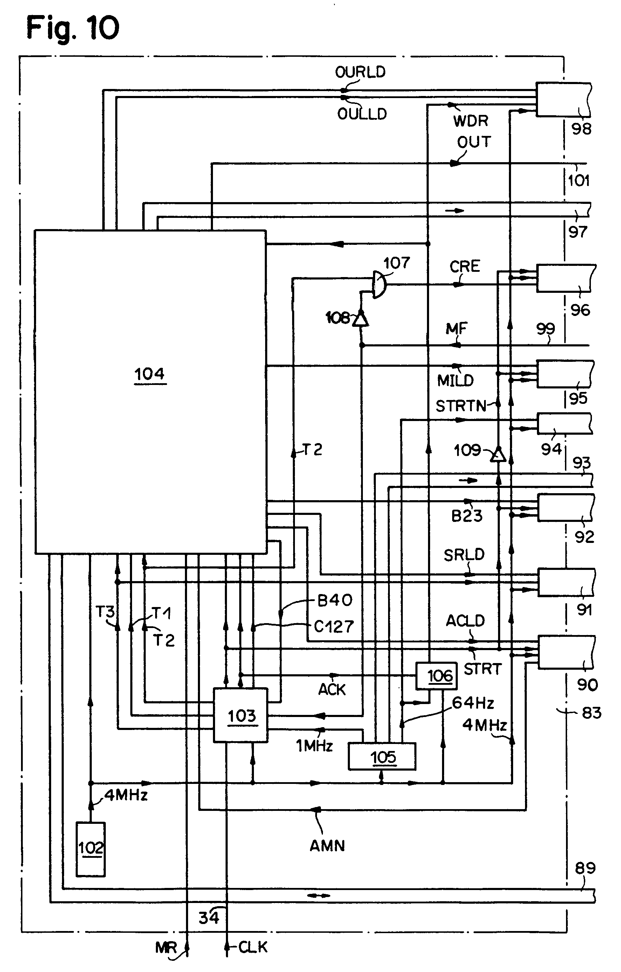

Die beiden Codierer 72 und 78 bestehen vorzugsweise aus Kurzschluss- oder Dioden-Steckern, mit denen innerhalb des betreffenden Codierers 72 bzw. 78 je nach gewünschtem Code elektrische Verbindungen hergestellt werden zwischen dessen einzelnen Ausgängen und den Logikwerten "1" bzw. "0". Der Aufbau der anderen Bauelemente der Interfaceschaltung 25 wird nachfolgend mit Hilfe der Figuren 10 bis 20 beschrieben.

Das Übertragungssystem arbeitet nach dem Halbduplex-Prinzip, d. h. die Übertragung erfolgt abwechselnd in beiden Übertragungsrichtungen. Dabei wird ein starres "Master/Slave"-Prinzip eingehalten unter Verwendung einer synchronen Byte-orientierten bitseriellen Übertragung, wobei die Informationen eines binären Telegramms byteweise zeitlich nacheinander übertragen werden. Das Kontrollmodul 10 überwacht als "Master" immer die Busverbindung, während jedes Funktionsmodul 11 als "Slave" seinerseits durch die Busverbindung überwacht wird. Die Anzahl der übertragenenen Byte ist pro Funktionsmodul-Zugriff konstant und vorzugsweise gleich 5 Byte zu je 8 Bit. Das vom Kontrollmodul 10 gelieferte und auf dem Synchronisationsleiter 30 anstehende Taktsignal CLK dient der Synchronisation sowie der Kontrolle des funktionsmodulseitigen Empfangs. Jedes Funktionsmodul 11 besitzt eine an ihm im Adressencodierer 72 hardwaremässig einstellbare Moduladresse, die z. B. 8 Bit aufweist, so dass 256 verschiedene Module anwählbar sind.

Als Datenpunkt wird jede durch eine Moduladresse und, falls vorhanden, durch eine Kanalnummer adressierte Information bezeichnet. Die auf dem Datenleiter 32 übertragene Information besteht, wie bereits erwähnt, aus 5 Byte eines binären Telegramms, die bei jedem Funktionsmodulzugriff in folgender Reihenfolge auf der Busverbindung 12; 14 erscheinen: Adressenbyte als erstes Byte, Funktionsbyte als zweites Byte, erstes Datenbyte als drittes Byte, zweites Datenbyte als viertes Byte und CRC-Byte als fünftes Byte.

Bei einem Schreibzyklus, d. h. bei einer Senderichtung der beiden Datenbyte vom Kontrollmodul 10 zum Funktionsmodul 11, werden die vier ersten Byte in der angegebenen Richtung bertragen, während dagegen das fünfte Byte, nämlich das CRC-Byte, in umgekehrter Richtung als Rückmeldung vom Funktionsmodul 11 zum Kontrollmodul 10 gesendet wird. Bei einem Lesezyklus, d. h. bei einer Senderichtung der beiden Datenbyte vom Funktionsmodul 11 zum Kontrollmodul 10, werden zwecks Aufrufung eines Funktionsmoduls 11 die beiden ersten Byte wieder in Richtung vom Kontrollmodul 10 zum Funktionsmodul 11 gesendet, jedoch die drei letzten Byte werden umgekehrt vom Funktionsmodul 11 zum Kontrollmodul 10 übertragen. Die beiden ersten Byte, nämlich das Adressen- und das Funktionsbyte, werden somit in allen Zyklen immer vom Kontrollmodul 10 zum Funktionsmodul 11 und das fünfte Byte, nämlich das CRC-Byte, immer vom Funktionsmodul 11 zum Kontrollmodul 10 gesendet. Die Übertragungsrichtung des dritten und vierten Byte, d. h. der beiden Datenbyte, hängt dagegen von der Zyklusart ab. Die beiden Datenbyte werden somit entweder während eines Schreibzyklus im Kontrollmodul 10 oder während eines Lesezyklus in einem Funktionsmodul 11 erzeugt. Innerhalb eines jeden Telegramms, d. h. innerhalb eines jeden Zyklus, bleibt dagegen die Übertragungsrichtung der beiden Datenbyte erhalten und ändert sich nicht. In jedem Byte wird das MSB ("Most significant bit") als Bit "7" zuerst und das LSB ("Least significant bit") als Bit "0" zuletzt gesendet.

Das vom Kontrollmodul 10 über den Synchronisationsleiter 30 gelieferte Taktsignal CLK steuert jeweils den Übertragungszyklus. Alle Funktionsmodule 11 hören ständig aktiv auf diesem Leiter 30 mit und reagieren unmittelbar auf die dort erscheinende Änderung des Taktsignals CLK. Jeder Übertragungszyklus beginnt mit einer Startbedingung auf dem Synchronisationsleiter 30, beinhaltet ein binäres Telegramm und endet mit einer Stoppbedingung. Ein vom Kontrollmodul 10 gesendeter Startimpuls muss eine minimale Zeit ti auf dem Synchronisationsleiter 30 anstehen, damit die Funktionsmodule 11 den Start als solchen erkennen. Darauf hin schalten sich alle Funktionsmodule 11 aktiv auf den Datenleiter 32. Die Funktionsmodule 11 können von sich allein nicht auf der Busverbindung 12; 14 aktiv werden. Ein Telegramm kann jedoch jederzeit durch einen Neustart abgebrochen werden.

Der Startimpuls besteht aus einem negativen Spannungshub, der vom Kontrollmodul 10 erzeugt und zur Verfügung gestellt wird. Wenn die Dauer t1 dieses negativen Spannungshubs grösser oder gleich der minimalen Zeit ti von z. B. 25 $\mu$s ist, wird der Datenempfang der Funktionsmodule 11 mit der nächsten steigenden Flanke des Taktsignals CLK gestartet.

Nach der Erkennung des Startimpulses sind die Funktionsmodule 11 bereit das zugesandte Telegramm und insbesondere dessen Adressenbyte zu empfangen und auszuwerten. Die Datenbit des Telegramms werden jeweils mit der fallenden Flanke des Taktsignals CLK vom jeweiligen Sender auf den Datenleiter 32 gelegt und mit der steigenden Flanke des Taktsignals CLK vom jeweiligen Empfänger abgetastet.

Bleibt der Synchronisationsleiter 30 während eines Telegramms zu lange auf einer tiefen Spannung, d. h. ist während eines Telegramms die Zeit t1 einer Impulslücke des Taktsignals CLK grösser oder gleich ti, dann erkennen die Funktionsmodule 11 dies als Fehler. Es erfogt dann ein Telegrammunterbruch mit einem anschliessendem Neustart des Telegramms bei der nächsten steigenden Flanke des Taktsignals CLK. Auf alle anderen Fehler reagieren die Funktionsmodule 11 erst am Ende eines Übertragungszyklus.

Das Eintreffen von 5 Byte zu je 8 Bit, d. h. das Eintreffen des vierzigsten Taktimpulses nach der Erkennung der Startbedingung bedeutet für die Funktionsmodule 11 das Ende des Telegramms. Danach erwarten sie noch ein Bestätigungssignal, welches durch das Kontrollmodul 10 nach dem Telegrammende zu senden ist. Stellt das Kontrollmodul 10 am Ende des Telegramms fest, dass das Telegramm korrekt übertragen wurde, sendet es ein Bestätigungssignal "In Ordnung", welches darin besteht, dass die Dauer t2 eines Impulses des Taktsignals CLK kleiner to und die Dauer t1 der zugehörigen Impulslücke grösser oder gleich ti ist, wobei to z. B. einen Wert von 128 $\mu$s besitzt. Stellt dagegen das Kontrollmodul 10 am Ende des Telegramms fest, dass das Telegramm nicht korrekt übertragen wurde, sendet es ein Bestätigungssignal "Nicht in Ordnung", welches darin besteht, dass die Dauer t2 eines Impulses des Taktsignals CLK grösser oder gleich to oder die Dauer t1 einer Impulslücke des Taktsignals CLK kleiner ti ist.

Bleibt der Synchronisationsleiter 30 während eines Telegramms zu lang auf einer hohen Spannung, d. h. ist die Dauer t2 eines Impulses des Taktsignals CLK während eines Telegramms grösser oder gleich to, dann wird von den Funktionsmodulen 11 ein Telegrammunterbruch veranlasst mit anschliessender Erwartung eines neuen Starts.

Jedes Funktionsmodul 11, welches seine eigene Adresse empfangen hat, muss innerhalb einer Zeit tw mit einem fehlerfreien Telegramm versehen sein, ansonsten ein "Watch Dog"-Alarm im betreffenden Funktionsmodul 11 wirksam wird. Die Zeit tw ist z. B. gleich 4 Sekunden.

Die Frequenz des Taktsignals CLK ist vorzugsweise 30 kHz bis 80 kHz. Nachfolgend gilt als Annahme, dass diese Frequenz einen Wert von 62,5 kHz besitzt. Dies ist gleichzeitig die Bitfrequenz des Übertragungstelegramms. Eine höhere Impulszahl des Telegramms wird vom jeweiligen Funktionsmodul 11 als Übertragungsfehler gewertet und das zugehörige Telegramm ignoriert.

Das Schieberegister 69 arbeitet als Serie/Parallel- oder als Parallel/Serie-Wandler. Nach Empfang des Startimpulses wird das Adressenbyte als erstes über den Leiter 35 empfangenes Byte seriell in das Schieberegister 69 der Interfaceschaltung 25 aller Funktionsmodule 11 hineingeschoben und, sobald es in diesem gespeichert ist, über den Bus 69a auf den Adressenkomparator 71 gegeben, in welchem die empfangene Adresse mit der vom Adressencodierer 72 über den Bus 72a gelieferten und im Adressencodierer 72 hardwaremässig eingestellten Moduladresse verglichen wird. Stimmen beide Adressen nicht überein, dann werden die betreffenden Funktionsmodule 11 für den Empfang der nachfolgenden Byte des Telegramms gesperrt und sie warten auf einen nächsten Startimpuls, während diese Byte zeitlich nacheinander über den Leiter 35 seriell in das Schieberegister 69 des nicht gesperrten Funktionsmoduls 11, nachfolgend kurz adressiertes Funktionsmodul 11 genannt, hineingeschoben werden. Die gleichzeitig am seriellen Ausgang des Schieberegisters 69 hinausgeschobenen Bit werden durch das gesperrte Ausgangs-Freigabegatter 84 daran gehindert den Leiter 36 zu erreichen.

Das Funktionsbyte, welches dann als zweites, durch das Kontrollmodul 10 ausgesandtes Byte vom adressierten Funktionsmodul 11 empfangen wird, wird in dessen Schieberegister 69 hineingeschoben und anschliessend zur Auswertung über den Bus 69a in den zugehörigen Funktionsdecodierer 73 geladen. Durch die im Funktionsdecodierer 73 erfolgte Decodierung des Funktionsbyte erfährt das adressierte Funktionsmodul 11 näheres über die Art der im dritten und/oder vierten Byte des laufenden Telegramms noch zu übertragenden Informationen.

Das LSB des Funktionsbytes gibt z. B. die Senderichtung des dritten und vierten Bytes an. Besitzt dieses LSB einen Logikwert "1", dann bedeutet dies z. B., dass das Kontrollmodul 10 einen Lesezyklus wünscht und im übertragenen dritten und/oder vierten Byte des Telegramms Informationen aus dem adressierten Funktionsmodul 11 erwartet. Besitzt dieses LSB dagegen einen Logikwert "0", dann bedeutet dies, dass das Kontrollmodul 10 einen Schreibzyklus wünscht und selber im dritten und/oder vierten Byte des Telegramms Informationen zum adressierten Funktionsmodul 11 übertragen will.

Theoretisch sind zusätzlich zur Übertragungsrichtung pro Adresse noch $2^7 = 127$ verschiene

Funktions-Informationen als Inhalt der 8 Bit des Funktionsbyte möglich. Damit das Funktionsmodul 11 bei einer Bitstörung auf dem Datenleiter 32 nicht in einer anderen Funktion übergeht, wird eine grosse Hammingdistanz zwischen zwei als Codewörter verwendeten Funktions-Bytewerte gewählt, so dass zusätzlich zur Übertragungsrichtung der Datenbyte das Funktions-Byte vorzugsweise nur mehr vier Funktionsangaben enthält, nämlich dass während eines Lesezyklus das adressierte Funktionsmodul 11 als drittes und/oder viertes Byte entweder ein sogenanntes "Addresspolling"-Telegramm, ein Modulinformations-Telegramm oder ein eigentliches Datentelegramm zu senden hat. In einem Schreibzyklus wird dagegen immer nur ein eigentliches Datentelegramm als drittes und viertes Byte übertragen. Bei Funktionsmodulen 11 mit analogem Ein-/Ausgang sind in der Regel mehrere Datenkanäle im Funktionsmodul 11 vorhanden. In diesem Fall wird bei Übertragung eines eigentlichen Datentelegramms sowohl beim Vorliegen eines Schreib- als auch eines Lesezyklus in einem Bit des Funktionsbytes angegeben, welcher der Datenkanäle des adressierten Funktionsmoduls 11 beschrieben bzw. gelesen werden soll.

Das sogenannte "Adresspolling" beinhaltet eine Kontrolle einer Mehrfachbelegung einer Moduladresse. Jedes Funktionsmodul 11, welches durch die übertragene Adresse angesprochen wird, setzt ein einziges und zufallsmässig beliebig ausgewähltes Bit im dritten oder vierten Byte auf einen Logikwert "1". Damit gibt es in den total 16 Bit des dritten und vierten Byte bei einem "Addresspolling"-Zyklus jeweils nur einen einzigen Logikwert "1", der an beliebiger Stelle in einem der beiden Byte vorkommt und durch den Zufallscodegenerator 77 erzeugt wird. Kurz vor dem Senden des dritten und vierten Byte durch ein adresiertes Funktionsmodul 11, wird deren Inhalt vom Zufallscodegenerator 77 ausgehend über den Bus 77a, den Bus-Multiplexer 70 und den Bus 70a parallel in das Schieberegister 69 geladen, um anschliessend seriell über dessen seriellen Ausgang und das während eines Lesezyklus freigegebene Ausgangs-Freigabegatter 84 als drittes und viertes Byte dem Leiter 36 und damit auch dem Leiter 32 zugeführt zu werden. Sind mehrere Funktionsmodule 11 irrtümlich unter einer gleichen Moduladresse erreichbar, dann erkennt dies das Kontrollmodul 10 dadurch, dass mehrere Logikwerte "1" im dritten und/oder vierten Byte des empfangenen Telegramms enthalten sind statt nur eines einzigen Logikwertes "1".

Ein Modulinformations-Telegramm dagegen beinhaltet Informationen über das adressierte Funktionsmodul 11, die hardwaremässig im Modulinformationscodierer 78 eingestellt und kurz vor dem Senden des dritten und vierten Bytes über den Bus 78a, den Bus-Multiplexer 70 und den Bus 70a parallel in das Schieberegister 69 geladen werden, um anschliessend ähnlich wie das "Addresspolling"-Telegramm seriell den Leitern 36 und 32 zugeführt zu werden. Im dritten Byte wird dabei z. B. eine Information über den Aufbau und/oder die Eingangs- und Ausgangs-Konfiguration der Pinbelegung des adressierten Funktionsmodul 11 angegeben, während im vierten Byte z. B. eine Information über den Typ einer integrierten LSI-Schaltung ("Large scale integrated circuit") angegeben wird, mit der das adressierte Funktionsmodul 11 bestückt ist.

Die Bit eines eigentlichen Datentelegramms, welches als drittes und viertes Byte während eines Lesezyklus vom adressierten Funktionsmodul 11 zum Kontrollmodul 10 zu übertragen ist, erreichen die Interfaceschaltung 25 des adressierten Funktionsmodul 11 von der Ausgangsschaltung 44 kommend über den Eingangsbus 85 und das Eingangsfilter 79, wo sie byteweise zwischengespeichert werden, um anschliessend kurz vor dem Senden über den Bus 79a, den Bus-Multiplexer 70 und den Bus 70a parallel in das Schieberegister 69 geladen zu werden, aus dem sie dann ähnlich wie das "Addresspolling"- und das Modulinformations-Telegramm seriell den Leitern 36 und 32 zugeführt werden.

Informiert das Kontrollmodul 10 dagegen durch das Funktionsbyte das adressierte Funktionsmodul 11 davon, dass ein Schreibzyklus vorliegt, erwartet dieses Funktionsmodul 11 das dritte und vierte Byte des Telegramms, welche durch das Kontrollmodul 10 gesendet werden, und schiebt diese beim Empfang über den Leiter 35 seriell in das Schieberegister 69 hinein, woraus sie dann byteweise parallel zuerst in den Zwischenspeicher 75 und dann in das Ausgangsregister 76 geladen werden, um anschliessend über den Ausgangsbus 86 der Ausgangsschaltung 44 zugeleitet zu werden.

Das in der Fig. 10 dargestellte Steuergerät 83 besteht aus einem Taktgenerator 102, einer ersten Steuereinheit 103, einer zweiten Steuereinheit 104, einem Frequenzteiler 105, einem "Watch Dog"-Zähler 106, einem Und-Gatter 107 und zwei Invertern 108 und 109. Der Taktgenerator 102 erzeugt ein vorzugsweise rechteckförmiges Taktsignal, welches z. B. eine Frequenz von 4 MHz besitzt und nachfolgend 4MHz-Taktsignal genannt wird. Dieses 4MHz-Taktsignal wird über eine Drahtverbindung je einem Takteingang der Bauelemente 103, 104, 105 und 106 sowie je einem ersten Leiter der Steuerbusse 90, 91, 92, 94, 95, 96 und 98 zugeleitet. Das aus dem Kontrollmodul 10 kommende Taktsignal CLK erreicht über den Leiter 34 einen zweiten Takteingang der ersten Steuereinheit 103, welche sechs Ausgänge besitzt, an denen je ein Signal T1, T2, T3, STRT ("START"), ACK ("ACKNOWLEDGE") und C127 ansteht. Alle diese sechs Ausgänge der Steuereinheit 103 sind je auf einen Steuereingang der zweiten Steuereinheit 104 geführt. Der Frequenzteiler 105 besitzt den Steuerbus 93 als Ausgangsbus sowie noch zwei einpolige Ausgänge, an denen ein 1MHz-Taktsignal bzw. ein 64Hz-Taktsignal ansteht. Das 1MHz-Taktsignal wird über einen Leiter einem dritten Takteingang der Steuereinheit 103 zugeführt, während das 64Hz-Taktsignal einen ersten Eingang des "Watch Dog"-Zählers 106 sowie einen zweiten Leiter des Steuerbusses 94 speist. Das Signal ACK erreicht von der Steuereinheit 103 kommend einen zweiten Eingang des "Watch Dog"-Zählers 106, dessen Ausgang, an dem ein Signal WDR ansteht, mit einem weiteren Eingang der Steuereinheit 104 und einem zweiten Leiter des Steuerbusses 98 verbunden ist. Der Steuerbus 89 ist auf einen Busanschluss der Steuereinheit 104 geführt, die acht einpolige Ausgänge besitzt, an denen je ein Signal B40, ACLD, SRLD, B23, MILD, OUT, OULLD und OURLD ansteht. Der Ausgang mit dem Signal B40 ist mit einem weiteren Eingang der Steuereinheit 103 verbunden, während die Ausgänge mit den Signalen ACLD, SRLD, B23 und MILD jeweils mit einem zweiten Leiter des Steuerbusses 90 bzw. 91 bzw. 92 bzw. 95 verbunden sind. Der Ausgang mit dem Signal OUT ist auf die Drahtverbindung 101 geführt, während die Ausgänge mit den Signalen OULLD und OURLD mit dem dritten bzw. vierten Leiter des Steuerbusses 98 verbunden sind. Ausserdem weist die Steuereinheit 104 noch einen Bus-Ausgang auf, der auf den Steuerbus 97 geführt ist. Der Leiter, auf dem das MR-Signal ansteht, ist mit einem weiteren Eingang der Steuereinheit 104 verbunden. Der Steuerbus 90 besitzt vier Leiter. Am dritten dieser Leiter steht ein Signal AMN an, welches einem letzten Eingang der Steuereinheit 104 zugeleitet wird, während das STRT-Signal von der Steuereinheit 103 kommend den vierten Leiter des Steuerbusses 90 speist. Der Steuerbus 91 weist drei Leiter auf, wovon der dritte von der Steuereinheit 103 kommend mit dem Signal T3 gespeist wird. Der Steuerbus 92 besitzt drei Leiter, wovon der dritte vom STRT-Signal gespeist ist, welches ebenfalls auf den Eingang des Inverters 109 geführt ist, dessen Ausgang einen dritten Leiter des Steuerbusses 95 bzw. einen zweiten Leiter des Steuerbusses 96 mit einem Signal STRTN speist. Auf dem Eingangsleiter 99 des Steuergerätes 83 steht ein Signal MF an, welches einem letzten Eingang der Steuereinheit 103 sowie einem Eingang des Inverters 108 zugeleitet wird. Der Ausgang des Inverters 108 ist mit einem ersten Eingang des Und-Gatters 107 verbunden, dessen Ausgang, an dem ein Signal CRE ansteht, auf einen dritten Leiter des Steuerbusses 96 geführt ist. Das Signal T2 speist von der Steuereinheit 103 kommend einen zweiten Eingang des Und-Gatters 107.

Im Taktgenerator 102, der vorzugsweise ein quarzstabilisierter Oszillator ist, wird ein periodisch rechteckförmiges 4MHz-Taktsignal erzeugt. Im Frequenzteiler 105, der vorzugsweise aus einem 16Bit-Zähler besteht, wird das 4MHZ-Taktsignal binär geteilt, so dass an den Ausgängen des Frequenzteilers 105 je ein ebenfalls periodisch rechteckförmiges 1MHz-Taktsignal und 64Hz-Taktsignal erscheint. Die invertierten Q-Ausgänge der vier niedrigsten Bit des Frequenzteilers 105 bilden den Steuerbus 93, über den ein quasi 4Bit-Zufallszahlenwert zum Zufallscodegenerator 77 (siehe Fig. 9) übertragen wird.

Der "Watch Dog"-Zähler ("Wachthundzähler") 106 besteht z. B. aus einem synchronen 9Bit-Zähler, der auf Null rückstellbar ist und der die periodisch rechteckförmigen Impulse des 64Hz-Taktsignals binär zählt. Wenn $2^9$ Impulse des 64Hz-Taktsignals den Eingang des "Watch Dog"-Zählers 106 erreichen, was einer Zeit von 4 Sekunden entspricht, ohne dass der "Watch Dog"-Zähler 106 vorher durch das Signal ACK auf Null zurückgestellt wurde, dann erscheint am Q-Ausgang des achten Bit des "Watch Dog"-Zählers 106 für die Dauer von 250 ns ein Logikwert "1" als Signal WDR, der gleichzeitig über eine Rückkopplung auf den Rückstelleingang des "Watch Dog"-Zählers 106 diesen wieder auf Null zurückstellt. Der Logikwert "1" des Signals WDR zeigt an, dass kein durch ein ACK-Signal bestätigtes gültiges Telegramm das zugehörige Funktionsmodul 11 erreicht hat. Der "Watch Dog"-Zähler 106 wird durch jedes Signal ACK auf Null zurückgestellt und beginnt anschliessend erneut zu zählen.

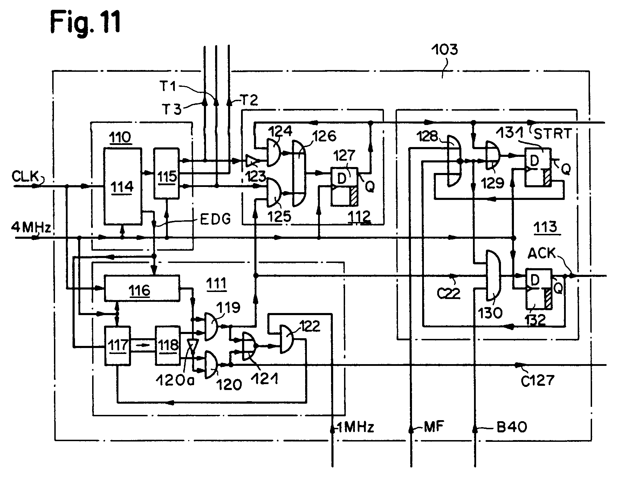

Die in der Fig. 11 dargestellte Steuereinheit 103 besteht aus einem Taktsynchronisierer 110, einem Zeitenzähler 111, einem Startdetektor 112 und einem Bestätigungsgenerator 113. Der Taktsynchronisierer 110 besteht seinerseits aus einem Synchronisierer 114 und einem Verzögerungsglied 115. Der Zeitenzähler 111 enthält einen Taktsignal-Statusspeicher 116, einen Zähler 117, einen Decodierer 118, zwei Und-Gatter 119 und 120, einen Inverter 120a, ein Nor-Gatter 121 und ein Und-Gatter 122. Der Startdetektor 112 besteht aus einem Inverter 123, zwei Und-Gattern 124 und 125, einem Oder-Gatter 126 und einem Flip Flop 127. Der Bestätigungsgenerator 113 enthält ein Nor-Gatter 128, ein Oder-Gatter 129, ein Und-Gatter 130 und zwei Flip Flop 131 und 132.

Der Eingang der Steuereinheit 103, an dem das 4MHz-Taktsignal ansteht, ist auf den Takteingang des Synchronisierers 114, des Verzögerungsgliedes 115, des Taktsignal-Statusspeichers 116, des Zählers 117 sowie der Flip Flop 127, 131 und 132 geführt. Der Eingang der Steuereinheit 103, an dem das Taktsignal CLK ansteht, ist mit je einem zweiten Takteingang des Synchronisierers 114 und des Taktsignal-Statusspeichers 116 verbunden. Ein erster Ausgang des Synchronisierers 114, an dem ein Signal EDG ("Edge") ansteht, ist auf je einen weiteren Eingang des Taktsignal-Statusspeichers 116 und des Zählers 117 geführt, während sein zweiter Ausgang mit einem Eingang des Verzögerungsgliedes 115 verbunden ist, welches drei Ausgänge aufweist, die drei Ausgänge der Steuereinheit 103 bilden, an denen je ein Signal T1, T2 bzw. T3 ansteht. Ein Ausgang des Taktsignal-Statusspeichers 116 ist auf einen ersten Eingang des Und-Gatters 119 sowie über den Inverter 120a auf einen ersten Eingang des Und-Gatters 120 geführt. Der Parallelausgang des Zählers 117 ist über einen Bus mit einem Buseingang des Decodierers 118 verbunden, dessen erster Ausgang auf einen zweiten Eingang des Und-Gatters 119 und dessen zweiter Ausgang auf einen zweiten Eingang des Und-Gatters 120 geführt ist. Der Ausgang des Und-Gatters 119, an dem ein Signal C22 ansteht, ist mit je einem ersten Eingang des Nor-Gatters 121, des Und-Gatters 125 und des Und-Gatters 130 verbunden, während der Ausgang des Und-Gatters 120, an dem das Signal C127 ansteht, auf einen zweiten Eingang des Nor-Gatters 121 sowie auf einen Ausgang der Steuereinheit 103 geführt ist. Der Ausgang des Nor-Gatters 121 ist mit einem ersten Eingang des Und-Gatters 122 verbunden, dessen zweiter Eingang auf den Eingang der Steuereinheit 103 geführt ist, an dem das 1MHz-Taktsignal ansteht, und dessen Ausgang mit einem Freigabeeingang des Zählers 117 verbunden ist. Der Ausgang des Verzögerungsgliedes 115, an dem das Signal T3 ansteht, ist über den Inverter 123 auf einen ersten Eingang des Und-Gatters 124 geführt, dessen Ausgang mit einem ersten Eingang des Oder-Gatters 126 verbunden ist. Der Ausgang des Verzögerungsgliedes 115, an dem das Signal T1 ansteht, ist auf einen zweiten Eingang des Und-Gatters 125 geführt, dessen Ausgang mit einem zweiten Eingang des Oder-Gatters 126 verbunden ist, wobei dessen Ausgang seinerseits auf den D-Eingang des Flip Flops 127 geführt ist. Am Q-Ausgang des Flip Flops 127 steht das Signal STRT an, welches auf einen zweiten Eingang des Und-Gatters 124, auf einen ersten Eingang des Oder-Gatters 129 und auf einen Ausgang der Steuereinheit 103 geführt ist. Die beiden Eingänge der Steuereinheit 103, an denen die Signale MF und B40 anstehen, sind mit einem ersten Eingang des Nor-Gatters 128 bzw. einem zweiten Eingang des Und-Gatters 130 verbunden. Der Ausgang des Nor-Gatters 128 speist einen zweiten Eingang des Oder-Gatters 129 und einen dritten Eingang des Und-Gatters 130. Der Ausgang des Oder-Gatters 129 ist auf den D-Eingang des Flip Flops 131 geführt, dessen invertierter Q-Ausgang mit einem zweiten Eingang des Nor-Gatters 128 verbunden ist. Der Ausgang des Und-Gatters 130 ist auf den D-Eingang des Flip Flops 132 geführt, dessen Q-Ausgang mit einem dritten Eingang des Nor-Gatters 128 verbunden ist und gleichzeitig den Ausgang der Steuereinheit 103 bildet, an dem das Signal ACK ansteht.

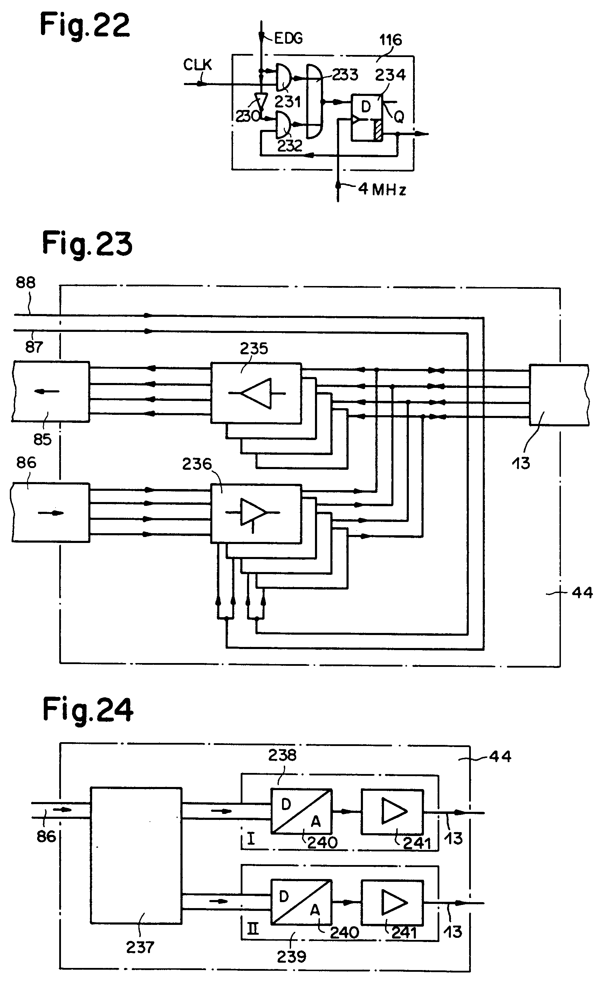

Der Zeitenzähler 111 misst die Dauer jedes Impulses und jeder Impulslücke des nichtsynchronisierten Taktsignals CLK. Zu diesem Zweck ist dieses Taktsignal CLK im Taktsignal-Statusspeicher 116 gespeichert, dessen Ausgang beim Vorliegen eines Impulses das Und-Gatter 119 und beim Vorliegen einer Impulslücke über den Inverter 120a das Und-Gatter 120 freigibt. Der Aufbau und die Funktionsweise des Taktsignal-Statusspeichers 116 wird anlässlich der Beschreibung der Fig. 22 näher erläutert. Zwecks Messung der Dauer der Impulse und der Impulslücken des Taktsignals CLK wird zu Beginn eines jeden Impulses und einer jeden Impulslücke des Taktsignals, d. h. zur Zeit einer jeden Flanke des Taktsignals CLK, durch das von einem Ausgang des Synchronisierers 114 kommende Signal EDG der Taktsignal-Statusspeicher 116 und der Zähler 117 auf Null zurückgestellt. Anschliessend beginnt der Zähler 117, der z. B. ein 7Bit-Zähler ist, die Impulse des 1MHz-Taktsignals zu zählen, welche ihn über das normalerweise freigegebene Und-Gatter 122 erreichen. Der Zählwert des Zählers 117 wird dabei fortlaufend mit Hilfe des Decodierers 118 decodiert.

Jedes übertragene Telegramm beginnt mit einem Startimpuls im Taktsignal CLK, dessen Dauer, welche auch "Idle Time" genannt wird, mindestens 22μs beträgt. Der Startimpuls ist im Kontrollmodul 10 eine Impulslücke und wegen seiner Invertierung in der Sendeschaltung 23 des Kontrollmoduls 10 (siehe Fig. 5) im Funktionsmodul 11 ein Impuls. Besitzt ein Impuls des Taktsignals CLK am Eingang des Zeitenzählers 111 mindestens eine Dauer von 22μs, dann zählt der Zähler 117 mindestens 22 Perioden von je 1μs des 1MHz-Taktsignals und erreicht mindestens den Zählwert 22, was für das Funktionsmodul 11 als Startsignal für den Empfang eines Telegramms gilt. Zu diesem Zweck gibt der decodierte Zählwert 22 des Zählers 117 das Und-Gatter 119 frei, so dass einerseits ein Logikwert "1" als Signal C22 an einem Ausgang des Zeitenzählers 111 und damit an je einem Eingang der Und-Gatter 125 und 130 erscheint und anderseits über das Nor-Gatter 121 das Und-Gatter 122 gesperrt wird, so dass keine 1MHz-Taktimpulse mehr den Zähler 117 erreichen und dieser somit beim Zählwert 22 stehen bleibt bis zu seiner nächsten Rückstellung durch das Signal EDG beim Erscheinen der nächsten Flanke des Taktsignals CLK, die als Impulsende-Flanke eine fallende Flanke ist. Zu dieser Zeit erscheint auch ein Impuls des Signals T1 von einem Ausgang des Verzögerungsgliedes 115 kommend an einem Eingang des Und-Gatters 125 des Startdetektors 112, so dass das Signal C22 über das Oder-Gatter 126 das Flip Flop 127 erreicht, in dem sein Logikwert "1" durch das 4MHz-Taktsignal abgespeichert wird, wobei das Flip Flop 127 über das Und-Gatter 124 und das Oder-Gatter 126 solange in diesem Logikzustand gehalten wird, bis 500ns später das Signal T3 vom Verzögerungsglied 115 kommend über den Inverter 123 das Und-Gatter 124 kurzzeitig sperrt, so dass das 4MHz-Taktsignal einen Logikwert "0" in das Flip Flop 127 lädt und dieses damit wieder auf Null zurückstellt. Am Ausgang des Flip Flops 127 und damit des Startdetektors 112 erscheint somit beim Vorliegen eines Startimpulses im Taktsignal CLK ein 500ns dauernder Impuls als Signal STRT, welches den Telegrammempfang im Funktionsmodul 11 startet.

Jedes übertragene Telegramm endet mit einem Stoppimpuls im Taktsignal CLK, dessen Dauer, welche auch "Timeout"-Zeit genannt wird, mindestens 127μs beträgt. Der Stoppimpuls ist im Kontrollmodul 10 ein Impuls und wegen seiner Invertierung in der Sendeschaltung 23 des Kontrollmoduls 10 (siehe Fig. 5) im Funktionsmodul 11 eine Impulslücke. Besitzt eine Impulslücke des Taktsignals CLK am Eingang des Zeitenzählers 111 mindestens eine Dauer von 127μs, dann zählt der Zähler 117 mindestens 127 Perioden von je 1μs des 1MHz-Taktsignals und erreicht mindestens den Zählwert 127. Der decodierte Zählwert 127 des Zählers 117 gibt das Und-Gatter 120 frei, so dass einerseits ein Logikwert "1" als Signal C127 an einem Ausgang des Zeitenzählers 111 und anderseits über das Nor-Gatter 121 das Und-Gatter 122 gesperrt wird, so dass keine 1MHz-Taktimpulse mehr den Zähler 117 erreichen und dieser somit beim Zählwert 127 stehen bleibt bis zu seiner nächsten Rückstellung durch das Signal EDG beim Erscheinen der nächsten Flanke des Taktsignals CLK.

Nach dem Startimpuls und vor dem Stoppimpuls erreicht der Zähler 117 normalerweise den Zählwert 22 bzw. 127 nicht, so dass an den Ausgängen des Zeitenzählers 111 dann kein Logikwert "1" erscheint. Sollte während der Übertragung eines Telegramms der Impuls des Taktsignals CLK am Eingang des Zeitenzählers 111 aus irgend einem Grund zu lange dauern, dann wird ein Startimpuls simmuliert. Das Telegramm wird sofort unterbrochen und ein neuer Start des Telegramms veranlasst.

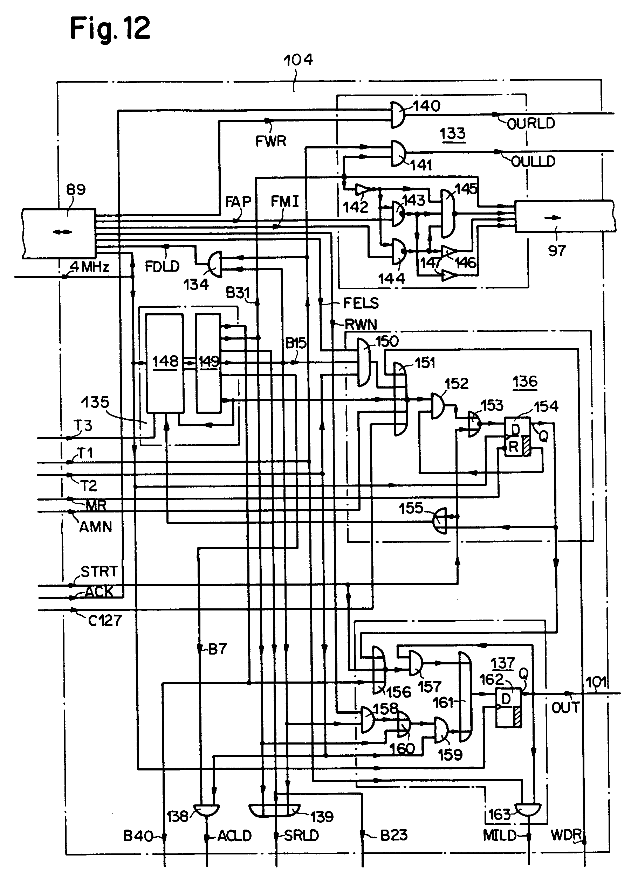

Wenn das Signal STRT bei Erfüllung der Startbedingung den Logikwert "1" annimmt, wird über das Oder-Gatter 129 das Flip Flop 131 des Bestätigungsgenerators 113 gesetzt und dadurch das Und-Gatter 130 über das Nor-Gatter 128 freigegeben. Dies bedeutet, dass das zugehörige Funktionsmodul 11 den Empfang eines Bestätigungssignals erwartet. Wenn ein Mithörfehler vom Mithör-Fehlerdetektor 82 der Interfaceschaltung 25 (siehe Fig. 9) erkannt wird, erscheint als Signal MF ein Logikwert "1" vom Mithör-Fehlerdetektor 82 kommend über die Drahtverbindung 99 an einem Eingang des Steuergerätes 83 und der Steuereinheit 103. Wenn ein Mithörfehler vorliegt, dann stellt das Signal MF über das Nor-Gatter 128 und das Oder-Gatter 129 das Flip Flop 131 zurück und es erfolgt kein Bestätigungssignal einer korrekten Telegrammübertragung bevor nicht ein neuer Telegrammstart erfolgt. Wenn kein Mithörfehler vorhanden ist, wird am Ende des Telegramms mit Hilfe des Signals B40 über das Und-Gatter 130 das Flip Flop 132 gesetzt, wenn das Signal C22 einen Logikwert "1" aufweist, d. h. wenn die Impulslücke am Ende des Telegramms mindestens die Länge eines Startimpulses besitzt. Am Q-Ausgang des Flip Flops 132 erscheint dann ein Logikwert "1" als Bestätigungssignal ACK für eine korrekte Telegrammübertragung. Das Bestätigungssignal ACK speist unter anderem einen Eingang des Und-Gatters 140 der Steuereinheit 104 (siehe Fig. 12).

Die in der Fig. 12 dargestellte Steuereinheit 104 besteht aus einer Logikschaltung 133, einem Und-Gatter 134, einem Bitzähler 135, einer NOP-Rückstellschaltung 136 (NOP = "Not operational"), einer Sendefreigabe-Schaltung 137, einem Und-Gatter 138 und einem Oder-Gatter 139. Die Logikschaltung 133 enthält zwei Und-Gatter 140 und 141, einen Inverter 142, zwei Nand-Gatter 143 und 144, ein Nand-Gatter 145 und zwei Inverter 146 und 147. Der Bitzähler 135 besteht aus einem Zähler 148 und einem Decodierer 149. Die NOP-Rückstellschaltung 136 enthält ein Und-Gatter 150, ein Nor-Gatter 151, ein Und-Gatter 152, ein Nor-Gatter 153, ein Flip Flop 154 und ein Oder-Gatter 155. Die Sendefreigabe-Schaltung 137 besteht aus einem Nor-Gatter 156, drei Und-Gattern 157, 158 und 159, zwei Oder-Gattern 160 und 161, einem Flip Flop 162 und einem Und-Gatter 163.

Die Steuereinheit 104 wird über den Steuerbus 89 mit fünf Signalen FWR, FAP, FMI, RWN und FELS gespeist. Ausserdem sind zehn Eingangssignale, nämlich das 4MHz-Taktsignal und die Signale T1, T2, T3, MR, AMN, STRT, ACK, C127 und WDR, vorhanden sowie, zusätzlich zu den in den Steuerbussen 89 und 97 vorhandenen Ausgangssignalen, noch acht Ausgangssignale, nämlich OURLD, OULLD, OUT, MILD, B23, SRLD, ACLD und B40, die an je einem einpoligen Ausgang der Steuereinheit 104 anstehen. Das 4MHz-Taktsignal speist einen sechsten Leiter des Steuerbusses 89, einen Takteingang des Zählers 148 sowie die Takteingänge der Flip Flop 154 und 162. Das Signal ACK speist einen ersten Eingang und das Signal FWR einen zweiten Eingang jeweils des Und-Gatters 140, dessen Ausgang den Ausgang der Steuereinheit 104 bildet, an dem das Signal OURLD ansteht. Das Signal T1 speist je einen ersten Eingang der Und-Gatter 141, 134 und 163. Das Signal T2 speist je einen ersten Eingang der Und-Gatter 150, 159 und 138. Das Signal T3 speist einen ersten Steuereingang des Zählers 148, dessen Parallelausgang auf einen Bus-Eingang des Decodierers 149 geführt ist, welcher seinerseits fünf Ausgänge, an denen je ein Signal B7, B15, B23, B31 und B40 ansteht, sowie einen sechsten Ausgang besitzt, der auf einen zweiten Steuereingang des Zählers 148 und auf einen ersten Eingang des Nor-Gatters 151 geführt ist. Das Signal B31 speist einen zweiten Eingang des Und-Gatters 141, einen ersten Leiter des Steuerbusses 97, je einen ersten Eingang der Oder-Gatter 160 und 139 sowie über den Inverter 142 je einen ersten Eingang der Nand-Gatter 145, 143 und 144. Der Ausgang des Und-Gatters 141 bildet den Ausgang der Steuereinheit 104, an dem das Signal OULLD ansteht. Die Signale FAP und FMI speisen je einen zweiten Eingang des Nand-Gatters 143 bzw. 144. Der Ausgang des Nand-Gatters 143 ist auf einen zweiten Eingang des Nand-Gatters 145 und über den Inverter 147 auf einen zweiten Leiter des Steuerbusses 97 geführt. Der Ausgang des Nand-Gatters 144 ist mit einem dritten Eingang des Nand-Gatters 145 und über den Inverter 146 mit einem dritten Leiter des Steuerbusses 97 verbunden. Der Ausgang des Nand-Gatters 145 speist seinerseits einen vierten Leiter des Steuerbusses 97. Das Signal B15 speist einerseits je einen zweiten Eingang der Und-Gatter 134 und 150 sowie des Oder-Gatters 139 und anderseits einen ersten Eingang des Und-Gatters 158. Der Ausgang des Und-Gatters 134, an dem ein Signal FDLD ansteht, ist auf einen siebten Leiter des Steuerbusses 89 geführt. Das Signal FELS speist einen dritten Eingang des Und-Gatters 150, dessen Ausgang auf einen zweiten Eingang des Nor-Gatters 151 geführt ist. Die Signale AMN, C127 und WDR speisen je einen weiteren Eingang des Nor-Gatters 151, dessen Ausgang mit einem ersten Eingang des Und-Gatters 152 verbunden ist. Der Ausgang des Und-Gatters 152 ist auf einen ersten Eingang des Nor-Gatters 153 geführt, dessen Ausgang mit dem D-Eingang des Flip Flops 154 verbunden ist. Das Signal STRT speist einen zweiten Eingang des Nor-Gatters 153 und je einen ersten Eingang des Nor-Gatters 156 und des Oder-Gatters 155, während das MR-Signal einen invertierenden Rückstelleingang des Flip Flops 154 speist. Der invertierte Q-Ausgang des Flip Flops 154 ist auf einen zweiten Eingang des Und-Gatters 152 und sein Q-Ausgang auf je einen zweiten Eingang des Oder-Gatters 155 und des Nor-Gatters 156 geführt. Das Signal B40 speist einen dritten Eingang des Nor-Gatters 156 und einen Ausgang der Steuereinheit 104. Der Ausgang des Nor-Gatters 156 ist mit einem ersten Eingang des Und-Gatters 157 verbunden, dessen Ausgang auf einen ersten Eingang des Oder-Gatters 161 geführt ist. Der Ausgang des Oder-Gatters 161 ist mit dem D-Eingang des Flip Flops 162 verbunden, während dessen Q-Ausgang, an dem das Signal OUT ansteht, auf je einen zweiten Eingang der Und-Gatter 157 und 163 sowie auf die Drahtverbindung 101 des Ausgangs der Steuereinheit 104 geführt ist. Am Ausgang des Und-Gatters 163 steht das Signal MILD an, welches einen weiteren Ausgang der Steuereinheit 104 speist. Das Signal RWN speist einen zweiten Eingang des Und-Gatters 158, dessen Ausgang mit einem zweiten Eingang des Oder-Gatters 160 verbunden ist. Der Ausgang des Oder-Gatters 160 ist auf einen zweiten Eingang des Und-Gatters 159 geführt, dessen Ausgang seinerseits mit einem zweiten Eingang des Oder-Gatters 161 verbunden ist. Das Signal B23 speist einen dritten Eingang des Oder-Gatters 139 und einen zusätzlichen Ausgang der Steuereinheit 104, während der Ausgang des Oder-Gatters 139, an dem das Signal SRLD ansteht, einen weiteren Ausgang der Steuereinheit 104 bildet. Das Signal B7 speist einen zweiten Eingang des Und-Gatters 138, dessen Ausgang, an dem das Signal ACLD ansteht, einen letzten Ausgang der Steuereinheit 104 bildet. Der Ausgang des Oder-Gatters 155 ist mit einem dritten Steuereingang des Zählers 148 verbunden.

Der Zähler 148 des Bitzählers 135 ist z. B. ein synchroner 6Bit-Zähler, dessen Zählwert fortlaufend im nachgeschalteten Decodierer 149 decodiert wird. Da die Bitfrequenz des Telegramms und die Frequenz des Taktsignals CLK gleich gross sind und annähernd einen Wert von 62,5 kHz aufweisen und da die Frequenz des Signals T3, dessen Impulse durch den Zähler 148 gezählt werden, gleich dieser Bitfrequenz ist, zählt der Zähler 148 die Anzahl Bit des Telegramms. Zu diesem Zweck stellt das Ausgangssignal STRT des Startdetektors 112, welches den Zähler 148 über das Oder-Gatter 155 erreicht, nach Erkennung der Startbedingung den Zähler 148 auf Null zurück und dieser zählt dann anschliessend die Impulse des Signals T3 und damit die Bitimpulse. Der Decodierer 149 decodiert die Zählwerte 7, 15, 23, 31, 40 und grösser 40. Die Ausgangssignale B7, B15, B23, B31 und B40 nehmen dementsprechend nach dem 8-ten, 16-ten, 24-ten, 32-ten und 41-ten Telegrammbit, d. h. am Ende eines jeden Bytes, einen Logikwert "1" an, was das Vorhandensein des zugehörigen Byteende anzeigt. Gleichzeitig besitzt der Decodierer 149 noch einen "Overflow"-Ausgang, an dem ein Logikwert "1" erscheint, wen mehr als 41 Impulse des Signals T3 vom Zähler 148 gezählt werden. Dieser Logikwert "1" wird einem Eingang des Zählers 148 zugeführt und stoppt innerhalb desselben den Zählvorgang, indem er den Zugang zur ersten Stufe des Zählers 148 mittels eines Und-Gatters unterbricht. Gleichzeitig erreicht dieser Logikwert "1" auch einen Eingang des Nor-Gatters 151 der NOP-Rückstellschaltung 136. Der Zählvorgang des Zählers 148 bleibt solange unterbrochen, bis ein erneuter Impuls des Signals STRT den Zähler 148 wieder auf Null zurückstellt.

Die Nop-Rückstellschaltung 136 veranlasst eine allgemeine Rückstellung auf Null des zugehörigen Funktionsmoduls 11 durch eine Rückstellung des Zählers 148 über das Oder-Gatter 155, wenn ein Logikwert "1" an seinem Ausgang erscheint. Dies geschieht, wenn einer der folgenden Fälle auftritt:

1) Die empfangene, im ersten Byte enthaltene Moduladresse stimmt nicht mit der eingestellten Adresse des vorliegenden Funktionsmoduls 11 überein. In diesem Fall besitzt das Signal AMN, welches im Adressenkomparator 71 erzeugt wird und über den Steuerbus 90 das Steuergerät 83 und die Steuereinheit 104 erreicht, einen Logikwert "1".

2) Das im adressierten Funktionsmodul 11 decodierte zweite Byte enthält keine gültige Funktion des Funktionsmoduls 11. In diesem Fall besitzt das Signal FELS, welches von einem Ausgang des Funktionsdecodierers 73 über den Steuerbus 89 das Steuergerät 83 und die Steuereinheit 104 erreicht, am Ende des zweiten Byte, d. h. wenn die Signale B15 und T2 je einen Logikwert "1" aufweisen, einen Logikwert "1". Dann besitzt der Ausgang des Und-Gatters 150 der NOP-Rückstellschaltung 136 ebenfalls einen Logikwert "1".

3) Die "Timeout"-Zeit ist abgelaufen, d. h. das Signal C127 weist einen Logikwert "1" auf.

4) Mehr als 40 Telegrammbit wurden übertragen, d. h. das "Overflow"-Ausgangssignal des Decodierers 149 besitzt einen Logikwert "1".

5) Die Zeit des "Watch Dog"-Zählers 106 ist abgelaufen, d. h. dessen Ausgangssignal WDR besitzt einen Logikwert "1".

6) Bei einer Eingabe einer allgemeinen Rückstellung ("Master reset"). In diesem Fall besitzt das Signal MR einen Logikwert "1".

Bei der Eingabe einer allgemeinen Rückstellung ("Master reset") wird in das Flip Flop 154 ein Logikwert "1" gesetzt. Wenn eine Startbedingung erfüllt ist, dann stellt das Signal STRT über das Nor-Gatter 153 das Flip Flop 154 auf Null zurück. Wenn nun einer der fünf ersten obenerwähnten Fälle auftritt, dann erscheint am Ausgang des Nor-Gatters 151 ein Logikwert "0", welcher das Und-Gatter 152 sperrt, so dass ein Logikwert "1" am D-Eingang des Flip Flops 154 erscheint und vom 4MHz-Taksignal anschliessend in diesem geladen wird.

Am Ausgang der Sendefreigabe-Schaltung 137 erscheint ein Logikwert "1", wenn das adressierte Funktionsmodul 11 senden soll. Das Flip Flop 162 ist am Ende eines Telegramms immer gesetzt, da dass letzte Byte eines Telegramms, nämlich das CRC-Byte, immer vom Funktionsmodul 11 wird. Das Flip Flop 162, welches eine Selbsthaltung in Gestalt des Und-Gatters 157 und des Oder-Gatters 161 besitzt, wird durch das Signal STRT, durch das Signal B40, welches einem 41-ten T3-Impuls entspricht, oder durch das Ausgangssignal der NOP-Rückstellschaltung 136 über das Nor-Gatter 156 auf Null zurückgestellt. Das Flip Flop 162 wird einerseits gesetzt, wenn nach Empfang des zweiten Bytes, d. h. wenn das Signal B15 einen Logikwert "1" besitzt, die decodierte Funktion eine Lesefunktion ist, d. h. wenn das Signal RWN, welches vom Funktionsdecodierer 73 kommend über den Steuerbus 89 das Steuergerät 83 und die Steuereinheit 104 erreicht, einen Logikwert "1" aufweist. Mit anderen Worten, wenn am Ausgang des Und-Gatters 158 ein Logikwert "1" erscheint, wird das Flip Flop 162 durch das 4MHz-Taktsignal gesetzt. Das Flip Flop 162 wird anderseits auch über das Oder-Gatter 160 jedesmal gesetzt, wenn das fünfte Byte des Telegramms gesendet werden muss, d. h. wenn das Signal B31 einen Logikwert "1" aufweist. Dies geschieht jeweils nur dann, wenn das Signal T2 einen Logikwert "1" aufweist, da nur dann das Und-Gatter 159 freigegeben ist. Das Signal OUT am Q-Augang des Flip Flops 162 gibt über die Drahtverbindung 101 das Ausgangs-Freigabegatter 84 der Interfaceschaltung 25 (siehe Fig. 9) und das Und-Gatter 217 im Multiplexer 81 (siehe Fig. 19) frei, wodurch unter anderem die seriellen Ausgangsbit des Schieberegisters 69 den Leiter 36 erreichen (siehe Fig. 9). Gleichzeitig erreicht das Signal OUT, wenn das Signal T1 einen Logikwert "1" besitzt, als Signal MILD über das Und-Gatter 163 (siehe Fig. 12) und den Steuerbus 95 (siehe Fig. 10) den Mithör-Fehlerdetektor 82 (siehe Fig. 9).

Nach dem zweiten, dritten und vierten Byte, d. h. wenn eines der Signale B15, B23 oder B31 einen Logikwert "1" besitzt, erscheint am Ausgang des Oder-Gatters 139 ein Logikwert "1" als Signal SRLD ("Shift Register:Load"), welches mit dem Signal T3 über den Steuerbus 91 (siehe Fig. 10) das Schieberegister 69 erreicht (siehe Fig. 9). Durch das Signal T3 wird das Schieberegister 69 freigegeben, während ein Logikwert "0" des Signals SRLD ein Schieben und ein Logikwert "1" ein Laden des Schieberegisters 69 bedeutet.

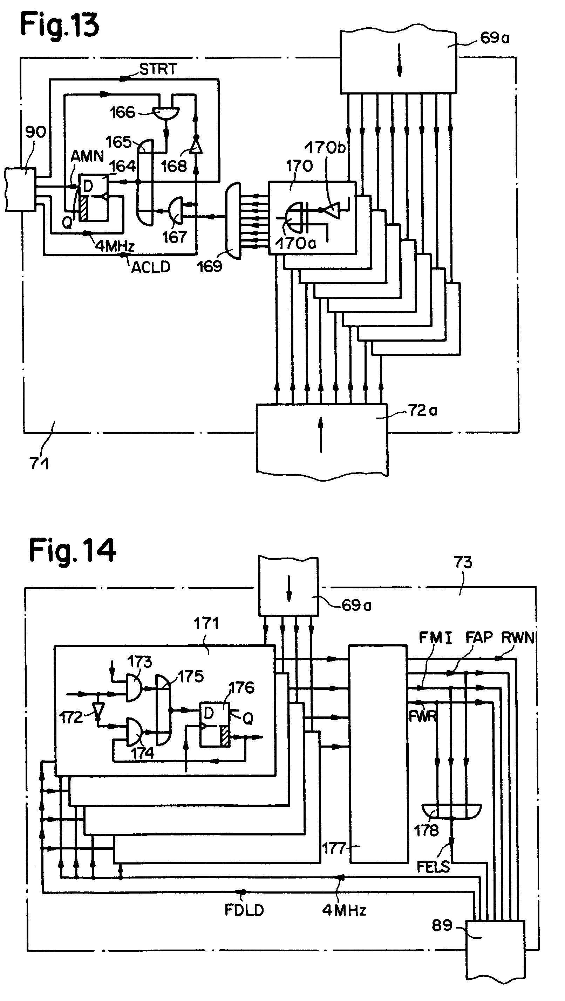

Jedem Funktionsmodul 11 ist eine Adresse zugeordnet, die mehrere Bit aufweist. Der in der Fig. 13 dargestellte Adressenkomparator 71 enthält ein Flip Flop 164, ein Nor-Gatter 165, zwei Und-Gatter 166 und 167, einen Inverter 168, ein Und-Gatter 169 und pro Bit der Adresse eine Vergleichsschaltung 170, die je aus einem Exklusiv-Oder-Gatter 170a und einem Inverter 170b besteht, wobei der Inverter 170b jeweils dem ersten Eingang des Exklusiv-Oder-Gatters 170a vorgeschaltet ist. Vorzugsweise besitzt die Adresse acht Bit. In diesem Fall sind somit acht Vergleichsschaltungen 170 vorhanden und die beiden Eingangsbusse 69a und 72a des Adressenkomparators 71 weisen dann je acht Busleiter auf. Je ein Busleiter des Busses 69a ist über je einen Inverter 170b mit einem ersten Eingang der acht Exklusiv-Oder-Gatter 170a verbunden, während ein zweiter Eingang der acht Exklusiv-Oder-Gatter 170a jeweils auf einen Busleiter des Busses 72a geführt ist. Der Ausgang der acht Exklusiv-Oder-Gatter 170a und damit der Vergleichsschaltungen 170 ist je auf einen Eingang des Und-Gatters 169 geführt, welches acht Eingänge aufweist. Über drei Leiter im Steuerbus 90 erreichen drei Signale, nämlich das 4MHz-Taktsignal sowie die Signale STRT und ACLD, den Adressenkomparator 71. Das Signal ACLD speist einen ersten Eingang des Und-Gatters 167 sowie über den Inverter 168 einen ersten Eingang des Und-Gatters 166. Das Signal STRT speist einen ersten Eingang des Nor-Gatters 165 und das 4MHz-Taktsignal den Takteingang des Flip Flops 164. Der Ausgang des Und-Gatters 166 ist mit einem zweiten Eingang des Nor-Gatters 165 und der Ausgang des Und-Gatters 169 mit einem zweiten Eingang des Und-Gatters 167 verbunden. Der Ausgang des letzten ist auf einen dritten Eingang des Nor-Gatters 165 geführt. Der Ausgang des Nor-Gatters 165 ist mit dem D-Eingang des Flip Flops 164 verbunden, dessen Q-Ausgang, an dem das Signal AMN ansteht, auf einen vierten Leiter des Steuerbusses 90 geführt ist, während der invertierte Q-Ausgang des Flip Flops 164 mit einem zweiten Eingang des Und-Gatters 166 verbunden ist.

Wenn die Signale B7 und T2 einen Logikwert "1" am Ende des ersten Bytes annehmen, dann erscheint über das Und-Gatter 138 (siehe Fig. 12) und den Steuerbus 90 (siehe Fig. 10) ein Logikwert "1" als Signal ACLD ("Address Comparator:Load") an einem Eingang des Und-Gatters 167 des Adressenkomparators 71 (siehe Fig. 13) und gibt dieses frei. Über den Bus 69a liegt die als erstes Byte empfangene Adresse an ersten Eingängen der Vergleichsschaltungen 170, während über den Bus 72a die hardwaremässig eingestellte Moduladresse des Funktionsmoduls 11 an zweiten Eingängen der Vergleichsschaltungen 170 liegt. Sind mindestens zwei gleich nummerierten Bit der beiden Adressen unterschiedlich, dann besitzt der Ausgang des Und-Gatters 169 einen Logikwert "0". Dieser wird im Nor-Gatter 165 invertiert und der invertierte Wert anschliessend mit Hilfe des 4MHz-Taktsignals im Flip Flop 164 gespeichert, um als Signal AMN auf einen Ausgangs-Busleiter des Steuerbusses 90 zu erscheinen. Das Und-Gatter 166 dient als Selbsthalte-Schaltung des Flip Flops 164 für den Fall, dass beide Adressen identisch sind und somit ein Logikwert "0" im Flip Flop 164 abgespeichert werden muss. Das Signal ACLD löscht diese Selbsthaltung, indem es das Und-Gatter 166 über den Inverter 168 sperrt. Gleichzeitig wird mit Hilfe des Und-Gatters 167 das Ausgangssignal des Und-Gatters 169 gelesen.

Der in der Fig. 14 darestellte Funktionsdecodierer 73 enthält unter anderem eine Speicherschaltung 171 pro Bit eines Funktionsbytes, welches z. B. vier Bit aufweist. In diesem Fall sind mindesten vier der acht Busleiter des Busses 69a als Eingangsleiter auf den Funktionsdecodierer 73 geführt. In jeder Speicherschaltung 171 ist ein Inverter 172, zwei Und-Gatter 173 und 174, ein Nor-Gatter 175 sowie ein Flip Flop 176 enthalten.

Der Funktionsdecodierer 73 enthält ausserdem noch ein Decodierer 177 und ein Nor-Gatter 178.

Der Funktionsdecodierer 73 wird über zwei Busleiter des Steuerbusses 89 mit dem Signal FDLD und dem 4MHz-Taktsignal gespeist. Letzteres speist die Takteingänge aller in den Speicherschaltungen 171 enthaltenen Flip Flop 176. Das Signal FDLD speist die Eingänge aller Speicherschaltungen 171. Innerhalb derselben ist deren Eingang auf einen ersten Eingang des Und-Gatters 173 und über den Inverter 172 auf einen ersten Eingang des Und-Gatters 174 geführt. Die Ausgänge der Und-Gatter 173 und 174 sind mit je einem Eingang des Nor-Gatters 175 verbunden, dessen Ausgang auf den D-Eingang des Flip Flops 176 geführt ist. Der invertierte Q-Ausgang des Flip Flops 176 ist einerseits mit einem zweiten Eingang des Und-Gatters 174 verbunden und bildet anderseits den Ausgang der Speicherschaltung 171. Jeder für das Funktionsbyte verwendete Busleiter des Busses 69a ist mit einem zweiten Eingang des Und-Gatters 173 der ihm zugehörigen Speicherschaltung 171 verbunden. Die Ausgänge der Speicherschaltungen 171 sind mit je einem Eingang des Decodierers 177 verbunden, der vier Ausgänge aufweist, an denen je eines der vier Signale FWR, FMI, FAP und RWN erscheint. Die drei Ausgänge des Decodierers 177, an denen die Signale FWR, FMI und FAP erscheinen, sind mit je einem Eingang des Nor-Gatters 178 verbunden, an dessem Ausgang das Signal FELS erscheint. Alle Signale FWR, FMI, FAP, RWN und FELS sind auf je einem Busleiter des Steuerbusses 89 geführt, der somit total sieben Busleiter aufweist.

Wenn in einem adressierten Funktionsmodul 11 die Signale B15 und T1 einen Logikwert "1" am Ende des zweiten Byte annehmen, dann erscheint über das Und-Gatter 134 (siehe Fig. 12) und den Steuerbus 89 (siehe Fig. 10 und Fig. 9) ein Logikwert "1" als Signal FDLD ("Function Decoder:Load") an einem Eingang der Speicherschaltung 171 des Funktionsdecodierers 73 (siehe Fig. 14). Die mit einer Bedeutung versehenen Bit des zweiten Telegrammbytes werden in diesem Augenblick im Flip Flop 176 der Speicherschaltungen 171 mit Hilfe des 4MHz-Taktsignals gespeichert, nachdem das Signal FDLD vorher die Selbsthaltung des Flip Flops 176, die mittels des Und-Gatters 174 realisiert ist, über den Inverter 172 gelöscht hat. Das in den Speicherschaltungen 171 gespeicherte zweite Telegrammbyte wird mit Hilfe des Decodierers 177 decodiert und es erscheint ein Logikwert "1" als Signal FAP, FMI, FWR oder RWN an einem Ausgang des Funktionsdecodierers 73, wenn das zweite Telegrammbyte eine Funktion "Addresspolling", Modulinformation, Schreibzyklus oder Datenrichtung angibt. Enthält das zweite Byte keine gültige Funktionsangabe, dann erscheint am Ausgang des Nor-Gatters 178 und damit an einem weiteren Ausgang des Funktionsdecodierers 73 ein Logikwert "1" als Signal FELS. Die Signale FAP, FMI, FWR, RWN und FELS erreichen dann über den Steuerbus 89 das Steuergerät 83 (siehe Fig. 9) und die Steuereinheit 104 (siehe Fig. 10).

In der Steuereinheit 104 (siehe Fig. 12) erreicht das Signal FAP, dessen Logikwert "1" als drittes und viertes Byte ein "Addresspolling"-Telegramm verlangt, über das normalerweise freigegebene Nand-Gatter 143, den Inverter 147 und den Steuerbus 97 einen Eingang des Bus-Multiplexers 70 (siehe Fig. 9), der innerhalb des letzten mit allen Steuereingängen derjenigen Bustreiber verbunden ist, die dem Bus 77a des Zufallscodegenerators 77 zugeordnet sind.

In der Steuereinheit 104 (siehe Fig. 12) erreicht das Signal FMI, dessen Logikwert "1" als drittes und viertes Byte ein Modulinformations-Telegramm verlangt, über das normalerweise freigegebene Nand-Gatter 144, den Inverter 146 und den Steuerbus 97 einen weiteren Eingang des Bus-Multiplexers 70 (siehe Fig. 9), der innerhalb des letzten mit allen Steuereingängen derjenigen Bustreiber verbunden ist, die dem Bus 78a des Modulinformations-Codierers 78 zugeordnet sind.

Die beiden Signale FAP und FMI erreichen invertiert über die normalerweise freigegebenen Nand-Gatter 143 und 144 das Nand-Gatter 145 (siehe Fig. 12). Besitzen beide Signale FAP und FMI einen Logikwert "0", dann wird als drittes und viertes Byte weder ein "Addresspolling"- noch ein Modulinformations-Telegramm verlangt und das dritte und vierte Byte stellt in diesem Fall immer eigentliche Datenbyte dar, deren Bit in einem Lese-Zyklus über den Eingangsbus 85 und das Eingangsfilter 79 den Bus-Multiplexer 70 erreichen (siehe Fig. 9). In diesem Fall erscheint am Ausgang des Nand-Gatters 145 ein Logikwert "1", der über den Steuerbus 97 einen weiteren Eingang des Bus-Multiplexers 70 (siehe Fig. 9) erreicht, der innerhalb des letzten mit allen Steuereingängen derjenigen Bustreiber verbunden ist, die dem Bus 79a des Eingangsfilters 79 zugeordnet sind.

In allen drei Fällen werden die Nand-Gatter 143, 144 und 145 am Ende des dritten Bytes durch das Signal B31 über den Inverter 142 gesperrt, da spätestens in diesem Augenblick der Inhalt des vierten Bytes bereits über den Bus-Multiplexer 70 ins Schieberegister 69 geladen sein muss. Gleichzeitig erreicht der Logikwert "1" des Signals B31 über den Steuerbus 97 einen weiteren Eingang des Bus-Multiplexers 70 (siehe Fig. 9), der innerhalb des letzten mit allen Steuereingängen derjenigen Bustreiber verbunden ist, die dem Bus 80a des CRC-Generators 80 zugeordnet sind, was den Ladevorgang der Bit des fünften Telegrammbytes in das Schieberegister 69 vorbereitet.

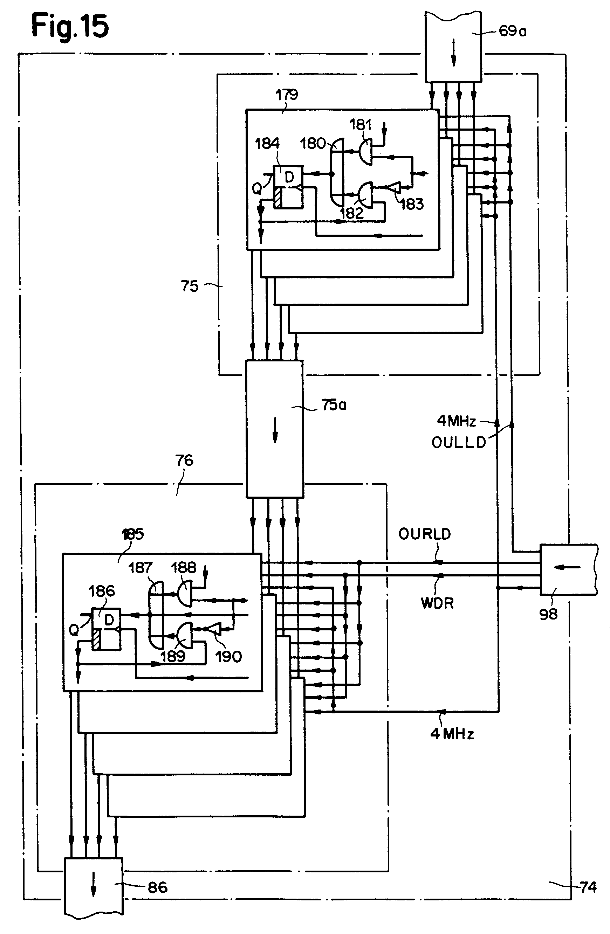

Die in der Fig. 15 dargestellte Ausgangsstufe 74 besteht, wie bereits erwähnt, aus dem Zwischenspeicher 75 und dem nachgeschalteten Ausgangsregister 76, wobei beide über einen Bus 75a miteinander verbunden sind. Der Zwischenspeicher 75 wird über den Bus 69a, der acht Busleiter aufweist, da alle Datenbyte vorzugsweise acht Bit besitzen, mit Daten gespeist. Der Zwischenspeicher 75 enthält pro Bit der Datenbyte eine Speicherschaltung 179, die jeweils aus einem Nor-Gatter 180, zwei Und-Gattern 181 und 182, einem Inverter 183 und einem Flip Flop 184 besteht.

Das Ausgangsregister 76 enthält pro Bit der Datenbyte eine Speicherschaltung 185, die jeweils aus einem Flip Flop 186, einem Nor-Gatter 187, zwei Und-Gattern 188 und 189 sowie einem Inverter 190 besteht. Die Speicherschaltungen 171 und 179 sind identisch aufgebaut, während die Speicherschaltungen 179 und 185 annähernd identisch aufgebaut sind mit dem einzigen Unterschied, dass das Nor-Gatter 180 nur zwei Eingänge aufweist, während das Nor-Gatter 187 drei Eingänge besitzt. Über die vier Busleiter des Steuerbusses 98 erreichen vier Signale die Ausgangsstufe 74, nämlich das 4MHz-Taktsignal sowie die Signale OULLD, OURLD und WDR. Das 4MHz-Taktsignal speist die Takteingänge aller Flip Flop 184 und 186 der Speicherschaltungen 179 bzw. 185. Das Signal OULLD speist einen Eingang aller Speicherschaltungen 179, während die Signale OURLD und WDR alle erste bzw. alle zweite Eingänge der Speicherschaltungen 185 speisen. Der Eingang einer jeden Speicherschaltung 179 ist innerhalb derselben jeweils mit einem ersten Eingang des Und-Gatters 181 und über den Inverter 183 mit einem ersten Eingang des Und-Gatters 182 verbunden. Je ein Busleiter des Busses 69a ist mit einem zweiten Eingang des Und-Gatters 181 der zugehörigen Speicherschaltung 179 verbunden, während der invertierte Q-Ausgang des Flip Flops 184 den Ausgang der zugehörigen Speicherschaltung 179 bildet. Die Ausgänge aller Speicherschaltungen 179 sind auf je einen Busleiter des Busses 75a geführt und über diese mit einem ersten Eingang des Und-Gatters 188 der zugehörigen Speicherschaltung 185 verbunden. Der erste Eingang einer jeden Speicherschaltung 185 ist innerhalb derselben auf einen zweiten Eingang des Und-Gatters 188 und über den Inverter 190 auf einen ersten Eingang des Und-Gaters 189 geführt. Der zweite Eingang einer jeden Speicherschaltung 185 ist innerhalb derselben auf den dritten Eingang des Nor-Gatters 187 geführt. Der invertierte Q-Ausgang des Flip Flops 186 aller Speicherschaltungen 185 ist mit je einem Busleiter des Ausgangsbusses 86 verbunden.

Nachfolgend wird einfachshalber angenommen, dass eigentliche Daten nur während des vierten Bytes vom Kontrollmodul 10 zum adressierten Funktionsmodul 11 übertragen werden beim Vorliegen eines Schreib-Zyklus. Wenn am Ende des vierten Bytes die Signale T1 und B31 einen Logikwert "1" aufweisen, dann erscheint am Ausgang des Und-Gatters 141 (siehe Fig. 12) ein Logikwert "1" als Signal OULLD ("Output Latch:Load"), welcher über den Steuerbus 98 (siehe Fig. 10 und Fig. 9) einen Eingang der Ausgangsstufe 74 und des Zwischenspeichers 75 erreicht und die im Schieberegister 69 vorhandenen Bitwerte über den Bus 69a in die Speicherschaltungen 179 lädt, wo sie in den Flip Flop 184 abgespeichert werden. Die letzten besitzen eine Selbsthaltung, die mittels der Inverter 183 und der Und-Gatter 182 realisiert ist. Diese zwischengespeicherten Bitwerte liegen über den Bus 75a am Buseingang des Ausgangsregisters 76.

Wenn am Ende des fünften Telegrammbytes das Signal ACK einen Logikwert "1" aufweist, d. h. wenn ein korrektes Telegramm übertragen wurde, und das Funktionsbyte einen Schreib-Zyklus angekündigt hatte, d. h. wenn das Signal FWR einen Logikwert "1" besitzt, dann erscheint am Ausgang des Und-Gatters 140 (siehe Fig. 12) ein Logikwert "1" als Signal OURLD ("Output Register:Load"), welcher über den Steuerbus 98 (siehe Fig. 10 und Fig. 9) einen Eingang der Ausgangsstufe 74 und des Ausgangsregisters 76 erreicht und die im Zwischenspeicher 75 zwischengespeicherten Bitwerte über den Bus 75a in die Speicherschaltungen 185 des Ausgangsregisters 76 lädt, wenn das Signal WDR des "Watch Dog"-Zählers einen Logikwert "0" aufweist. Diese Bitwerte werden dann in den Flip Flop 186 der Speicherschaltungen 185 abgespeichert. Die letzten besitzen wieder eine Selbsthaltung, die mittels des Inverters 190 und des Und-Gatters 189 realisiert ist. Die im Ausgangsregister 76 gespeicherten Bitwerte werden über den Ausgangsbus 86 der Ausgangsschaltung 44 des Funktionsmoduls 11 zugeführt, wo sie weiter verarbeitet werden. Erscheint ein Logikwert "1" als Signal WDR an einem der Eingänge der Ausgangsstufe 74 und des Ausgangsregisters 76, dann wird das Ausgangsregister 76 über das Nor-Gatter 187 auf Null zurückgestellt. Das Signal WDR erreicht vom Ausgang des "Watch Dog"-Zählers 106 (siehe Fig. 10) über den Steuerbus 98 die Ausgangsstufe 74.

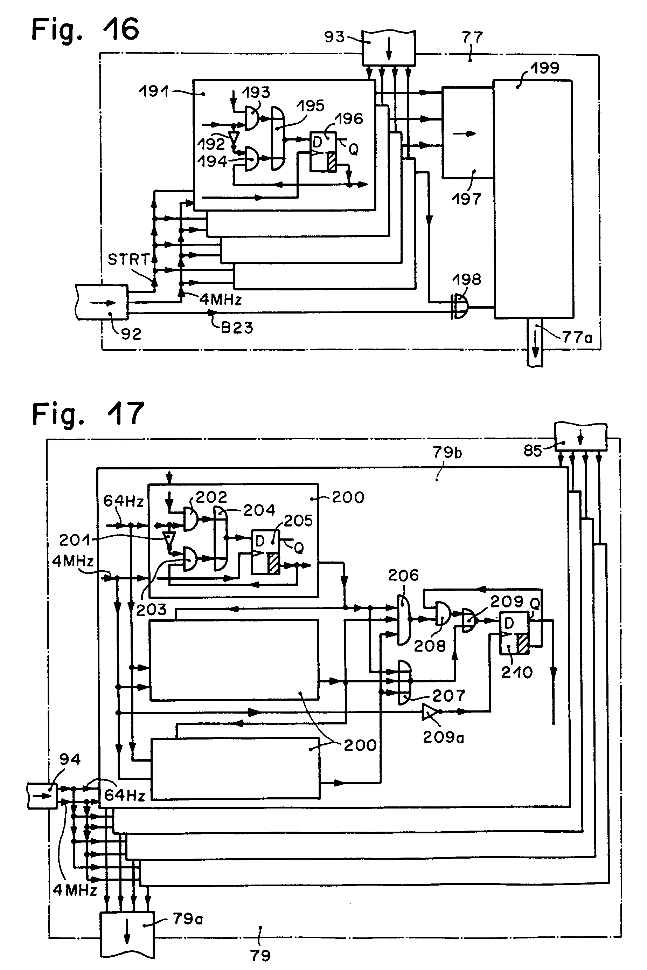

Der in der Fig. 16 dargestellte Zufallscodegenerator 77 wird über die z. B. vier Busleiter des Steuerbusses 93 mit vier Zufallsbit und über die drei Leiter des Steuerbusses 92 mit dem 4MHz-Taktsignal und den Signalen STRT und B23 gespeist. Der Zufallscodegenerator 77 enthält pro Busleiter des Steuerbusses 93 je eine Speicherschaltung 191, die aus einem Inverter 192, zwei Und-Gattern 193 und 194, einem Nor-Gatter 195 und einem Flip Flop 196 besteht. Die Speicherschaltung 191 ist identisch aufgebaut wie die Speicherschaltungen 171 und 179. Das 4MHz-Taktsignal speist die Takteingänge aller Flip Flop 196, während das Signal STRT einen Eingang aller Speicherschaltungen 191 speist. Der Eingang einer jeden Speicherschaltung 191 ist innerhalb derselben auf einen ersten Eingang des Und-Gatters 193 und über den Inverter auf einen ersten Eingang des Und-Gatters 194 geführt, während der invertierte Q-Ausgang des Flip Flops 196 den Ausgang der Speicherschaltung 191 bildet. Die Ausgänge der Speicherschaltungen 191 der drei niedrigsten Bit sind auf je einen Busleiter eines Busses 197 geführt. Der Zufallscodegenerator 77 enthält noch ein Exklusiv-Oder-Gatter 198 und einen "3 zu 8"-Decodierer 199, dessen Ausgang den Bus 77a bildet, der den Ausgangsbus des Zufallscodegenerators 77 darstellt. Der Bus 197 bildet den Eingangsbus des "3 zu 8"-Decodierers, während der Ausgang der vierten Speicherschaltung 191, in der das höchstwertigste Bit der vier Zufallsbit gespeichert ist, mit einem ersten Eingang des Exklusiv-Oder-Gatters 198 verbunden ist, dessen zweiter Eingang vom Signal B23 gespeist ist und dessen Ausgang auf einen weiteren Eingang des "3 zu 8"-Decodierers 199 geführt ist.

Im Zufallscodegenerator 77 werden 2 Byte, nämlich das dritte und vierte Byte des Telegramms erzeugt, wobei in den total 16 Bit der beiden Byte nur ein einziges Bit mit dem Logikwert "1" vorhanden ist, welcher sich ausserdem noch in einer Zufallsposition innerhalb eines der beiden Byte befindet. Über den Steuerbus 93 liegen die vier Zufallsbit, welche im Frequenzteiler 105 des Steuergerätes 83 erzeugt werden (siehe Fig. 10), am Eingang der Speicherschaltungen 191 des Zufallscodegenerators 77 und werden nach Erkennung der Startbedingung durch den Logikwert "1" des Signals STRT in dieselben geladen, wo sie jeweils in den Flip Flop 196 abgespeichert werden. Die Speicherschaltungen 191 besitzen je eine Selbsthalteschaltung, die mittels des Inverters 192 und Und-Gatters 194 realisiert ist. Die drei ersten Bit des so gespeicherten 4Bit-Zufallswertes werden im "3 zu 8"-Decodierer 199 decodiert. Mit dem vierten Bit des 4Bit-Zufallswertes wird das Byte - drittes oder viertes - ausgewählt, in welchem sich der Logikwert "1" befinden soll. Dies geschieht mit Hilfe des Exklusiv-Oder-Gatters 198, dessen Ausgang die "3 zu 8"-Decodierung freigibt, wenn sein Ausgang einen Logikwert "0" aufweist, d. h. wenn seine beide Eingangssignale gleich sind. Da das eine dieser Eingangssignale, nämlich das Signal B23, nur am Ende des dritten Telegrammbytes einen Logikwert "1" aufweist, wird der "3 zu 8"-Decodierer 199 nur zu Beginn des vierten Bytes freigegeben und der Logikwert "1" nur während des vierten Bytes gesendet, wenn das vierte Bit des 4Bit-Zufallswertes ein Logikwert "1" aufweist. Besitzt es dagegen einen Logikwert "0", dann wird der "3 zu 8"-Decodierer 199 bereits zu Beginn des dritten Bytes freigegeben, so dass der Logikwert "1" bereits während des dritten Bytes gesendet wird. In diesem Fall ist die "3 zu 8"-Decodierung zu Beginn des vierten Byte gesperrt, so dass in diesem kein Logikwert "1" vorhanden ist. Der "3 zu 8"-Decodierer 199 erzeugt an einem einzigen seiner Ausgänge ein Logikwert "1", wobei dieser Ausgang durch den 3Bit-Eingangswert des "3 zu 8"-Decodierers 199 bestimmt wird.

Der Eingangsbus 85 des in der Fig. 17 dargestellten Eingangsfilters 79 besitzt z. B. acht Busleiter, d. h. für jedes Bit eines Datenbytes einen Busleiter. Zu jedem Busleiter des Eingangsbusses 85 gehört ein Bitfilter 79b. Jedes Bitfilter 79b enthält drei Speicherschaltungen 200, die je aus einem Inverter 201, zwei Und-Gattern 202 und 203, einem Nor-Gatter 204 und einem Flip Flop 205 bestehen. Die Speicherschaltungen 200 sind identisch aufgebaut wie die Speicherschaltungen 171, 179 und 191. Ausserdem enthält jedes Bitfilter 79b noch ein Nand-Gatter 206, ein Nor-Gatter 207, ein Und-Gatter 208, ein Nor-Gatter 209, einen Inverter 209a und ein Flip Flop 210.

Jeder Busleiter des Eingangsbusses 85 ist auf einen ersten Eingang des Und-Gatters 202 einer ersten Speicherschaltung 200 des zu im gehörigen Bitfilters 79b geführt. In jedem Bitfilter 79b ist der Ausgang der ersten Speicherschaltung 200 auf je einen ersten Eingang des Und-Gatters 202 einer zweiten Speicherschaltung 200, des Nand-Gatters 206 und des Nor-Gatters 207 geführt, während jeweils der Ausgang der zweiten Speicherschaltung 200 auf einen ersten Eingang des Und-Gatters 202 der dritten Speicherschaltung 200 und auf je einen zweiten Eingang des Nand-Gatters 206 und des Nor-Gatters 207 geführt ist. Der Ausgang der dritten Speicherschaltung 200 ist in jedem Bitfilter 79b mit je einem dritten Eingang des Nand-Gatters 206 und des Nor-Gatters 207 verbunden. In jedem Bitfilter 79b ist der Ausgang des Nand-Gatters 206 auf einen ersten Eingang des Und-Gatters 208 geführt, dessen zweiter Eingang mit dem invertierten Q-Ausgang des Flip Flops 210 verbunden ist. Der Ausgang des Und-Gatters 208 und des Nor-Gatters 207 sind auf je einen Eingang des Nor-Gatters 209 geführt, dessen Ausgang mit dem D-Eingang des Flip Flops 210 verbunden ist. Der Q-Ausgang des Flip Flops 210 bildet den Ausgang des zugehörigen Bitfilters 79b. Die Ausgänge aller Bitfilter 79b sind auf je einen Busleiter des Busses 79a geführt, der den Ausgangsbus des Eingangsfilters 79 bildet. Das Eingangsfilter 79 wird über die beiden Busleiter des Steuerbusses 94 mit dem 4MHz-Taktsignal und dem 64Hz-Taktsignal gespeist. Das 4 MHz-Taktsignal speist die Takteingänge aller Flip Flop 205 und über den Inverter 209a die Takteingänge der Flip Flop 210 aller Speicherschaltungen 200 bzw. aller Bitfilter 79b. Das 64Hz-Taktsignal speist in allen Bitfiltern 79b den Eingang aller Speicherschaltungen 200. Dieser Eingang ist innerhalb einer jeden Speicherschaltung mit einem zweiten Eingang des Und-Gatters 202 und über den Inverter 201 mit einem ersten Eingang des Und-Gatters 203 verbunden.

Über den Eingangsbus 85 erreicht jedes Bit eines eigentlichen Datenbyte, welches vom addressierten Funktionsmodul 11 zum Kontrollmodul 10 zu übertragen ist, den Eingang einer ersten Speicherschaltung 200, in der sie zur Zeit der Impulse des 64Hz-Taktsignals geladen werden, um im Flip Flop 205 der betreffenden Speicherzelle 200 abgespeichert zu werden. Jede dieser Speicherschaltungen 200 besitzt eine Selbsthaltung, die mit Hilfe des Inverters 201 und des Und-Gatters 203 realisiert ist. Der Inhalt der ersten Speicherschaltung 200 wird anschliessend in der zweiten Speicherschaltung 200 und dann schliesslich deren Inhalt in der dritten Speicherschaltung 200 geschoben. Das Eingangsfilter 79 dient dazu Störimpulse, die ggf. auf den Eingangsbus 85 erscheinen, zu eliminieren. Dies geschieht dadurch, dass ein Bitwert nur als gültig gilt, wenn in den drei zusammengehörigen Speicherschaltungen 200 ein gleicher Bitwert abgespeichert ist. In diesem Fall wird dieser Bitwert über das Nand-Gatter 206, wenn der Bitwert ein Logikwert "1" ist, oder über das Nor-Gatter 207, wenn der Bitwert ein Logikwert "0" ist, mit der fallenden Flanke des 4MHz-Taktsignals in das Flip Flop 210 geladen und damit dem Bus 79a am Ausgang des Eingangsfilters 79 zugeleitet. Das Flip Flop 210 besitzt eine Selbsthaltung, die mittels des Und-Gatters 208 realisiert ist.

Der in der Fig. 18 dargestellte CRC-Generator 80 besteht aus einem Schieberegister 211 und drei Addierern 212, 213 und 214. Jeder Addierer 212, 213 und 214 arbeitet als "Modulo 2 Addierer" und besteht aus einem Exklusiv-Oder-Gatter. Der CRC-Generator 80 erzeugt ein CRC-Byte, welches vorzugsweise acht Bit besitzt. In diesem Fall besteht das Schieberegister 211 ebenfalls aus acht Bitzellen 0 bis 7. Der 8Bit-Parallelausgang des Schieberegisters 211 bildet den Bus 80a, der den Ausgangsbus des CRC-Generators darstellt. Die vom Multiplexer 81 herkommende Drahtverbindung 81a ist auf einen ersten Eingang des Addierers 212 geführt, dessen zweiter Eingang mit dem Ausgang der Bitzelle 7 des Schieberegisters 211 und dessen Ausgang mit je einem ersten Eingang der Addierer 213 und 214 sowie mit einem Eingang der Bitzelle 0 des Schieberegisters 211 verbunden ist. Ein Parallelausgang der Bitzelle 6 ist auf einen zweiten Eingang des Addierers 213 geführt, dessen Ausgang mit einem Paralleleingang der Bitzelle 7 verbunden ist. Ein Parallelausgang der Bitzelle 1 ist auf einen zweiten Eingang des Addierers 214 geführt, dessen Ausgang mit einem Paralleleingang der Bitzelle 2 verbunden ist. Über drei Leiter des Steuerbusses 96 werden dem CRC-Generator 80 das 4MHz-Taktsignal sowie die Signale STRTN und CRE zugeführt. Das 4MHz-Taktsignal speist die Takteingänge aller Bitzellen des Schieberegisters 211. Die Signale STRTN und CRE speisen je einen weiteren Eingang des Schieberegisters 211.

Der in der Fig. 19 dargestellte Multiplexer 81 besteht aus einem Inverter 215, zwei Und-Gattern 216 und 217 und einem Oder-Gatter 218. Der Leiter 35 und die Drahtverbindung 100 sind auf je einen ersten Eingang der Und-Gatter 216 bzw. 217 geführt, deren Ausgänge mit je einem Eingang des Oder-Gatters 218 verbunden sind. Die Drahtverbindung 101 ist auf einen zweiten Eingang des Und-Gatters 217 und über den Inverter 215 auf einen zweiten Eingang des Und-Gatters 216 geführt. Der Ausgang des Oder-Gatters 218 bildet den Ausgang des Multiplexers 81 und ist an dem Leiter 81a angeschlossen.

Während der Zeit, in der durch das Funktionsmodul 11 Telegrammbyte empfangen werden sollen, liegt ein Logikwert "0" auf der Drahtverbindung 101, so dass das Und-Gatter 217 gesperrt und das Und-Gatter 216 freigegeben ist. Die auf dem Leiter 35 empfangenen zeitseriellen Bit des Telegramms erreichen somit über das Und-Gatter 216 und den Leiter 81a den Eingang des CRC-Generators 80. Sollen dagegen Byte durch das Funktionsmodul 11 gesendet werden, dann liegt ein Logikwert "1" auf der Drahtverbindung 101, die einerseits das Ausgangs-Freigabegatter 84 (siehe Fig. 9) und anderseits das Und-Gatter 217 freigibt unter gleichzeitiger Sperrung des Und-Gatters 216. Die zeitseriellen Bit des gesandten Telegramms erreichen dann vom seriellen Ausgang des Schieberegisters 69 kommend über das Und-Gatter 217 und den Leiter 81a den Eingang des CRC-Generators 80 (siehe Fig. 9 und Fig. 19).

In den Eingang des CRC-Generators 80 und damit in dessen rückgekoppeltes Schieberegister 211 werden somit jeweils zeitseriell die empfangenen und die gesendeten Bit des Telegramms hineingeschoben (siehe Fig. 18). Im adressierten Funktionsmodul 11 bildet der CRC-Generator das CRC-Byte ("cyclic redundant check byte"), welches als fünftes Byte in jedem Telegramm vom betreffenden Funktionsmodul 11 gesendet wird, indem er die vier ersten Byte des Telegramms, nämlich das Adressenbyte, das Funktionsbyte, das erste und das zweite Datenbyte, fortlaufend durch ein Generatorpolynom $g(z) = z^8 + z^7 + z^2 + 1$ binär teilt. Der CRC-Generator 80 erhält vom Steuergerät 83 (siehe Fig. 10) die Signale STRTN und CRE über den Steuerbus 96. Bei Erfüllung der Startbedingung stellt das Signal STRTN das Schieberegister 211 auf Null zurück, worauf anschliessend die Bit der vier ersten Byte des Telegramms zeitseriell mittels des 4MHz-Taktsignals in das Schieberegister 211 hineingeschoben und die vier Byte mittels dessen Rückkopplungen über die Exklusiv-Oder-Gatter der Addierer 212, 213 und 214 durch das Generatorpolynom g(z) binär geteilt werden. Wenn kein Mithörfehler vorliegt, d. h. wenn das Signal MF einen Logikwert "0" besitzt, und wenn das Signal T2 einen Logikwert "1" aufweist, erscheint am Ausgang des Und-Gatters 107 (siehe Fig. 10) ein Logikwert "1" als Signal CRE, welcher die Auswertung desjenigen Bit freigibt, welches gerade am Eingang des CRC-Generators 80 ansteht. Am Parallelausgang des Schieberegisters 211 und damit auf dem Bus 80a steht dann nach Ablauf des vierten Byte des Telegramms das berechnete CRC-Byte an.

Wie bereits erwähnt sind der Multiplexer 65a und der CRC-Generator 65b der Interfaceschaltung 21 des Kontrollmoduls 10 ähnlich aufgebaut wie der Multiplexer 81 und der CRC-Generator 80 der Interfaceschaltung 25 der Funktionsmodule 11, wobei das Signal ER die Rolle des Signals CRE, das Taktsignal CLK die Rolle des 4MHz-Taktsignals und das Rückstellsignal CLR die Rolle des Signals STRTN übernimmt (siehe Fig. 8). Ähnlich wie beim Funktionsmodul 11 werden in das rückgekoppelte Schieberegister des CRC-Generators 65b die diesmal vom Kontrollmodul 10 gesendeten und empfangenen Byte zeitlich nacheinander hineingeschoben und fortlaufend durch das gleiche Generatorpolynom g(z) binär geteilt, welches auch in den Funktionsmodulen 11 verwendet wird, mit dem Unterschied, dass im Kontrollmodul 10 nicht vier Byte, sondern alle fünf Byte des Telegramms, also auch das empfangene CRC-Byte, durch das Generatorpolynom g(z) binär geteilt werden. Beim Nichtvorhandensein eines Übertragungsfehlers muss das Resultat dieser binären Teilung am Ende des fünften Bytes, d. h. am Telegrammende, gleich Nul sein, d. h. alle im Schieberegister des CRC-Generators 65b gespeicherten Bit müssen dann Null sein. Nur in diesem Fall erscheint beim Telegrammende ein Logikwert "0" am Ausgang des Oder-Gatters 65c (siehe Fig. 8) als Indikation einer fehlerfreien Übertragung. Beim Vorliegen eines Übertragungsfehlers ist dagegen mindestens ein Bit im Schieberegister des CRC-Generators 65b unterschiedlich von Null, so dass in diesem Fall am Telegrammende ein Logikwert "1" am Ausgang des als Decodierer funktionierenden Oder-Gatters 65c erscheint, der im Statusregister 62 abgespeichert wird zwecks Indikation eines Übertragungsfehlers und Auslösung einer Sendewiederholung.

Über drei Leiter des Steuerbusses 95 werden dem in der Fig. 20 dargestellten Mithör-Fehlerdetektor 82 das 4MHz-Taktsignal und die Signale STRTN und MILD zugeführt. Der Mithör-Fehlerdetektor 82 besteht aus einem Nicht-Exklusiv-Oder-Gatter 219, einem Und-Gatter 220, einem Oder-Gatter 221, einem Und-Gatter 222 und einem Flip Flop 223. Der Leiter 35 und die Drahtverbindung 100 sind je an einem Eingang des Nicht-Exklusiv-Oder-Gatters 219 angeschlossen, dessen Ausgang auf einen ersten Eingang des Und-Gatters 220 geführt ist. Die Signale MILD und STRTN speisen einen zweiten Eingang des Und-Gatters 220 bzw. einen ersten Eingang des Und-Gatters 222. Der Ausgang des Und-Gatters 220 ist auf einen ersten Eingang des Oder-Gatters 221 geführt, dessen zweiter Eingang mit dem Q-Ausgang des Flip Flops 223 verbunden ist, der gleichzeitig den Ausgang des Mithör-Fehlerdetektors 82 bildet, an dem das Signal MF ansteht und der an der Drahtverbindung 99 angeschlossen ist. Der Ausgang des Oder-Gatters 221 ist auf einen zweiten Eingang des Und-Gatters 222 geführt, dessen Ausgang mit dem D-Eingang des Flip Flops 223 verbunden ist. Das 4MHz-Taktsignal speist den Takteingang des Flip Flops 223.

Wenn das Funktionsmodul 11 eines oder mehrere Byte sendet, dann erreichen die Bit dieser Byte zeitseriell nacheinander vom seriellen Ausgang des Schieberegisters 69 kommend einerseits direkt einen ersten Eingang des Mithör-Fehlerdetektors 82 (siehe Fig. 9) und anderseits invertiert über das Ausgangs-Freigabegatter 84, den Leiter 36, die Sendeeinheit 27, eine der beiden Empfangseinheiten 28 und den Leiter 35 (siehe Fig. 5) einen zweiten Eingang des Mithör-Fehlerdetektors 82. Beide Eingangssignale des Mithör-Fehlerdetektors 82 müssen somit unterschiedlich sein. In dies nicht der Fall, dann erscheint ein Logikwert "1" am Ausgang des Nicht-Exklusiv-Oder-Gatters 219, welcher als Alarm im Flip Flop 223 gespeichert wird und als Signal MF am Ausgang des Mithör-Fehlerdetektors 82 erscheint (siehe Fig. 20), wenn das Signal MILD, welches vom Und-Gatter 163 kommt (siehe Fig. 12), einen Logikwert "1" aufweist. Das Signal MILD besitzt einen Logikwert "1", wenn das Funktionsmodul 11 auf Senden geschaltet ist und das Signal T1 einen Logikwert "1" aufweist. Das Flip Flop 223 besitzt eine Selbsthalteschaltung, welche durch das Oder-Gatter 221 gebildet ist. Das Signal STRTN stellt das Flip Flop 223 zu Beginn eines jeden Telegramms auf Null zurück.

Genau wie jedes Funktionsmodul 11 die Byte mithört, die es selber sendet, so hört auch das Kontrollmodul 10 diejenigen Byte mit, die es selber sendet, und wertet sie mit Hilfe des Mithör-Fehlerdetektors 64 aus. Dieser arbeitet ähnlich wie der Mithör-Fehlerdetektor 82 der Funktionsmodule 11, wobei das Signal ES die Rolle des Signals MILD, das Taktsignal CLK die Rolle des 4MHz-Taktsignals und das Rückstellsignal CLR die Rolle des Signals STRTN übernimmt (siehe Fig. 8). Stimmt wenigstens ein mitgehörtes Bit nicht mit dem gesendeten Bit überein, dann erscheint am Ausgang des Mithör-Fehlerdetektors 64 ein Logikwert "1", der im Statusregister 62 lesbar abgespeichert wird zwecks Unterbrechung des Telegramms und Veranlassung einer Sendewiederholung. Tritt während der Übertragung ein Mithörfehler auf, wird jeweils unverzüglich die Telegrammübertragung unterbrochen und ein "Interrupt"-Signal ITR ausgelöst.

Eine durch das Kontrollmodul 10 sowohl bei der CRC- als auch bei der Mithör-Kontrolle erkannte fehlerfreie Übertragung wird nach dem Telegrammende durch das Kontrollmodul 10 bestätigt, indem es nach dem vierzigsten Taktimpuls des Taktsignals CLK mit Hilfe des Signals EC und des Und-Gatters 66a der Sendeeinheit 66 (siehe Fig. 8) ein Bestätigungsimpuls "Telegramm in Ornung" auf die Leiter 29 und 30 des Taktsignals CLK gibt (siehe Fig. 5). Dieser Bestätigungsimpuls besteht vorzugsweise darin, dass am Telegrammende der Startimpuls noch einmal als Bestätigung gesendet wird. Bei einem fehlerhaften Telegramm gibt das Kontrollmodul 10 dagegen einen Bestätigungsimpuls "Telegramm nicht in Ordnung" auf die Leiter 29 und 30. Durch diesen Bestätigungsimpuls erfährt das adressierte Funktionsmodul 11, ob das empfangene Telegramm in Ordnung war und führt erst dann die empfangenen und in der Zwischenzeit abgespeicherten Befehle definitiv aus. Der Bestätigungsimpuls "Telegramm nicht in Ordnung" besteht vorzugsweise darin, dass am Telegrammende die sogenannte "Time out"-Zeit abgewartet wird, bevor ein erneuter Startimpuls über die Leiter 29 und 30 gesendet wird.

Gleichzeitig mit dem Bestätigungssignal "Telegramm in Ordnung" werden im Kontrollmodul 10 die Register 58 bis 61 (siehe Fig. 8), deren Schreiben während der Telegrammübertragung gesperrt war, wieder für einen Schreibvorgang freigegeben und wird das "Interrupt"-Signal ITR ausgelöst. Letzteres wird durch ein nachfolgendes Lesen des Statusregisters 62 auf Null zurückgestellt.

Der in der Fig. 21 dargestellte Taktsynchronisierer 110 besteht, wie bereits erwähnt, aus dem Sychronisierer 114 und dem nachgeschalteten Verzögerungsglied 115. Der Synchronisierer 114 besteht seinerseits aus zwei Flip Flop 224 und 225, einem Und-Gatter 226 und einem Nicht-Exklusiv-Oder-Gatter 227, während das Verzögerungsglied 115 aus zwei Flip Flop 228 und 229 besteht. Das 4MHz-Taktsignal speist die Takteingänge der Flip Flop 224, 225, 228 und 229, während das Taktsignal CLK den D-Eingang des Flip Flops 224 speist. Der Q-Ausgang des Flip Flops 224 ist auf den D-Eingang des Flip Flops 225 geführt und sein invertierter Q-Ausgang mit je einem ersten Eingang des Und-Gatters 226 und des Nicht-Exklusiv-Oder-Gatters 227 verbunden. Der Ausgang des Flip Flops 225 ist auf je einen zweiten Eingang des Und-Gatters 226 und des Nicht-Exklusiv-Oder-Gatters 227 geführt, wobei der Ausgang des letzten, an dem das Signal EDG ansteht, einen ersten Ausgang des Synchronisierers 114 und des Taktsynchronisierers 110 bildet. Der Ausgang des Und-Gatters 226 bildet einen zweiten Ausgang des Synchronisierers 114 und des Taktsynchronisierers 110, an dem das Signal T1 ansteht, und ist gleichzeitig mit dem D-Eingang des Flip Flops 228 verbunden, dessen Q-Ausgang auf den D-Eingang des Flip Flops 229 geführt ist und gleichzeitig einen Ausgang des Taktsynchronisierers 110 bildet, an dem das Signal T2 ansteht. Der Q-Ausgang des Flip Flops 229 bildet den Ausgang des Taktsynchronisierers 110, an dem das Signal T3 ansteht.

Das Taktsignal CLK erreicht vom Kontrollmodul 10 kommend über die Busverbindung 12; 14 und den Leiter 34 das Steuergerät 83 (siehe Fig. 9) und in demselben einen Takteingang des Taktsynchronisierers 110 und damit des Synchronisierers 114 (siehe Fig. 11) der Steuereinheit 103. Im Synchronisierer 114 (siehe Fig. 21) wird das Taktsignal CLK in den beiden Flip Flop 224 und 225 mit Hilfe des 4MHz-Taktsignals abgetastet, dessen Periode 250 ns beträgt. Das Taktsignal CLK wird mit den steigenden Flanken des 4MHz-Taktsignals in das Flip Flop 224 geladen und dadurch synchronisiert, d. h. am Q-Ausgang des Flip Flops 224 steht ein synchronisiertes Taktsignal CLK an. Im Flip Flop 225 ist dagegen das nichtsynchronisierte Taktsignal CLK gespeichert. Das synchronisierte und das nichtsynchronisierte Taktsignal CLK sind nur in der Nähe ihrer Flanken für eine Dauer von höchstens 250 ns unterschiedlich, so dass am Ausgang des Nicht-Exklusiv-Oder-Gatters 227 nur dann ein Logikwert "1" als Signal EDG erscheint. Es steht somit bei jeder Flanke des Taktsignals CLK ein Impuls, der eine maximale Dauer von 250 ns aufweist, als Signal EDG an einem der Ausgänge des Taktsynchronisieres 110 an. Wenn dagegen im Flip Flop 224 ein Logikwert "0" und im Flip Flop 226 ein Logikwert "1" vorhanden ist, d. h. beim Vorliegen einer fallenden Flanke des Taktsignals CLK, dann erscheint am Ausgang des Und-Gatters 226 und damit an einem weiteren Ausgang des Taktsynchronisierers 110 ein Logikwert "1" als Signal T1. Es steht somit bei jeder fallenden Flanke des Taktsignals CLK ein Impuls mit einer maximalen Dauer von 250 ns als Signal T1 an einem der Ausgänge des Taktsynchronisierers 110 an. Das Signal T1 wird im Flip Flop 228 um 250 ns verzögert, so dass an dessem Q-Ausgang und damit an einem der Ausgänge des Taktsynchronisierers 110 bei jeder fallenden Flanke des Taktsignals CLK ein Impuls als Signal T2 erscheint, der jeweils um 250 ns auf den zugehörigen Impuls des Signals T1 verzögert ist. Das Signal T2 wird im Flip Flop 229 ebenfalls um 250 ns verzögert, so dass an dessem Q-Ausgang und damit an einem der Ausgänge des Taktsynchronisierers 110 bei jeder fallenden Flanke des Taktsignals CLK ein Impuls als Signal T3 erscheint, der jeweils um 250 ns auf den zugehörigen Impuls des Signals T2 verzögert ist.

Der in der Fig. 22 dargestellte Taktsignal-Statusspeicher 116 besteht aus einem Inverter 230, zwei Und-Gattern 231 und 232, einem Nor-Gatter 233 und einem Flip Flop 234. Das Signal EDG ist auf einen ersten Eingang des Und-Gatters 231 und über den Inverter 230 auf einen ersten Eingang des Und-Gatters 232 geführt. Die Ausgänge der Und-Gatter 231 und 232 sind mit je einem Eingang des Nor-Gatters 233 verbunden, dessen Ausgang auf den D-Eingang des Flip Flops 234 geführt ist. Das Taktsignal CLK speist einen zweiten Eingang des Und-Gatters 231 und das 4MHz-Taktsignal den Takteingang des Flip Flops 234, dessen invertierter Q-Ausgang mit einem zweiten Eingang des Und-Gatters 232 verbunden ist und gleichzeitig den Ausgang des Taktsignal-Statusspeichers 116 bildet.

Das nichtsynchronisierte Taktsignal CLK speist gemäss Fig. 11 einen Eingang des Zeitenzählers 111 und damit des Taktsignal-Statusspeichers 116. Im letzten wird der Status des Taktsignals CLK im Flip Flop 234 synchron durch das 4MHz-Taktsignal gespeichert. Dieses Flip Flop 234 (siehe Fig. 22) besitzt eine Halteschaltung, die mittels des Und-Gatters 232 und des Nor-Gatters 233 realisiert ist. Bei jeder Flanke des Taktsignals CLK wird diese Halteschaltung durch das Signal EDG über den Inverter 230 zurückgestellt. Das Taktsignal CLK erscheint synchron zum 4MHz-Taktsignal invertiert am Q-Ausgang des Flip Flops 234 und nichtinvertiert am Ausgang des Taktsignal-Statusspeichers 116.

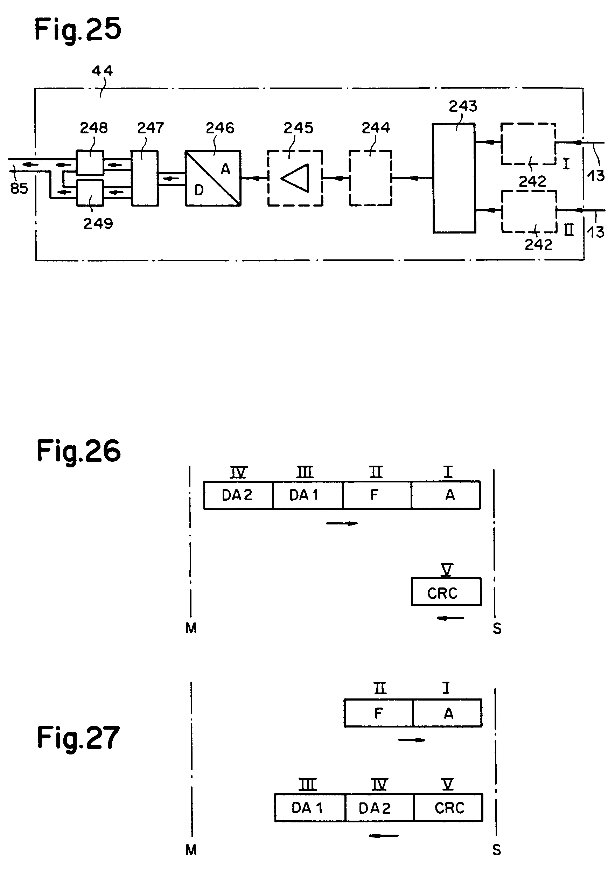

Die in der Fig. 23 dargestellte erste Variante der Ausgangsschaltung 44 besteht aus mehreren, z. B. vier "Tri-state"-Sendern 235 und ebensovielen "Tri-state"-Empfängern 236. Der Ausgangsbus 86 der Interfaceschaltung 25 ist mit den Eingängen der "Tri-state"-Empfänger 236 verbunden, deren Ausgänge mit den Eingängen der "Tri-state"-Sender 235 verbunden und gleichzeitig an den Kabelverbindungen 13 angeschlossen sind, die in der Fig. 23 als Bus dargestellt sind. Die Ausgänge der "Tri-state"-Sender 235 sind auf den Eingangsbus 85 der Interfaceschaltung 25 geführt. Die Steuereingänge der "Tri-state"-Empfänger 236 sind z. B. zwei zu zwei miteinander verbunden und an je einer der beiden Steuerleitungen 87 bzw. 88 angeschlossen.

Die der betriebstechnischen Anlage 9 zur Verfügung gestellten Daten bzw. die von ihr zur Verfügung gestellten Daten sind entweder digitale oder analoge Daten. Im ersten Fall besitzt die Ausgangsschaltung 44 des Funktionsmoduls 11 den in der Fig. 23 dargestellten Aufbau. Die digitalen Daten erreichen von der Interfaceschaltung 25 kommend über deren Ausgangsbus 86 die "Tri-state"-Empfänger 236, die beim Vorliegen eines Schreib-Zyklus durch die auf den Steuerleitungen 87 und 88 anstehenden Signale freigegeben sind und die die Datensignale verstärken, so dass diese verstärkt die Kabelverbindungen 13 und über diese die betriebstechnische Anlage 9 erreichen. Beim Vorliegen eines Lese-Zyklus erreichen die digitalen Daten von der betriebstechnischen Anlage kommend über die Kabelverbindungen 13, die immer freigegebenen "Tri-state"-Sender 235 und den Eingangsbus 85 die Interfaceschaltung 25, wo sie dann weiter verarbeitet werden.

Die in der Fig. 24 dargestellte zweite Variante der Ausgangsschaltung 44 des Funktionsmoduls 11 besteht aus einem Demultiplexer 237 und z. B. zwei Kanälen 238 und 239, wobei jeder Kanal 238 und 239 je einen Digital/Analog-Wandler 240 und je einen diesem nachgeschalteten Verstärker 241 enthält, die beide innerhalb eines jeden Kanals 238 und 239 in der angegebenen Reihenfolge in Kaskade geschaltet sind. Der Ausgangsbus 86 der Interfaceschaltung 25 ist auf den Eingang des Demultiplexers 237 geführt, dessen erster Busausgang über einen Bus mit dem Eingang des Kanals 238 verbunden ist und dessen zweiter Busausgang über einen weiteren Bus mit dem Eingang des Kanals 239 verbunden ist. Die Ausgänge der Verstärker 241 bilden je einen Ausgang der Ausgangsschaltung 44 und sind an den Kabelverbindungen 13 angeschlossen.

Sollen analoge Daten zur betriebstechnischen Anlage 9 hin übertragen werden, dann erreichen diese in digitaler Form über den Ausgangsbus 86 der Interfaceschaltung 25 den Demultiplexer 237, der nötig ist, da in der Regel mehrere analoge Parameter in der betriebstechnischen Anlage 9 vorhanden sind, deren Werte fern eingestellt werden müssen. Deshalb wird jedem dieser analogen Parameter ein Kanal 238 bzw. 239 zugeordnet und das decodierte Funktionsbyte gibt im adressierten Funktionsmodul 11 dessem Demultiplexer 237 an, welcher Kanal 238 oder 239 durch ihn anzuwählen ist. Der Demultiplexer 237 leitet dann den in digitaler Form anstehenden analogen Datenwert an den betreffenden Kanal weiter, in dessem Digital/Analog-Wandler er dann in einem echten analogen Wert umgewandelt wird, um anschliessend im Verstärker 241 verstärkt zu werden. Dieser verstärkte analoge Datenwert erreicht dann über die Kabelverbindungen 13 die betriebstechnische Anlage 9.

Die in der Fig. 25 dargestellte dritte Variante der Ausgangsschaltung 44 des Funktionsmoduls 11 besteht aus z. B. zwei Brücken oder Shunt 242, die nur fakultativ vorhanden sind, einem Multiplexer 243, einem fakultativ vorhandenen Filter 244, einem ebenfalls fakultativ vorhandenen Verstärker 245, einem Analog/Digital-Wandler 246, einem Demultiplexer 247 und zwei Schieberegistern 248 und 249. Zwei Kabelverbindungen 13, die je einen Analogwert-Kanal bilden, sind über die Brücken bzw. Shunt 242 mit je einem Eingang des Multiplexers 243 verbunden, dessen Ausgang in der angegebenen Reihenfolge über das Filter 244 und den Verstärker 245 auf den Analogeingang des Analog/Digital-Wandlers 246 geführt ist, dessen Digitalausgang wiederum über einen Bus mit dem Eingang des Demultiplexers 247 verbunden ist. Ein erster Busausgang des Demultiplexers 247 ist mit dem Paralleleingang des Schieberegisters 248 und ein zweiter Busausgang des Demultiplexers 247 mit dem Paralleleingang des Schieberegisters 249 verbunden. Die Parallelausgänge der beiden Schieberegister sind parallel geschaltet und auf den Eingangsbus 85 der Interfaceschaltung 25 geführt.

Sollen analoge Daten von der betriebstechnischen Anlage 9 zum Kontrollmodul 10 übertragen werden, dann erreichen sie in ihrem jeweiligen Kanal entweder direkt, wenn sie aktiv in Gestalt von elektrischen Spannungen vorliegen, oder über einen Shunt, wenn sie in Gestalt von elektrischen Strömen vorliegen, oder über eine Brücke, wenn sie passiv z. B. als Widerstandswerte vorliegen, einen Eingang des Multiplexers 243, der sie seinem für alle Kanäle gemeinsamen Ausgang zuleitet. Notfalls wird das Ausgangssignal des Multiplexers 243 noch im Filter 244 gefiltert und/oder im Verstärker 245 verstärkt. Der so erhaltene analoge Datenwert wird anschliessend im Analog/Digital-Wandler 246 in digitaler Form gebracht und entsprechend dem Kanal, dem er zugehört, im Demultiplexer 247 demultiplexiert und einem dem betreffenden Kanal zugeordneten Schieberegister 248 bzw. 249 zugeleitet, in dem er zwischengespeichert wird. Diese Zwischenspeicherung ist nötig, da die Analog/Digital-Umwandlung im Analog/Digital-Wandler 246 vollkommen unabhängig von der Datenübertragung erfolgt und dementsprechend asynchron ist. Aus dem Schieberegister 248 bzw. 249 werden dann die Bit des zwischengespeicherten Datenwertes im richtigen Augenblick parallel herausgelesen und über den Eingangsbus 85 der Interfaceschaltung 25 zugeleitet.

Die Datensignale DA sind binäre Datentelegramme und bestehen in einer Minimalausführung mindestens aus je einem Adressenbyte I und einem Datenbyte III. Sie können zusätzlich noch ein Funktionsbyte II und/oder ein CRC-Byte V enthalten sowie weitere Datenbyte IV. Vorzugsweise sind zwei Datenbyte III und IV in den Datensignalen DA vorhanden. In einer Maximalausführung bestehen die Datensignale DA somit vorzugsweise in der angegebenen Reihenfolge aus einem Adressenbyte I, einem Funktionsbyte II, zwei Datenbyte III und IV sowie einem CRC-Byte V. In allen Ausführungen werden in einem Schreibzyklus die drei ersten Bytearten I bis IV und in einem Lesezyklus nur die beiden ersten Bytearten I bis II von einem Kontrollmodul 10 zu den Funktionsmodulen 11 übertragen. Das CRC-Byte V wird dagegen immer und die dritte Byteart III bis IV nur im Lesezyklus in umgekehrter Richtung von einem Funktionsmodul 11 zu mindestens einem Kontrollmodul 10 übertragen.

Der in der Fig. 26 dargestellte Schreibzyklus eines Datentelegramms besteht somit vorzugsweise aus fünf Byte I bis V, wovon die vier ersten Byte I bis IV vom Kontrollmodul 10, welches als "Master" M arbeitet, zum Funktionsmodul 11 übertragen werden, welches als "Slave" S arbeitet. Erst nach Empfang dieser vier ersten Byte I bis IV sendet das Funktionsmodul 11 das fünfte Byte als CRC-Byte zum Kontrollmodul 10.

Der in der Fig. 27 dargestellte Lesezyklus eines Datentelegramms besteht dann vorzugsweise ebenfalls aus fünf Byte I bis V, wovon diesmal nur die zwei ersten Byte I und II vom Kontrollmodul 10, welches wieder als "Master" M arbeitet, zum Funktionsmodul 11 übertragen werden, welches wieder als "Slave" S arbeitet. Erst nach Empfang dieser beiden ersten Byte I und II sendet das Funktionsmodul 11 die drei letzten Byte des Telegramms zum Kontrollmodul 10.

Sowohl im Schreib- wie im Lese-Zyklus haben die fünf Byte eine gleiche Bedeutung, nämlich immer ist das erste Byte I ein Adressenbyte, das zweite Byte II ein Funktionsbyte, das dritte Byte III ein erstes Datenbyte, das vierte Byte IV ein zweites Datenbyte und das fünfte Byte V ein CRC-Byte. Dabei werden die beiden ersten Byte I und II immer vom Kontrollmodul 10 zum Funktionsmodul 11 und das fünfte Byte V immer umgekehrt vom Funktionsmodul 11 zum Kontrollmodul 10 gesendet. Die Senderichtung der beiden Datenbyte III und IV ist dagegen davon abhängig, ob ein Schreib- oder Lese-Zyklus vorliegt.

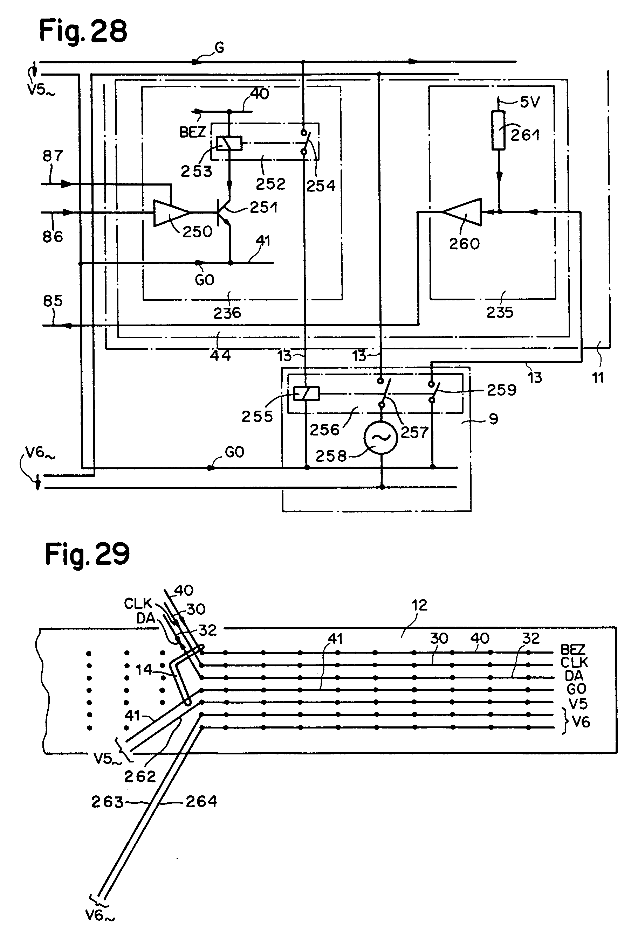

Das in der Fig. 28 dargestellte Beispiel einer Ansteuerung einer betriebstechnischen Anlage 9 beinhaltet eine Ausgangsschaltung 44 des Funktionsmoduls 11 und eine Teilschaltung der betriebstechnischen Anlage 9. In der Praxis enthält die betriebstechnische Anlage 9 natürlich eine Vielzahl von Teilschaltungen, die gleich, ähnlich oder auch verschieden von der in der Fig. 28 dargestellten Teilschaltung sind. In der Fig. 28 wurde nur eine einzige Teilschaltung dargestellt, um auf einfache Art die Arbeitsweise der Ausgangsschaltung 44 näher zu erläutern. Diese besitzt daher in der Fig. 28 eine Minimalausrüstung, nämlich einen 1Bit-Ausgang und einen 1Bit-Eingang, so dass nur ein einziger "Tri state"-Sender 235 und ein einziger "Tri state"-Empfänger 236 vorhanden ist. Der "Tri state"-Empfänger 236 besteht z. B. aus einem käuflichen CMOS-Empfangstreiber 250, einem Transistor 251, der z. B. ein bipolarer NPN-Transistor ist, und einem Relais 252, welches eine Relaisspule 253 und einen Relaiskontakt 254 aufweist. Der Relaiskontakt 254 ist z. B. ein Schliesskontakt. Der Ausgangsbus 86 der Interfaceschaltung 25 besteht in der Fig. 28 nur aus einem einzigen Busleiter 86, der auf den Eingang des CMOS-Empfangstreibers 250 geführt ist, dessen Steuereingang z. B. an der Steuerleitung 87 angeschlossen und dessen Ausgang mit der Basis des Transistors 251 verbunden ist. Wenn der CMOS-Empfangstreiber 250 einen "Open collector"-Ausgang besitzt, dann ist der Transistor 251 natürlich überflüssig, da er bereits im CMOS-Empfangstreiber 250 enthalten ist. In diesem Fall kann der Ausgang des CMOS-Empfangstreibers 250 direkt an der Spule 253 angeschlossen werden. Der Emitter des Transistors 251 ist auf den Leiter 41 geführt, d. h. mit der Systemmasse GO verbunden. Der Kollektor des Transistors 251 ist über die Relaisspule 253 mit dem Leiter 40 verbunden, d. h. mit dem Potential BEZ. In der Praxis werden in der Anlage auch eine Wechselspannung V5 und/oder V6 benötigt zur Speisung von Antrieben und anderen Leistungsverbrauchern. Diese Wechselspannungen V5 und V6 werden vorzugsweise über die Funktionsmodule 11 verschlauft. Die Wechselspannung V5 besitzt vorzugsweise einen Wert von 24 Volt und die Wechselspannung V6 einen Wert von 220 Volt in Europa bzw. 110 Volt in den USA. Ein Pol der Wechselspannung V5 ist mit dem Leiter 41 und damit mit der Systemmasse GO verbunden. Die Wechselspannung V5 speist z.B. über den Relaiskontakt 254 eine Spule 255 eines Schützen 256 der betriebstechnischen Anlage 9, dessen Starkstromkontakt 257 z. B. einen Einphasenmotor 258 ein- oder ausschaltet, der seinerseits z. B. eine Pumpe oder ein Mischventil antreibt. Um dies zu erreichen, speist die Wechselspannung V6 über den Starkstromkontakt 257 den Einphasenmotor 258. Der Schütz 256 besitzt noch einen Hilfskontakt 259, dessen Position über den "Tri state"-Sender 235 des Funktionsmoduls 11 und den Eingangsbus 85 der Interfaceschaltung 25 zum Kontrollmodul 10 zurückgemeldet wird. In der Darstellung der Fig. 28 besitzt die Ausgangsschaltung 44 des Funktionsmoduls 11 nur einen einzigen "Tri state"-Sender 235 sowie der Eingangsbus 85 der Interfaceschaltung 25 nur einen einzigen Busleiter 85. Der "Tri state"-Sender 235 besteht z. B. aus einem käuflichen CMOS-Sendetreiber 260 und einem Widerstand 261. Die Systemmasse GO ist über den Hilfskontakt 259 des Schützes 256 mit einem Eingang des CMOS-Sendetreibers 260 und mit einem ersten Pol des Widerstandes 261 verbunden, dessen zweiter Pol mit dem positiven Pol der Speisespannung 5 Volt des Funktionsmoduls 11 verbunden ist. Der Ausgang des CMOS-Sendetreibers 260 ist auf den einzigen Busleiter 85 des Eingangsbusses 85 der Interfaceschaltung 25 geführt.

In der in der Fig. 28 dargestellten Schaltung erhält die betriebstechnische Anlage 9 einen digitalen 1Bit-Datenwert vom Kontrollmodul 10 über den CMOS-Empfangstreiber 250, den Transistor 251 und das Relais 252 zugesandt, wobei der Relaiskontakt 254 des letzten mit Hilfe der Wechselspannung V5 die Spule 255 des Schützes 256 ein- oder ausschaltet, je nachdem ob ein Logikwert "1" oder "0" vom Kontrollmodul 10 ausgesandt wurde. Der Starkstromkontakt 257 des Schützes 256 schaltet dann mit Hilfe der Wechselspannung V6 den Einphasenmotor 258 ein oder aus. Die Ein- oder Ausposition des Schützes 256 wird anschliessend mit Hilfe von dessem Hilfskontakt 259 über den CMOS-Sendetreiber 260 des Funktionsmoduls 11 an das Kontrollmodul 10 zurückgemeldet. Es ist zu beachten, dass die Schaltströme der Spule 255 des Schützes 256 über die Systemmasse GO fliessen und in diese nicht vernachlässigbare ohmsche und/oder induktive Spannungsabfälle verursachen können, die die Telegrammübertragung stören würden, wenn die Spannungen von deren Übertragungssignalen DA und CLK auf die Systemmasse GO bezogen würden. Dies wird, wie bereits erwähnt, dadurch vermieden, dass diese Spannungen auf das Potential BEZ des Leiters 40 und nicht auf das Potential GO des Leiters 41 bezogen werden (siehe Fig. 5).

Wenn Versorgungswechselspannungen V5 und/oder V6 mit übertragen werden müssen, besitzt mindestens die Busschiene 12 noch einen oder mehrere weitere Leiter, die über das Speisemodul 15 mit weiteren Leitern einer oder mehrerer Kabelverbindungen elektrisch verbunden sind.

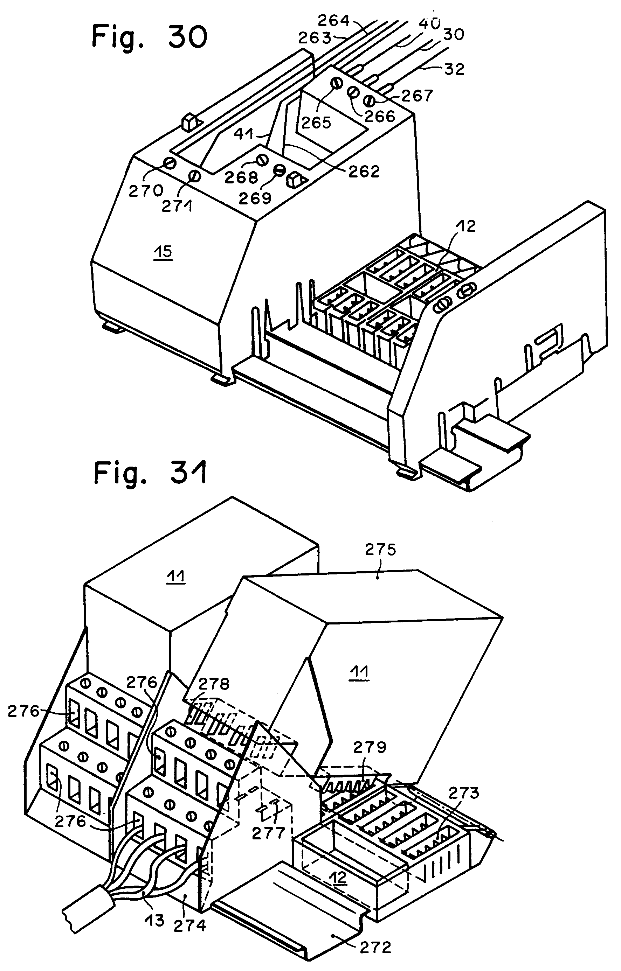

Die Fig. 29 zeigt eine symbolische Darstellung einer erweiterten Busschiene 12, welche sieben parallel geführte elektrische Leiter aufweist, mit ihren Spannungs- und Signalanschlüssen. Die Kabel-Busverbindung 14 besteht, wie bereits erwähnt, aus den vier Leitern 30, 32, 40 und 41,an denen die Signale bzw. Potentiale BEZ, CLK, DA und GO anstehen, wobei der Leiter 41, der die Systemmasse darstellt, getrennt geführt sein kann. Die drei Leiter 40, 30 und 32 bilden z. B. ein Flachkabel und sind, in der Darstellung der Fig. 29, mit den drei obersten Leitern der Busschiene 12 verbunden, während der Leiter 41 mit dem vierten Leiter von oben der Busschiene 12 verbunden ist. Da ein Pol der Versorgungswechselspannung V5 mit dem Leiter 41 verbunden ist, wird zwecks Übertragung der Versorgungswechselspannung V5 der andere Pol der Versorgungswechselspannung V5 vorzugsweise über einen Leiter 262 einer Kabelverbindung und das Speisemodul 15 einem Leiter der Busschiene 12 zugeführt, wobei der Leiter 262 räumlich gleich geführt ist wie der Leiter 41, der mit dem Potential GO verbunden ist. Der Leiter 262 ist in der Darstellung der Fig. 29 mit dem fünften Leiter von oben der Busschiene 12 verbunden, während gegebenenfalls zwei von der Wechselspannung V6 gespeisten Leiter 263 und 264 einer Kabelverbindung über das Speisemodul 15 an zwei weiteren Leitern, nämlich an den beiden untersten Leitern der Busschiene 12 angeschlossen sind zwecks Übertragung der Wechselspannung V6.

Ein Kontrollmodul 10 ist an beliebiger Stelle mit mindestens einer der vorhandenen Busschienen 12 elektrisch verbunden, wobei der Anschluss mindestens einer der in der Busverbindug 12; 14 enthaltenen Kabel-Busverbindungen 14 sowie der Leiter 262, 263 und 264 an die Busschiene 12 vorzugsweise mit Hilfe des Speisemoduls 15 erfolgt (siehe Fig. 2). Dieses besitzt vorzugsweise einen ähnlichen Aufbau, wie derjenige, der in der Fig. 30 dargestellt ist. Das Speisemodul 15 besitzt dann eine Gestalt und Abmessung ähnlich den Funktionsmodulen 11. Es ist in der Darstellung der Fig. 30 auf seiner Unterseite mit Steckerteilen versehen, so dass es elektrisch auf die Busschiene 12 steckbar ist und elektrische Verbindungen herstellt zwischen sieben Anschlussklemmen 265 bis 271, die z. B. auf der Oberseite des Speisemoduls 15 angeordnet sind, und je einem der sieben parallelen Leiter der Busschiene 12. Die drei Anschlussklemmen 265, 266 und 267 der Leiter 40, 30 und 32 sind räumlich neben- und beieinander in der Darstellung der Fig. 30 hinten auf der Oberseite des Speisemoduls 15 als Schraubverbindung angeornet. Die zwei Anschlussklemmen 268 und 269 der Leiter 41 und 262 sind räumlich neben- und beieinander in der Darstellung der Fig. 30 in der Mitte auf der Oberseite des Speisemoduls 15 als Schraubverbindung angeornet. Die zwei Anschlussklemmen 270 und 271 der Leiter 263 und 264 sind räumlich neben- und beieinander in der Darstellung der Fig. 30 vorne auf der Oberseite des Speisemoduls 15 als Schraubverbindung angeornet.

In der Fig. 31 ist der räumliche Aufbau zweier Funktionsmodule 11 und der Busschiene 12 dargestellt, wobei eines der beiden Funktionsmodule 11 teilweise halb aus der Busschiene 12 herausgezogen dargestellt ist. Die Busschiene 12 besteht unter anderem aus einer Schiene 272 sowie aus räumlich parallel angeordneten mehrpoligen, z. B. siebenpoligen, Steckerteilen 273, die alle mechanisch miteinander verbunden sind. Das Funktionsmodul 11 besteht aus einem Klemmenblock 274 und einem Elektronikblock 275. Der Klemmenblock 274 ist auf die Schiene 272 geschoben und besitzt einerseits Anschlüsse 276, die vorzugsweise Schraubanschlüsse sind, für die Kabelverbindungen 13 und anderseits z. B. weibliche Steckerteile 277 zum Einstecken des zugehörigen Elektronikblocks 275. Dieser besitzt dann seinerseits erste männliche Steckerteile 278 zum Einstecken des Klemmenblocks 274 und z. B. weibliche zweite Steckerteile 279 zum Einstecken des Elektronikblocks 275 in die Steckerteile 273 der Busschiene 12. In der Darstellung der Fig. 31 sind die Anschlüsse 276 auf der Vorderseite und die Steckerteile 277 auf einer Oberseite jeweils der Klemmenblöcke 274 angeordnet. In der gleichen Darstellung sind die Steckerteile 278 vorne und die Steckerteile 279 hinten auf einer Unterseite der Elektronikblöcke 275 angeordnet. Die Steckerteile 273, 277, 278 und 279 sind alle räumlich so angeordnet, dass jeder Elektronikblock 275 annähernd gleichzeitig aus dem zugehörigen Klemmenblock 274 und der Busschiene 12 herausgezogen werden kann, ohne dass der Klemmenblock 274 abmontiert oder die Kabelverbindungen 13 gelöst werden müssen. Ein Austausch der Elektronikblöcke 275 ist somit jederzeit ohne grosse Demontage- und Montagearbeiten möglich durch ein einfaches Herausnehmen des alten Elektronikblockes 275 und ein Hineinstecken eines neuen Elektronikblockes 275. Um ein Umstecken der Funktionsmodule 11 unter Betriebsspannung zu ermöglichen, muss der räumliche und mechanische Aufbau derselben derartig sein, dass beim Einstecken der Funktionsmodule 11 die Leiter der Busverbindung 12; 14 in folgender Reihenfolge kontaktiert werden: 262 (V5), 41 (GO), 40 (BEZ), 32 (DA) und 30 (CLK).

In einer in der Fig. 32 dargestellen konventionellen Anordnung sind die z. B. in einem Anlagenschrank 280 räumlich verteilt angeordneten Kontrollmodule 10 und Funktionsmodule 11 elektrisch miteinander verbunden und bilden zusammen einen Geräteblock 10; 11, dessen Ausgangs- und Eingangsklemmen in der Fig. 32 mit 281 bezeichnet sind. Diese Ausgangs- und Eingangsklemmen 281 des Geräteblockes 10; 11 sind Klemme für Klemme über je eine Drahtverbindung 282 mit je einer zugehörigen Klemme 283 einer ersten Klemmenleiste 284 elektrisch verbunden. Zu jeder Klemme 283 der ersten Klemmenleiste 284 gehört je eine mit ihr elektrisch verbundene Klemme 285 einer zweiten Klemmenleiste 286. In der Fig. 32 wurden aus Gründen der zeichnerischen Einfachheit die elektrischen Verbindungen zwischen den Klemmen 283 und 285 nicht dargestellt. Die beiden Klemmenleisten 284 und 286 sind nahe beieinander und räumlich parallel zueinander an einem äusseren Rand der Geräteanordnung, z. B. unten, im Anlagenschrank 280 angordnet. Alle ausserhalb des Anlagenschrankes 280 befindlichen Spannungsquellen und Geräte der betriebstechnischen Anlage 9 sind über die Kabelverbindungen 13 direkt mit den Klemmen 285 der zweiten Klemmenleiste 286 elektrisch verbunden, so dass diese Geräte und Spannungsquellen nur über die Klemmen 285 und 283 der beiden Klemmenleisten 284 und 285 mit dem Geräteblock 10; 11 verbunden sind. In der Praxis bilden die beiden Klemmenleisten 284 und 286 in der Regel zusammen eine einzige Klemmenleiste, die mit zwei Reihen Klemmen 283 bzw. 285 versehen ist.

In der in der Fig. 33 dargestellten erfindungsgemässen Anordnung ist im Anlagenschrank 280 ein Kontrollmodul 10 über eine Kabel-Busverbindung 14 mit den Funktionsmodulen 11 verbunden, die z. B. alle nebeneinander auf eine Busschiene 12 angeordnet sind. Jedes Funktionsmodul 11 besitzt Anschlüsse 276, die über Kabelverbindungen 13 unmittelbar mit Spannungsquellen und Geräten der betriebstechnischen Anlage 9 verbunden sind. Da die Funktionsmodule 11 mechanisch annähernd alle gleich sind, bilden die Anschlüsse 276 eine annähernd geradlinige Reihe von Anschlüssen, die die Rolle der zweiten Klemmenleiste 286 der in der Fig. 32 dargestellten Anordnung übernimmt mit dem Vorteil, dass jetzt pro Kabelverbindung 13 nur mehr ein Anschluss 276 vorhanden ist, statt drei Klemmen 281, 283 und 285. Ausserdem werden die vielen Drahtverbindungen 282 sowie alle in der in der Fig. 32 dargestellten Anordnung vorhandenen elektrischen Verbindungen zwischen den Kontrollmodulen 10 und den Funktionsmodulen 11 durch eine einzige Busverbindung 12; 14 ersetzt, welche höchstens sieben Leiter 40, 30, 32, 41, 262, 263 und 264 aufweist (siehe Fig. 29). Die erfindungsgemässe Anordnung gemäss der Fig. 33 führt somit zu einer grossen Ersparnis im Klemmen-, Verdrahtungs- und Montageaufwand.

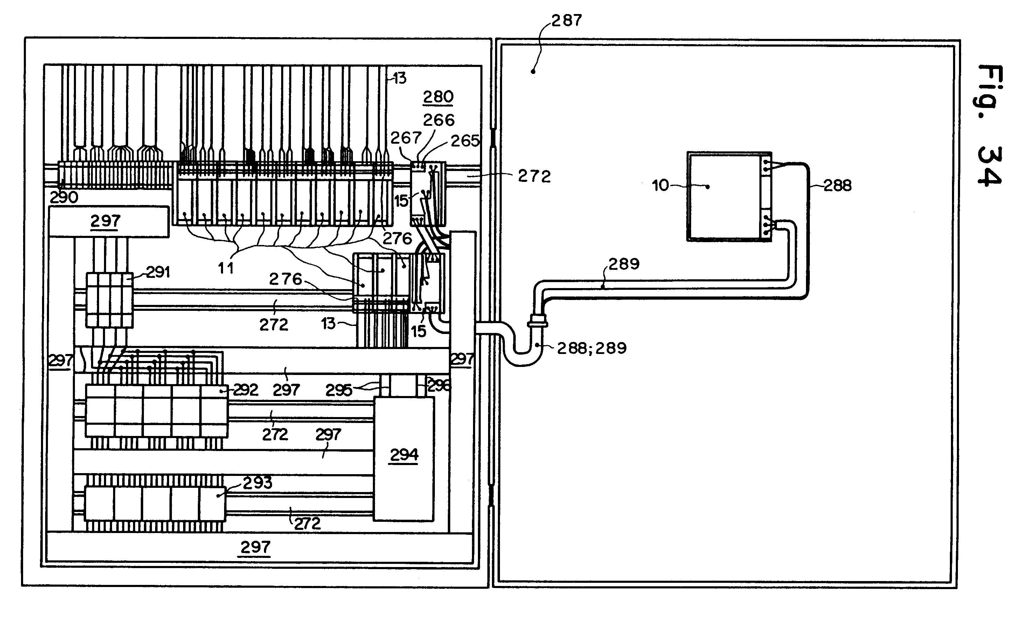

In der Fig. 34 ist ein geöffneter Anlagenschrank 280 einer erfindungsgemässen Anordnung dargestellt, wobei die von hinten gesehene geöffnete Schranktür 287 des Anlagenschrankes 280 sich in der Darstellung der Zeichnung rechts befindet. Auf der Schranktür 287 ist ein Kontrollmodul 10 angeordnet, welches über einen schwanenhalsförmigen Kabelbaum 288; 289 mit den Geräten im Innern des Anlagenschrankes 280 verbunden ist. Der Kabelbaum 288; 289 besteht vorzugsweise aus einem zweiadrigen Kabel 288 und einen dreiadrigen Kabel 289.

Im Innern des Anlagenschrankes 280 sind z. B. vier Schienen 272 horizontal parallel angeordnet. Auf der obersten Schiene 272 sind eine Vielzahl von Klemmen 290, z. B. elf Funktionsmodule 11 und ein Speisemodul 15 montiert, auf der zweiten Schiene 272 von oben z. B. vier Sicherungen 291 und drei Funktionsmodule 11 angeordnet und auf der zweiten Schiene 272 von unten z. B. fünf Motorschutzschalter 292 montiert. Die untere Schiene 272 weist z. B. fünf Schütze 293 auf, während ein Transformator 294 in der unteren rechten Ecke des Anlagenschrankes 280 angeordnet ist. Die fünf ersten Klemmen 290 von links liegen z. B. an die vier Leiter eines Dreiphasen-Versorgungsnetzes bzw. an einer Schutzerde, während über die restlichen Klemmen 290 die Geräte der betriebstechnischen Anlage 9, d. h. z. B. Ventilator- und/oder Pumpenmotoren, vom Anlagenschrank 280 her mit Starkstrom gespeist werden. Diese zuletzt genannten Klemmen 290 werden zu diesem Zweck von der Dreiphasenspannung des Dreiphasen-Versorgungsnetzes über die Sicherungen 291, die Motorschutzschalter 292 und die Schützen 293 mit elektrischem Strom gespeist. Der Transformator 294 wird über zwei Drähte 295 mit einer von der Dreiphasenspannung abgeleiteten Versorgungswechselspannung V6 von z. B. 220 Volt gespeist. Der Transformator 294 wandelt diese Versorgungswechselspannung V6 um in eine Versorgungswechselspannung V5 von z. B. 24 Volt, die über zwei Drähte 296 den Transformator 294 verlässt. Den beiden oberen Schienen 272 ist je eine nichtdargestellte Busschiene 12 zugeordnet, die jeweils über das zugeordnete Speisemodul 15 gespeist wird. Die vier Drähte 295 und 296 sowie die drei Adern des Kabels 289 sind im Schaltschrank 280 jeweils über eines der beiden Speisemodule 15 mit einem der Leiter 263, 264, 262, 41, 40, 30 bzw. 32 der beiden nichtdargestellten Busschienen 12 verbunden (siehe Fig. 29). Die beiden Drähte 296 sind ausserdem noch unmittelbar auf die beiden Adern des Kabels 288 geführt. In der Fig. 34 sind Kabelkanäle mit 297 bezeichnet. Die Anschlüsse 276 der Funktionsmodule 11 sind mit den Kabelverbindungen 13 versehen, die alle oder teilweise in den Kabelkanälen 297 verlegt sind und dem unmittelbaren Anschluss der nicht mehr dargestellten betriebstechnischen Anlage 9 dienen.

Im Unterschied zu dem in der Fig. 30 dargestellten Speisemodul 15 besitzen die beiden in der Fig. 34 dargestellten Speisemodule 15 jeweils die Anschlussklemmen 265 bis 267 (siehe Fig. 30) in doppelter Ausführung, einmal oben und einmal unten am Speisemodul 15 angeordnet, wobei diese Anschlussklemmen jeweils zwei zu zwei elektrisch miteinander verbunden sind. Diese doppelte Ausführung der Anschlussklemmen 265 bis 267 hat den Vorteil, dass die Speisung der Leiter 40, 30 und 32 der verschiedenen Busschienen 12 im Anlagenschrank einfacher zu realisieren ist.

In der Regel ist somit immer auf einer der Busschienen 12 mindestens eines der Funktionsmodule 11 vorhanden. Diese Busschiene 12 ist dabei an der elektrischen Peripherie der Anordnung derart angeordnet und mindestens dieses oder eines dieser Funktionsmodule 11 sowie elektrische Anschlüsse 276 desselben sind dabei derart angeordnet, dimensioniert und ausgebildet, dass mindestens dieses Funktionsmodul 11 zugleich eine Eingangs- und/oder Ausgangsklemme der Anordnung ist, so dass diese elektrische Anschlüsse 276 des Funktionsmoduls 11 unmittelbar mit Anschlussklemmen der betriebstechnischen Anlage 9 verbunden werden können. Zwecks Erreichen einer möglichst universellen Lösung ist das Funktionsmodul 11 dabei nur vorzugsweise zur Behandlung von höchstens zwei Prozessgrössen ausgebildet. Das Funktionsmodul 11 ist vorzugsweise über Steckerteile 273 und 279 an seiner Busschiene 12 angeschlossen, wobei das Funktionsmodul 11 sowohl mechanisch als auch elektrisch individuell beliebig in einer jeden der vielen vorhandenen Positionen auf einer beliebigen der vorhandenen Busschienen 12 steckbar ist, ohne dass dazu zur Gewährleistung einer korrekten Arbeitsweise der Anordnung Hardware- oder Software-Änderungen erforderlich sind.

In diesem sehr universellen erfindungsgemässen ZLT-Gebäudeautomationssystem ist der Verdrahtungs-, Klemmen-, Verbindungsstellen- und Montageaufwand innerhalb des Anlagenschrankes auf ein Minimum reduziert worden und eine aufwendige Rangierverdrahtung fällt weg, da die Anschlüsse der betriebstechnischen Anlage nicht an Klemmen 283; 285, sondern direkt an den Anschlüssen 276 der Funktionsmodule 11 angeschlossen sind. Dadurch wird eine grosse Kosten- und Zeitersparnis realisiert. Da die Funktionsmodule 11 ohne Rücksicht auf die eigene Funktionsmodulart und ohne Rücksicht auf die früher einmal am gleichen Ort gesteckte Funktionsmodulart an beliebigen Orten auf einer Busschiene steckbar sind, ist eine optimale Flexibilität der Anordnung hinsichtlich Änderungen und Ausbau des Systems durch eine vollkommen freie Austauschbarkeit der Funktionsmodule 11 gewährleistet. Durch Verwendung des Potentials BEZ statt des Potentials GO als gemeinsames Bezugspotential für die Übertragungssignale DA und CLK entsteht eine Verminderung der Störanfälligkeit der Anordnung, da eine weniger störanfällige Übertragungsverbindung zwischen Kontrollmodule 10 und Funktionsmodule 11 vorhanden ist. Durch die Minimierung der Anzahl Leiter in der Busschiene 12 auf vier bis sieben Leitern und durch Verwendung einer optimal dünnen Kabel-Busverbindung 14 zwischen der Busschiene 12 und den Kontrollmodulen 10, können letztere statt auf der Busschiene 12 auf die Tür des Anlagenschrankes oder Schaltkastens angeordnet sein. Dadurch sind die Bedien- und Anzeigeelemente der Kontrollmodule 10 direkt von aussen zugänglich, ohne dass vorher diese Tür geöffnet werden muss. Da die Inbetriebsetzung und das Austesten der Anlage hinsichtlich des Vorhandenseins von Verdrahtungsfehlern dank Vorhandensein vorallem der Busverbindung 12; 14 stark vereinfacht ist, ist eine Reduktion der Anzahl Fehlerquellen zu erwarten. Aus dem gleichen Grund ist der Projektierungsaufwand bei der Aufstellung von Stromlaufplänen, Drahtzugslisten usw. stark vereinfacht. Weitere Vorteile sind eine hohe Installations- und Service-Freundlichkeit, ein geringer Platzbedarf der Anordnung mit hohem Ausnützungsgrad sowie die Verringerung der Anzahl der im Feld konfektionierten Kabelbäume. Da die Umwandlung der Analogwerten in Digitalwerten bereits in den Funktionsmodulen 11 erfolgt, geschieht diese in Sekundenschnelle unter gleichzeitiger Entlastung des zentralseitigen Computers von zeitaufwendigen Umwandlungsarbeiten.

Alle erwähnten nicht direkten Zubehör-Bauelemente des Mikrocomputers 50 werden vorzugsweise in CMOS-Technologie hergestellt und können entweder als kundenspezifischen Schaltungen oder aus käuflichen Bauelementen der CMOS-Reihen 14000 und 14500 realisiert werden, wie sie z. B. durch die Firma Motorola Semiconductor Products Inc., 5005E Mc Dowell Road M370, Phoenix, AZ 85008, angeboten werden und in deren Datenbuch "The european CMOS Selection", 1979, beschrieben sind.

**Patentansprüche**

1. Anordnung zur Überwachung, Steuerung und Regelung einer betriebstechnischen Anlage (9) eines Gebäudeautomationssystems mit mindestens einem als Master-Sender-Empfänger arbeitenden bedienseitigen Kontrollmodul (10) und mindestens einem als Slave-Sender-Empfänger arbeitenden Funktionsmodul (11), die über eine mindestens eine Busschiene (12) enthaltende Busverbindung (12; 14) elektrisch miteinander verbunden sind zwecks Übertragung von Adressen, Daten und Versorgungsspannungen, wobei auf der bzw. einer der Busschienen (12) mindestens ein Funktionsmodul (11) angeordnet ist, welches einerseits mit Leitern dieser Busschiene (12) und anderseits zwecks Übertragung von Prozessgrössen mit Steuer- und/oder Meldeeinrichtungen der betriebstechnischen Anlage (9) elektrisch verbunden ist, dadurch gekennzeichnet, dass diese Busschiene (12) derart an der elektrischen Peripherie der Anordnung angeordnet ist und dass mindestens dieses bzw. eines dieser Funktionsmodule (11) sowie elektrische Anschlüsse (276) desselben derart angeordnet, dimensioniert und ausgebildet sind, dass das Funktionsmodul (11) zugleich Eingangs- und/oder Ausgangsklemme der Anordnung ist, so dass diese elektrischen Anschlüsse (276) des Funktionsmoduls (11) unmittelbar mit Anschlussklemmen der betriebstechnischen Anlage (9) verbunden werden können, und dass das Kontrollmodul (10) räumlich getrennt und entfernt von den Busschienen (12) und den Funktionsmodulen (11) angeordnet ist.

2. Anordnung nach Anspruch 1, dadurch gekennzeichnet, dass das Funktionsmodul (11) über Steckerteile (273, 279) an diese Busschiene (12) angeschlossen ist und dass die Funktionsmodule (11) mechanisch annähernd alle gleich sind und ihnen je eine positionsunabhängige Adresse zugeordnet ist, so dass das Funktionsmodul (11) sowohl mechanisch als auch elektrisch individuell beliebig in einer jeden der vielen vorhandenen Positionen auf einer der Busschienen (12) steckbar ist, ohne dass dazu zur Gewährleistung einer korrekten Arbeitsweise der Anordnung Hardware- oder Software-Änderungen erforderlich sind.

3. Anordnung nach Anspruch 1 oder 2, dadurch gekennzeichnet, dass das Funktionsmodul (11) zur Behandlung von höchstens zwei Prozessgrössen ausgebildet ist.

4. Anordnung nach einem der Ansprüche 1 bis 3, dadurch gekennzeichnet, dass ein bzw. eines der Kontrollmodule (10) von allen Busschienen (12) entfernt angeordnet ist und die Busverbindung (12; 14) mindestens eine Kabel-Busverbindung (14) enthält, durch welche dieses Kontrollmodul (10) an beliebiger Stelle mit mindestens einer der Busschienen (12) elektrisch verbunden ist.

5. Anordnung nach Anspruch 4, dadurch gekennzeichnet, dass ein Speisemodul (15) vorhanden ist, welches elektrisch auf eine der Busschienen (12) steckbar ist zum elektrischen Anschluss der Kabel-Busverbindung (14) an die Busschiene (12).

6. Anordnung nach einem der Ansprüche 1 bis 5, dadurch gekennzeichnet, dass innerhalb der Busverbindung (12; 14) ein einziger Bus vorhanden ist zur Übertragung von Datensignalen (DA), welche sowohl die zu übertragenden Daten als auch diese Adresse enthalten.

7. Anordnung nach Anspruch 6, dadurch gekennzeichnet, dass die Adresse am Funktionsmodul (11) beliebig einstellbar ist.

8. Anordnung nach Ansprch 6 oder 7, dadurch gekennzeichnet, dass der Bus zur Übertragung der Datensignale (DA) aus einem einzigen Leiter (32) besteht, die Datensignale (DA) binäre Datentelegramme sind und die Übertragung der Adressen und Daten zeitseriell ist.

9. Anordnung nach Anspruch 8, dadurch gekennzeichnet, dass die Datensignale (DA) mindestens aus je einem Adressenbyte (I) und Datenbyte (III, IV) bestehen, wobei in einem Schreibzyklus alle Bytearten (I, III, IV) und in einem Lesezyklus nur jedes Adressenbyte (I) jeweils von dem bzw. einem der Kontrollmodule (10) zum Funktionsmodul (11) übertragen werden, während jedes Datenbyte (III, IV) im Lesezyklus in umgekehrter Richtung vom Funktionsmodul (11) zum Kontrollmodul (10) übertragen wird.

10. Anordnung nach Anspruch 8, dadurch gekennzeichnet, dass die Datensignale (DA) mindestens aus einem Adressenbyte (I), Funktionsbyte (II) und Datenbyte (III, IV) bestehen, wobei in einem Schreibzyklus alle Bytearten (I bis IV) und in einem Lesezyklus die beiden ersten Bytearten (I, II) jeweils von dem bzw. einem der Kontrollmodule (10) zum Funktionsmodul (11) übertragen werden, während jedes Datenbyte (III, IV) im Lesezyklus in umgekehrter Richtung vom Funktionsmodul (11) zum Kontrollmodul (10) übertragen wird.

11. Anordnung nach Anspruch 8, dadurch gekennzeichnet, dass die Datensignale (DA) mindestens aus einem Adressenbyte (I), Datenbyte (III, IV) und CRC-Byte (V) bestehen, wobei in einem Schreibzyklus die beiden ersten Bytearten (I, III, IV) und in einem Lesezyklus jedes Adressenbyte (I) jeweils von dem bzw. einem der Kontrollmodule (10) zum Funktionsmodul (11) übertragen werden, während jedes CRC-Byte (V) immer und jedes Datenbyte (III, IV) im Lesezyklus in umgekehrter Richtung vom Funktionsmodul (11) zum Kontrollmodul (10) übertragen werden.

12. Anordnung nach Anspruch 8, dadurch gekennzeichnet, dass die Datensignale (DA) mindestens aus einem Adressenbyte (I), Funktionsbyte (II), Datenbyte (III, IV) und CRC-Byte (V) bestehen, wobei in einem Schreibzyklus die drei ersten Bytearten (I bis IV) und in einem Lesezyklus die beiden ersten Bytearten (I bis II) jeweils von dem bzw. einem der Kontrollmodule (10) zum Funktionsmodul (11) übertragen werden, während jedes CRC-Byte (V) immer und jedes Datenbyte (III, IV) im Lesezyklus in umgekehrter Richtung vom Funktionsmodul (11) zum Kontrollmodul (10) übertragen werden.

13. Anordnung nach einem der Ansprüche 9 bis 12, dadurch gekennzeichnet, dass jeweils zwei Datenbyte (III und IV) in den Datensignalen (DA) vorhanden sind.

14. Anordnung nach einem der Ansprüche 1 bis 13, dadurch gekennzeichnet, dass ein weiterer Leiter (30) zur Übertragung eines Taktsignals (CLK) in der Busverbindung (12; 14) vorhanden ist.

15. Anordnung nach einem der Ansprüche 1 bis 14 mit einem gemeinsamen Potential (GO), auf das die Spannungen des Gesamtsystems, des bzw. der Kontrollmodule (10) und der Geräte der betriebstechnischen Anlage (9) bezogen sind, wobei mindestens ein erster Leiter (41) eines in der Busverbindung (12; 14) enthaltenen und der Übertragung einer Versorgungsgleichspannung (V1) dienenden Leiterpaares (40; 41) an diesem gemeinsamen Potential (GO) liegt, dadurch gekennzeichnet, dass bei der Übertragung über die Busverbindung (12; 14) Spannungen von übertragenen Signalen (DA, CLK) statt auf das Potential (GO) des ersten Leiters (41) auf das Potential (BEZ) des zweiten Leiters (40) des Leiterpaares (40; 41) bezogen sind.

16. Anordnung nach Anspruch 15 mit mindestens einer Pegelanpass-Schaltung (20) pro Kontrollmodul (10), wobei jede Pegelanpass-Schaltung (20) mindestens eine Sendeschaltung (23) enthält, dadurch gekennzeichnet, dass zur Speisung aller Sendeschaltungen (23) einer Pegelanpass-Schaltung (20) pro Pegelanpass-Schaltung (20) eine Gleichspannungsquelle (39) vorhanden ist, deren erster Pol mit dem zweiten Leiter (40) des Leiterpaares (40; 41) und deren zweiter Pol mit je einem Speisepol aller Sendeschaltungen (23) verbunden ist.

17. Anordnung nach Anspruch 15 oder 16, dadurch gekennzeichnet, dass mindestens eine der Busschienen (12) einen weiteren Leiter aufweist zur Übertragung einer Versorgungswechselspannung (V5), wobei ein Pol der Versorgungswechselspannung (V5) mit dem ersten Leiter (41) des Leiterpaares (40; 41) verbunden ist, und dass dieser weitere Leiter der Busschiene (12) über ein Speisemodul (15) mit einem Leiter (262) einer Kabelverbindung elektrisch verbunden ist.

18. Anordnung nach einem der Ansprüche 15 bis 17, dadurch gekennzeichnet, dass mindestens eine der Busschienen (12) zwei weitere Leiter aufweist zur Übertragung einer zusätzlichen Versorgungswechselspannung (V6) und dass diese beiden weiteren Leiter der Busschiene (12) über ein Speisemodul (15) mit je einem Leiter (263, 264) einer Kabelverbindung elektrisch verbunden sind.

19. Anordnung nach einem der Ansprüche 1 bis 18 mit einem Mikrocomputer (50), dadurch gekennzeichnet, dass in dem bzw. in einem der Kontrollmodule (10) ein vom Mikrocomputer (50) gesteuerter digitaler Funktionsblock vorhanden ist, der beim Vorhandensein mehrerer Funktionsmodule (11) den übertragungsmässigen Anschluss derselben an die Busverbindung (12; 14) verwaltet.

20. Anordnung nach Anspruch 19 mit einer Interfaceschaltung (21) und mindestens einer der Interfaceschaltung (21) nachgeschalteten Pegelanpass-Schaltung (20) im digitalen Funktionsblock und mit einer am Eingang aller Funktionsmodule (11) angeordneten Anpass-Schaltung (26), wobei alle Pegelanpass-Schaltungen (20) und Anpass-Schaltungen (26) jeweils Sende- und Empfangsschaltungen (23, 24) bzw. Sende- und Empfangseinheiten (27, 28) enthalten, dadurch gekennzeichnet, dass die Pegelanpass-Schaltungen (20) jeweils aus zwei Sendeschaltungen (23), eine für ein Taktsignal (CLK) und eine für Datensignale (DA), und einer Empfangsschaltung (24) für die Datensignale (DA) bestehen und dass die Anpass-Schaltungen (26) jeweils aus einer Sendeeinheit (27) für die Datensignale (DA) und zwei Empfangseinheiten (28) bestehen, eine für das Taktsignal (CLK) und eine für die Datensignale (DA).

**21.** Anordnung nach Anspruch 19 oder 20, dadurch gekennzeichnet, dass der Mikrocomputer (50) über eine Busverbindung (55) mit einem Adressenspeicher (52) und einem bidirektionellen Datentreiber (53) verbunden ist, dass ein Richtungs-Kontrollgerät (54) vorhanden ist, welches der Festlegung einer Übertragungsrichtung des bidirektionellen Datentreibers (53) dient und dessen Ausgänge auf je einen Steuereingang des bidirektionellen Datentreibers (53) geführt sind, und dass der digitale Funktionsblock ein Adressenregister (58) zum Speichern eines Adressenbytes (I), gegebenenfalls ein Funktionsregister (59) zum Speichern eines Funktionsbyte (II), wenn ein solches zu übertragen ist, mindestens ein Datenregister (60 bzw. 61) zum Speichern eines Datenbytes (III, IV), ein Statusregister (62) zum Speichern eines Status der Anordnung, ein Kontrollgerät (62a) als Steuergerät, ein Schieberegister (63) als Parallel/Serie- bzw. Serie/Parallel-Wandler, eine Sendeeinheit (66) und ein als Empfangseinheit dienendes Und-Gatter (67) enthält, wobei alle Register (58, 59, 60, 61, 62) mit dem Adressenspeicher (52) und dem bidirektionellen Datentreiber (53) und alle Register (58, 59, 60, 61) ausser das Statusregister (62) mit einem Paralleleingang/-ausgang des Schieberegisters (63) verbunden sind, dessen serieller Ausgang über die Sendeeinheit (66) auf den Eingang einer der beiden Sendeschaltungen (23) aller Pegelanpass-Schaltungen (20) geführt ist, während der Ausgang von deren Empfangsschaltung (24) jeweils über das Und-Gatter (67) mit einem seriellen Eingang des Schieberegisters (63) verbunden ist.

**22.** Anordnung nach einem der Ansprüche 19 bis 21, dadurch gekennzeichnet, dass bei einer Übertragung eines CRC-Bytes der digitale Funktionblock einen CRC-Generator (65b) zur Auswertung des CRC-Bytes (V) enthält, wobei der Ausgang des Und-Gatters (67) mit einem Eingang und ein Ausgang der Sendeeinheit (66) mit einem anderen Eingang eines Multiplexers (65a) verbunden ist, dessen Ausgang auf einen Signaleingang des CRC-Generators (65b) geführt ist, während die Parallelausgänge des letzten mit den Eingängen eines Oder-Gatters (65c) verbunden sind, welches als Decodierer dient und dessen Ausgang auf einen Eingang des Statusregisters (62) geführt ist.

**23.** Anordnung nach einem der Ansprüche 19 bis 22, dadurch gekennzeichnet, dass der digitale Funktionsblock einen Mithör-Fehlerdetektor (64) enthält zur Auswertung der vom Kontrollmodul (10) ausgesendeten Byte, die von einem Ausgang der Sendeeinheit (66) über zwei verschiedene Wege je einen Eingang des Mithör-Fehlerdetektors (64) erreichen, wobei der Ausgang der Sendeeinheit (66) mit einem Eingang und der Ausgang der Empfangsschaltung (24) aller Pegelanpass-Schaltungen (20) mit einem anderen Eingang des Mithör-Fehlerdetektors (64) verbunden ist, dessen Ausgang auf einen Eingang des Statusregisters (62) geführt ist.

**24.** Anordnung nach einem der Ansprüche 19 bis 23, dadurch gekennzeichnet, dass im Funktionsmodul (11) der Anpass-Schaltung (26) eine Interfaceschaltung (25) nachgeschaltet ist, die einen Eingangsbus (85) aufweist, der auf einen Paralleleingang eines Schieberegisters (69) geführt ist, dessen Parallelausgang seinerseits mit je einem Buseingang eines Adressenkomparators (71), der dem Vergleich einer empfangenen Adresse mit einer in einem Adressencodierer (72) eingestellten Moduladresse dient, gegebenenfalls eines Funktionsdecodierers (73), falls ein empfangenes Funktionsbyte (II) auszuwerten ist, und einer Ausgangsstufe (74) verbunden ist, wobei der Adressencodierer (72) auf einen weiteren Buseingang des Adressenkomparators (71) geführt ist und ein Daten-Busausgang der Ausgangsstufe (74) mit einem Ausgangsbus (86) der Interfaceschaltung (25) verbunden ist, und dass ein Steuergerät (83) sowie ein Ausgangs-Freigabegatter (84) vorhanden sind, wobei ein serieller Ausgang des Schieberegisters (69) über letzteres mit dem Eingang der Sendeeinheit (27) der Anpass-Schaltung (26) und der Ausgang einer der beiden Empfangseinheiten (28) der Anpass-Schaltung (26) mit einem seriellen Eingang des Schieberegisters (69) verbunden ist.

**25.** Anordnung nach Anspruch 24, dadurch gekennzeichnet, dass in der Interfaceschaltung (25) des Funktionsmoduls (11) ein Zufallscodegenerator (77) zwecks Kontrolle einer Mehrfachbelegung von Moduladressen und ein Modulinformations-Codierer (78) zwecks Einstellung von Modulinformationen vorhanden ist und dass der Zufallscodegenerator (77), der Modulinformations-Codierer (78) und der Eingangsbus (85) an je einem Buseingang eines Bus-Multiplexers (70) angeschlossen sind, dessen Ausgang auf einen Paralleleingang des Schieberegisters (69) geführt ist.

**26.** Anordnung nach Anspruch 24 oder 25, dadurch gekennzeichnet, dass beim Vorhandensein einer CRC-Byte-Übertragung die Interfaceschaltung (25) des Funktionsmoduls (11) einen Multiplexer (81) enthält, dessen Ausgang mit einem seriellen Eingang eines CRC-Generators (80) verbunden ist, der der Erzeugung von CRC-Byte (V) dient, wobei der serielle Eingang und der serielle Ausgang des Schieberegisters (69) mit je einem Eingang des Multiplexers (81) verbunden ist, und dass ein Ausgang des CRC-Generators (80) über einen Bus (80a) an einen weiteren Buseingang des Bus-Multiplexers (70) angeschlossen ist.

27. Anordnung nach einem der Ansprüche 24 bis 26, dadurch gekennzeichnet, dass der Eingangsbus (85) der Interfaceschaltung (25) des Funktionsmoduls (11) über ein Eingangsfilter (79) an den Bus-Multiplexer (70) angeschlossen ist.

28. Anordnung nach einem der Ansprüche 24 bis 27, dadurch gekennzeichnet, dass die Interfaceschaltung (25) des Funktionsmoduls (11) einen Mithör-Fehlerdetektor (82) enthält, wobei der serielle Eingang und der serielle Ausgang des Schieberegisters (69) mit je einem Eingang des Mithör-Fehlerdetektors (82) verbunden ist.

29. Anordnung nach einem der Ansprüche 24 bis 28, dadurch gekennzeichnet, dass die Ausgangsstufe (74) der Interfaceschaltung (25) des Funktionsmoduls (11) aus einem Zwischenspeicher (75) und einem mittels eines Busses (75a) nachgeschalteten Ausgangsregister (76) besteht.

30. Anordnung nach einem der Ansprüche 2 bis 29, dadurch gekennzeichnet, dass mindestens eine der Busschienen (12) eine Schiene (272) sowie räumlich parallel angeordneten mehrpoligen Steckerteilen (273) enthält und dass das Funktionsmodul (11) aus einem Klemmenblock (274) und einem Elektronikblock (275) besteht, wobei der Klemmenblock (274) Anschlüsse (276) für Kabelverbindungen (13) und Steckerteile (277) zum Einstecken des Elektronikblocks (275) besitzt, während der Elektronikblock (275) seinerseits erste Steckerteile (278) zum Einstecken des Klemmenblocks (274) und zweite Steckerteile (279) zum Einstecken des Elektronikblocks (275) in die Steckerteile (273) der Busschiene (12) besitzt, wobei alle Steckerteile (273, 277, 278 und 279) räumlich so angeordnet sind, dass der Elektronikblock (275) annähernd gleichzeitig aus dem zugehörigen Klemmenblock (274) und der Busschiene (12) herausgezogen werden kann, ohne dass dabei der Klemmenblock (274) abmontiert oder die Kabelverbindungen (13) gelöst werden müssen.

## Claims

1. Installation for the supervision, control and regulation of a technical operating installation (9) of a building automation system with at least one control module (10) on the tending side functioning as a master transmitter-receiver and with at least one function module (11) functioning as a slave transmitter-receiver which are connected electrically to each other via a bus connection (12; 14) containing at least one bus rail (12) for the transmission of addresses, data and distribution voltages, whereby at least one function module (11) is installed on one of the bus rails (12) said function module (11) being electrically connected on the one hand to conductors of this bus rail (12) and on the other hand to control and/or message transmitting devices of the technical operating installation (9) for the transmission of process magnitudes, characterized in that this bus rail (12) is installed in such manner at the electrical periphery of the installation and in that at least this or one of these function modules (11) as well as electrical contacts (276) of same are located, sized and designed in such manner that the function module (11) is at the same time input and/or output terminal of the installation so that these electrical connections (276) of the function module (11) can be connected directly to the connection terminals of the technical operating installation (9), and in that the control module (10) is installed so that it is spatially separated and distanced from the bus rails (12) and the function modules (11).

2. Installation as in claim 1, characterized in that the function module (11) is connected via connector elements (273, 279) to this bus rail (12) and in that the function modules (11) are all approximately mechanically the same, and in that each is assigned an address independent of position, so that the function module (11) can be individually mechanically or electrically plugged in as required to any one of the many positions available on one of the bus rails (12), without the need for hardware or software alterations to ensure the proper functioning of the installation.

3. Installation as in claim 1 or 2, characterized in that the function module (11) is designed for the treatment of a maximum of two process magnitudes.

4.  Installation as in one of claims 1 to 3, characterized in that a or one of the control modules (10) is installed at a distance from all the bus rails (12) and in that the bus connection, 12; 14) contains at least one cable-bus link (14) through which this control module (10) is electrically connected at any desired location to at least one of the bus rails (12).

5.  Installation as in claim 4, characterized in that a supply module (15) is used which can be plugged in electrically on one of the bus rails (12) to establish the electrical connection between the cable-bus link (14) and the bus rail (12).

6.  Installation as in one of claims 1 to 5, characterized in that within the bus connection (12; 14) one single bus is used to transmit data signals (DA) which contain the data to be transmitted as well as this address.

7.  Installation as in claim 6, characterized in that the address can be set as desired on the function module (11).

8.  Installation as in claims 6 or 7, characterized in that the bus serving to transmit the data signals (DA) consists of one single conductor (32), in that the data signals (DA) are binary data telegrams and in that the transmission of the addresses and data is sequential.

9.  Installation as in claim 8 , characterized in that each of the data signals (DA) consists of at least one address byte (I) and data byte (III, IV), whereby all the byte types (I, III, IV) in a write cycle and only every address byte (I) in a read cycle are transmitted from the control module (10) or from one of the control modules (10) to the function module (11), while every data byte (III, IV) is transmitted in opposite direction from the function module (11) to the control module (10) in a read cycle.

10. Installation as in claim 8 , characterized in that the data signals (DA) consist at least of one address byte (I), function bytes (II) and data bytes (III, IV), whereby all byte types (I to IV) in a write cycle and the two first byte types (I, II) in a read cycle are transmitted from one or from a control module or from one of the control modules (10) to the function module (11), while every data byte (II, IV) in a read cycle is transmitted in opposite direction from the function module (11) to the control module (10).

11. Installation as in claim 8 , characterized in that the data signals (DA) consist of at least one address byte (I), data bytes (III, IV) and CRC bytes (V), whereby the first two byte types (I, III, IV) in a write cycle and each address byte (I) in a read cycle are transmitted from the control module (10) or from one of the control modules (1) to the function module (11) while each CRC byte (V) always, and each data byte (III, IV) in the read cycle is transmitted in opposite direction from the function module (11) to the control module (10).

12. Installation as in claim 8 , characterized in that the data signals (DA) consist of at least one address byte (I), of function bytes (II), data bytes (III, IV) and CRC bytes (V), whereby the first three byte types (I to VI) in a write cycle and the first two byte types (I to II) in a read cycle are each transmitted from a control module (10) or from one of the control modules (10) to the function module (11), while each CRC byte (V) always and each data byte (III, IV) in the read cycle is transmitted in opposite direction from the function module (11) to the control module (10).

13. Installation as in one of the claims 9 to 12, characterized in that two data bytes (III and IV) are present in each of the data signals (DA).

14. Installation as in one of the claims 1 to 13,characterized in that an additional conductor is available in the bus connection (12; 14) for the transmission of a clock signal (CLK).

15. Installation as in one of the claims 1 to 14 with a common potential (GO) to which the voltages of the global system, of the control module(s) (10) and of the instruments of the technical operating installation (9) are referred, whereby at least one first conductor (41) of a pair of conductors (40; 41) contained in the bus connection (12; 14) and serving to transmit a d.c. distribution voltage (V1) is connected to this common potential (GO), characterized in that voltages of transmitted signals (DA, CLK) are referred to the potential (BEZ) of the second conductor (40) of the pair of conductors (40; 41) instead of to the potential (GO) of the first conductor (41) in transmission via the bus connection (12; 14).

16. Installation as in claim 15 with at least one level adaptation circuit (20) per control module (10), whereby each level adaptation circuit (20) contains at least one transmission circuit (23), characterized that for the supply of all transmission circuits (23) of a level adaptation circuit (20) a d.c. voltage source (39) is provided per level adaptation circuit (20) the first pole of which is connected to the second conductor (40) of the pair of conductors (40; 41) and the second pole of which is connected to a supply pole of each transmission circuit (23).

17. Installation as in claim 15 or 16, characterized in that at least one of the bus rails (12) is provided with an additional conductor for the transmission of an a.c. distribution voltage (V5), whereby one pole of the a.c.distribution voltage (V5) is connected to the first conductor (41) of the pair of conductors (40; 41) and in that this additional conductor of the bus rail (12) is connected electrically via a supply module (15) to a conductor (262) of a cable connection.

18. Installation as in claim 15 to 17, characterized in that at least one of the bus rails (12) is provided with two additional conductors for the transmission of an additional a.c. distribution voltage (V6) and in that each of these two additional conductors of the bus rail (12) is electrically connected via a supply module (15) to a conductor (263, 264) of a cable connection.

19. Installation as in one of the claims 1 to 18 with a microcomputer (50), characterized in that the or one of the control modules (10) contains a digital function block controlled by the microcomputer (50) which manages the transmission connection of function modules (11) to the bus connection (12; 14) if several such function modules (11) are present.

20. Installation as in claim 19 with an interface circuit (21) and at least one level adaptation circuit (20) downstream of the interface circuit (21) in the digital function block and with an adaptation circuit (26) installed at the input of every function module (11), whereby all the level adaptation circuits (20) and adaptation circuits (26) contain transmission and reception circuits (23, 24) or transmitting and receiving units (27, 28), characterized in that each level adaptation circuit (20) consists of two transmission circuits (23), one for a clock signal (CLK) and one for data signals (DA) and of a reception circuit (24) for the data signals (DA) and in that the adaptation circuit (26) consists of a transmitting unit (27) for the data signals (DA) and of two receiving units (28), one of the clock signal and one for the data signals (DA).

21. Installation as in claim 19 or 20, characterized in that the microcomputer (50) is connected via a bus connection (55) to an address memory (52) and to a bi-directional data driver (53), in that a direction-control device (54) is provided, serving to determine a direction of transmission of the bi-directional data driver (53) and the outputs of which are each carried to a control input of the bi-directional data driver (53) and in that the digital function block contains an address register (59) to store an address byte (I), if needed a function register (50) to store a function byte (II) if one is to be transmitted, at least one data register (60 or 61) to store of a status of the installation, a verification device 62a serving as a control device, a shift register (63) serving as a parallel/serial or serial/parallel converter, a transmitting unit (66) and an AND gate (67) serving as a receiving unit, whereby all the registers (58, 59, 60, 61, 62) are connected to the address memory (52) and to the bi-directional data driver (53) and whereby all the registers (58, 59, 60, 61) with the exception of the status register (62) are connected to a parallel input/output of the shift register (63) whose serial output is carried via transmission unit (66) to the input of one of the two transmission circuits (23) of all level adaptation circuits (20) while each output of their reception circuit (24) is connected via the AND gate (67) to one serial input of the shift register 63.

22. Installation as in claims 19 to 21, characterized in that the digital function block contains a CRC generator (65b) during a transmission of a CRC byte to evaluate the CRC byte (V), whereby the output and the AND GATE (67) is connected to one input and an output of the transmitting (66) is connected to another input of a multiplexer (65a), the output of which is carried to a signal input of the CRC generator (65b) while the parallel outputs of the latter are connected to the inputs of an OR gate (65c) which serves as a decoder and the output of which is carried to an input of the status register (62).

23. Installation as in one of the claims 19 to 22, characterized in that the digital function block contains a monitor-error detector 64 to evaluate the bytes emitted from the control module (10) which go from an output of the transmitting unit (66) over two different paths, each to an input of the monitor-error detector 64, whereby the output of the transmitting unit (66) is connected to one input and the output of the reception circuit (24) of every level adaptation circuit (20) is connected to another input of the monitor-error detector 64 whose output is carried to an input of the status register (62).

24. Installation as in one of the claims 19 to 23, characterized in that an interface circuit (25) is installed downstream of the adaptation circuit (26) in the function module (11) and is provided with an input bus (85) which is carried to a parallel input of a shift register (69) whose parallel output in turn is connected to a bus input of an address comparator (71) which serves to compare a received address with a modular address installed in an address coder (72), if necessary to a bus input of a function decoder (73) if a received function byte (II) must be evaluated and to a bus input of an output step (74), whereby the address coder (72) is carried to an additional bus input of the address comparator (71) and a data bus input of the output step (74) is connected to an output bus (86) of the interface circuit (25), and in that a control device (83) as well as an output release gate (84) are available, whereby a serial output of the shift register (69) is connected via the latter to the input of the transmitting unit (27) of the adaptation circuit (26) and the output of one of the two receiving units (28) of the adaptation circuit (26) is connected to a serial input of the shift register (69).

25. Installation as in claim 24, characterized in that the interface circuit (25) of the function module (11) contains a random code generator (77) for the control of a multiple occupation of modular addresses and a module information coder (78) for the adjustment of module information and in that the random code generator (77), the module information coder (78) and the bus input (85) are each connected to a bus input of a bus multiplexer (70) whose output is carried to a parallel input of the shift register (69).

26. Installation as in claim 24 or 25 , characterized in that when a CRC byte transmission occurs the interface circuit (25) of the function module (11) contains a multiplexer (81) whose output is connected to a serial input of a CRC generator (80) serving to produce CRC bytes (V), whereby the serial input and the serial output of the shift register (69) are each connected to an input of the multiplexer (81) and in that an output of the CRC generator (80) is connected via a bus (80a) to an additional bus input of the bus multiplexer (70).

27. Installation as in one of the claims 24 to 26 , characterized in that the input bus (85) of the interface circuit (25) of the function module (11) is connected via an input filter (79) to the bus multiplexer (70).

28. Installation as in one of the claims 24 to 27, characterized in that the interface circuit (25) of the function module (11) contains a monitor-error detector (82), whereby the serial input and the serial output of the shift register (69) are each connected to an input of the monitor-error detector (82).

29. Installation as in one of the claims 24 to 28, characterized in that the output step (74) of the interface circuit (25) of the function module (11) consists of a buffer memory (75) and an output register (76) connected downstream by means of a bus (75a).

30. Arrangement as in one of the claims 2 to 29, characterized in that at least one of the bus rails (12) contains a rail (272) as well as multipole connector elements installed at a parallel in space and in that the function module (11) consists of a terminal strip (274) and an electronics block (275), whereby the terminal strip (274) is provided with connections (276) for cable connections (13) and connector elements (277) to plug in the electronics block (275, while the electronics block (275) in turn is provided with a first set of connector elements (278) to plug in the terminal block (274) and a second set of connector elements to plug in the electronics block (275) into the connector elements (273) of the bus rail (12), whereby all connector elements (273, 277, 278 and 279) are installed in such manner spatially that the electronics block (275) can be pulled out of the corresponding terminal block (274) and from the bus rail (12) nearly simultaneously without requiring disassembly of the terminal block (274) or disconnection of the cable connection (13).

**Revendications**

1. Agencement de surveillance, de commande et de réglage d'une installation de technique d'exploitation (9) d'un système d'automatisation de bâtiment comprenant au moins un module de contrôle (10) de gestion agissant comme émetteur-récepteur maître (10) et au moins un module de fonction (11) agissant comme émetteur-récepteur asservi, qui sont reliés électriquement entre eux par l'intermédiaire d'une liaison de bus (12; 14) comprenant une ligne de bus (12) servant à transférer des adresses, des données et des tensions d'alimentation, au moins un module de fonction (11) qui est relié d'une part à des conducteurs de cette ligne de bus (12) et d'autre part, pour la transmission de valeurs de procédé, à des dispositifs de commande et/ou d'enregistrement de l'installation de technique d'exploitation (9) étant disposé sur la ligne de bus (12) ou sur l'une d'elles, caractérisé en ce que cette ligne de bus (12) est disposé à la périphérie électrique de l'agencement, et au moins ce module de fonction (11) ou l'un de ceux-ci ainsi que ses raccords électriques (276) sont disposés, dimensionnés et réalisés, d'une manière telle que le module de fonction (11) est à la fois la borne d'entrée et/ou de sortie du dispositif, de sorte que ces raccords électriques (276) du module de fonction (11) peuvent être reliés immédiatement à des bornes de raccord de l'installation de technique d'exploitation (9) et que le module de contrôle (11) est disposé de façon séparée dans l'espace et à distance des lignes de bus (12) et des modules de fonction (11).

2. Dispositif selon la revendication 1, caractérisé en ce que le module de fonction (11) est raccordé à cette ligne de bus (12) par des fiches (273, 279) et en ce que les modules de fonction (11) sont mécaniquement à peu près tous semblables et qu'une adresse indépendante de la position est associée à chacun d'eux, de sorte que le module de fonction (11) peut être enfiché individuellement à volonté, tant mécaniquement qu'électriquement, dans l'une quelconque des nombreuses positions disponibles sur l'une des lignes de bus (12), sans qu'il faille, pour garantir un mode de travail correct de l'agencement, modifier le matériel ou le logiciel à cet effet.

3. Agencement selon l'une des revendications 1 ou 2, caractérisé en ce que le module de fonction (11) est réalisé pour le traitement de deux valeurs de processus au plus.

4. Agencement selon l'une des revendications 1 à 3, caractérisé en ce qu'un module de contrôle (10) ou l'un d'eux est disposé à distance de toutes les lignes de bus (12) et que la liaison de bus (12; 14) contient au moins une liaison de bus câblée (14) au moyen de laquelle ce module de contrôle (10) est relié électriquement à un emplacement choisi à volonté avec au moins l'une des lignes de bus (12).

5. Agencement selon la revendication 4, caractérisé en ce qu'il est prévu un module d'alimentation (15) qui peut être enfiché électriquement sur l'une des lignes de bus (12) en vue d'un raccord électrique de la liaison de bus (14) câblée à la ligne de bus (12).

6. Agencement selon l'une des revendications 1 à 5, caractérisé en ce qu'un bus unique est prévu, à l'intérieur de la liaison de bus (12;14), pour la transmission de signaux de données (DA) qui contiennent tant les données à transférer que cette adresse.

7. Agencement selon la revendication 6, caractérisé en ce que l'adresse peut être placée à volonté sur le module de fonction (11).

8. Agencement selon la revendication 6 ou 7 caractérisé en ce que le bus se compose d'un conducteur unique (32) de transmission des signaux de données (DA), que les signaux de données (DA) sont des télégrammes de données et que la transmission des adresses et des données est sérielle dans le temps.

9. Agencement selon la revendication 8, caractérisé en ce que chacun des signaux de données (DA) se compose d'au moins un octet d'adresse (I) et un octet de données (III, IV), tous les types d'octets (I, III, IV) devant être transférés depuis le module de contrôle (10) ou depuis l'un d'eux vers le module de fonction (11) au cours d'un cycle d'écriture alors que, dans un cycle de lecture, seul un octet d'adresse (I) doit respectivement être transféré de l'un à l'autre tandis que chaque octet de donnée (III, IV) doit être transféré dans le cycle de lecture en sens inverse depuis le module de fonction (11) vers le module de contrôle (10).

10. Agencement selon la revendication 8, caractérisé en ce que les signaux de données (DA) se composent au moins d'un octet d'adresse (I) d'un octet de fonction (II) et d'un octet de données (III, IV), tous les types d'octets (I à IV) devant être transférés du module de contrôle (10) ou de l'un d'eux vers le module de fonction (11) dans un cycle d'écriture et les deux premiers types d'octets (I, II) devant être transférés de l'un à l'autre dans un cycle de lecture, tandis que chaque octet de donnée (III, IV) est transféré en sens inverse, dans le cycle de lecture, depuis le module de fonction (11) vers le module de contrôle (10).

**11.** Agencement selon la revendication 8, caractérisé en ce que les signaux de données (DA) se composent au moins d'un octet d'adresse (I), un octet de données (III, IV) et un octet de contrôle de redondance cyclique, ou CRC, (V), les deux premiers types d'octets (I, III, IV) étant transférés depuis le module de contrôle (10) ou depuis l'un d'eux vers le module de fonction (11) pendant un cycle d'écriture et chaque octet d'adresse (I) étant respectivement transféré de l'un à l'autre dans le cycle de lecture, tandis que chaque octet de contrôle de redondance cyclique est toujours transféré en sens inverse, ainsi que chaque octet de donnée (III, IV) lors du cycle de lecture, depuis le module de fonction vers le module de contrôle.

**12.** Agencement selon la revendication 8, caractérisé en ce que les signaux de données (DA) se composent au moins d'un octet d'adresse (I), d'un octet de fonction (II), d'un octet de donnée (III, V) et d'un octet de contrôle de redondance cyclique (V), les trois premiers types d'octets (I, à IV) étant transférés depuis le module de contrôle (10) ou depuis l'un d'eux vers le module de fonction (11) pendant un cycle d'écriture et les deux premiers types d'octets (I, II) étant respectivement transféré de l'un à l'autre dans le cycle de lecture, tandis que chaque octet de contrôle de redondance cyclique est toujours transféré en sens inverse, ainsi que chaque octet de donnée (III, IV) lors du cycle de lecture, depuis le module de fonction vers le module de contrôle.

**13.** Agencement selon l'une des revendication 9 à 12, caractérisé en ce que deux octets de données (III et IV) sont respectivement présents dans les signaux de données (DA).

**14.** Agencement selon l'une des revendications 1 à 13, caractérisé en ce qu'un autre conducteur (30) est prévu dans la liaison de bus (12; 14) pour la transmission d'un signal d'horloge (CLK).

**15.** Agencement selon l'une des revendications 1 à 14, comprenant un potentiel commun (GO) auquel les tensions de tout le système du module ou des modules de contrôle (10) et des dispositifs de l'installation de technique d'exploitation (9) sont rapportés, au moins un premier conducteur (41) d'une paire de conducteurs (40, 41) contenue dans la liaison (12; 14) et servant à la transmission d'une tension continue d'alimentation (V1) étant à ce même potentiel commun (GO), caractérisé en ce que les tensions de signaux transférés (DA, CLK) sont rapportées lors de la transmission par la liaison de bus (12; 14), au potentiel (BEZ) du deuxième conducteur (40) de la paire de conducteurs (40; 41) au lieu de l'être au potentiel (GO) du premier conducteur (41).

**16.** Agencement selon la revendication 15, comprenant au moins un circuit d'ajustement (20) de niveau par module de contrôle (10), chaque circuit d'ajustement (20) de niveau comprenant au moins un circuit d'émission (23), caractérisé en ce qu'il est disposé une source d'alimentation continue (39) par circuit d'ajustement (20) de niveau, pour l'alimentation de tous les circuits d'émission (23) d'un circuit d'ajustement (20) de niveau, le premier pôle de cette source étant relié au deuxième conducteur (40) de la paire de conducteurs (40, 41) et son deuxième pôle étant respectivement relié à un pôle d'alimentation du circuit d'émission respectif (23).

**17.** Agencement selon la revendication 15 ou 16, caractérisé en ce qu'au moins l'une des lignes de bus (12) comporte un autre conducteur pour la transmission d'une tension alternative d'alimentation (V5), un pôle de la tension alternative d'alimentation (25) étant relié au conducteur (41) de la paire de conducteurs (40, 41) et en ce que cet autre conducteur de la ligne de bus (12) est relié électriquement par un module d'alimentation (15) à un conducteur (262) d'une liaison câblée.

**18.** Agencement selon l'une des revendications 15 à 17, caractérisé en ce qu'au moins l'une des lignes de bus (12) comporte deux autres conducteurs pour la transmission d'une tension alternative d'alimentation additionnelle (V6) et en ce que les deux autres conducteurs de la ligne de bus (12) sont reliés électriquement chacun, par un module d'alimentation (15), à un conducteur (263; 264) d'une liaison câblée.

**19.** Agencement selon l'une des revendications 1 à 18, comprenant un micro-ordinateur (50), caractérisé en ce qu'un bloc de fonction numérique commandé par le micro-ordinateur (50) qui gère, lorsqu'il existe plusieurs modules de fonction (11), le raccordement de ces modules à la liaison de bus (12; 14) pour leur transmission est disposé dans le module de contrôle (10) ou dans l'un d'eux.

**20.** Agencement selon la revendication 19, comprenant un circuit d'interface (21) et au moins un circuit d'ajustement (20) de niveau monté en aval du circuit d'interface (21) dans le bloc numérique de fonction et comprenant aussi un circuit d'ajustement (26) disposé à l'entrée de tous les modules de fonction, tous les circuits d'ajustement (20) de niveau et circuits d'ajustement (26) de niveau contenant respectivement des circuits d'émission et de réception (23, 24) ou des unités d'émission et de réception (27, 28), caractérisé en ce que les circuits d'ajustement (20) de niveau se composent respectivement de deux circuits d'émission (23), un pour un signal d'horloge (CLK) et un pour des signaux de données (DA), et d'un circuit de réception (24) pour les signaux de données (DA) et en ce que les circuits d'ajustement (26) se composent respectivement d'une unité d'émission (27) pour les signaux de données (DA) et de deux unités de réception (28), l'une pour le signal d'horloge (CLK) et l'autre pour les signaux de données (DA).

21. Agencement selon la revendication 19 ou 20, caractérisé en ce que le micro-ordinateur (50) est relié par une liaison de bus (55) à une mémoire d'adresses (52) et à un dispositif bidirectionnel de commande (53) de données, en ce qu'il est prévu un appareil de contrôle (54) de direction qui sert à fixer une direction de transmission du dispositif bidirectionnel (53) de commande de données et dont les sorties sont amenées chacune à une entrée de commande du dispositif bidirectionnel (53) de commande de données, et en ce que le bloc numérique de fonction contient un registre d'adresses (58) pour mémoriser un octet d'adresse (I), éventuellement un registre de fonction (58) pour mémoriser un octet de fonction (II) lorsqu'un tel octet doit être transféré, au moins un registre de données (60 ou 61) pour mémoriser un octet de donnée (III, IV), un registre d'état (62) pour mémoriser un état du dispositif, un appareil de contrôle (62a) servant d'appareil de commande, un registre à décalage (63) servant de convertisseur parallèle/série ou série/parallèle, une unité d'émission (66) et une porte Et servant d'une unité de réception, tous les registres (58, 59, 60, 61, 62) étant reliés à la mémoire d'adresses (52) et avec le dispositif bidirectionnel (53) de commande de données et tous les registres (58, 59, 60, 61) à l'exception du registre d'état (62) étant reliés à une entrée/sortie parallèle du registre à décalage (63), dont la sortie sérielle est amenée par l'unité d'émission (66) à l'entrée de l'un des deux circuits d'émission (23) de tous les circuits d'ajustement (20) de niveau, tandis que la sortie de son circuit de réception (24) est respectivement reliée, par la porte Et (67), à une entrée sérielle du registre à décalage (63).

22. Dispositif selon l'une des revendications 19 à 21, caractérisé en ce que le bloc numérique de fonction contient, lors d'une transmission d'un octet de contrôle de redondance cyclique, un générateur de contrôle de redondance cyclique pour l'évaluation de l'octet de contrôle de redondance cyclique (V), la sortie de la porte Et (67) étant reliée à une entrée d'un multiplexeur (65a), et une sortie de l'unité d'émission (66) étant reliée à l'autre entrée de ce multiplexeur, dont la sortie est amenée à une entrée de signaux du générateur (65b) de contrôle de redondance cyclique, tandis que les sorties parallèles de ce dernier sont reliées aux entrées d'une porte Ou (65c), qui sert de décodeur et dont la sortie est amenée à une entrée du registre d'état (62).

23. Dispositif selon l'une des revendications 19 à 22, caractérisé en ce que le bloc numérique de fonction contient un détecteur (64) de défauts d'écoute, pour l'évaluation des octets émis par le module de contrôle (11) qui atteignent, à partir de la sortie de l'unité d'émission (66), par deux trajets différents, chacune des entrées d'un détecteur (64) de défauts d'écoute, la sortie de l'unité d'émission (66) étant reliée à une entrée du détecteur (64) de défauts d'écoute, et la sortie du circuit de réception (24) de tous les circuits d'ajustement (20) de niveau étant reliée à une autre entrée de ce détecteur (64) de défauts d'écoute, dont la sortie est amenée à une entrée du registre à décalage (62).

24. Dispositif selon les revendications 19 à 23, caractérisé en ce qu'il est monté dans le module de fonction, en aval du circuit d'ajustement (26), un circuit d'interface (25) qui comporte un bus d'entrée (85) qui est amené à une entrée parallèle d'un registre à décalage (69) dont la sortie parallèle est elle-même reliée respectivement à une entrée de bus d'un comparateur (71) d'adresses, qui sert à comparer une adresse reçue avec une adresse de module réglée dans un codeur (72) d'adresses, éventuellement à une entrée de bus d'un décodeur de fonction (73), lorsqu'un octet de fonction reçu (II) doit être évalué, et à un étage de sortie (74), le codeur (72) d'adresses étant amené à une autre entrée de bus du comparateur (71) d'adresses et une sortie de bus de donnée de l'étage (66, 74) étant relié à une sortie de bus (86) du circuit d'interface (25), et en ce qu'un appareil de commande (83) ainsi qu'une porte de validation de sortie (84) sont prévus, une sortie sérielle du registre à décalage (69) étant reliée par cette porte à l'entrée de l'unité d'émission (27) du circuit d'ajustement (26) et la sortie de l'une des deux unités de réception (28) du circuit d'ajustement (26) étant reliée à une entrée sérielle du registre à décalage (69).

25. Dispositif selon la revendication 24, caractérisé en ce que le circuit d'interface (25) comprend du module de fonction (11) comprend un générateur de code aléatoire (77), disposé de manière à contrôler une occupation multiple d'adresses de modules, et un codeur (78) d'information de module, pour régler des informations de module, et en ce que le générateur de code aléatoire (77), le codeur (78) d'informations de module et le bus d'entrée (85) sont raccordés chacun à une entrée de bus d'un multiplexeur (70) de bus dont la sortie est amenée à une entrée parallèle du registre à décalage (69).

26. Agencement selon la revendication 24 ou 25, caractérisé en ce que le circuit d'interface (25) du module de fonction (11) contient, dans les cas de transmission d'octet de contrôle de redondance cyclique, un multiplexeur (81) dont la sortie est reliée à une entrée sérielle d'un générateur (80) de contrôle de redondance cyclique qui sert à engendrer l'octet de contrôle de redondance cyclique (V), l'entrée sérielle et la sortie sérielle du registre à décalage (69) étant reliées chacune à une entrée du multiplexeur (80), et en ce qu'une sortie du générateur (80) de contrôle de redondance cyclique est raccordée par un bus (80a) à une autre entrée de bus du multiplexeur (70) de bus.

27. Agencement selon l'une des revendications 24 à 26, caractérisé en ce que le bus d'entrée du circuit d'interface (25) du module de fonction (11) est raccordé par un filtre d'entrée (79) au multiplexeur (70) de bus.

28. Agencement selon l'une des revendications 24 à 27, caractérisé en ce que le circuit d'interface (25) du module de fonction (11) contient un détecteur (82) de défauts d'écoute, l'entrée sérielle et la sortie sérielle du registre à décalage (69) étant reliées chacune à l'entrée du détecteur (82) de défauts d'écoute.

29. Agencement selon l'une des revendications 24 à 28, caractérisé en ce que l'étage de sortie (74) du circuit d'interface (25) et du module de fonction (11) se compose d'une mémoire tampon (75) et d'un registre de sortie (76) monté en aval au moyen d'un bus (75a).

30. Agencement selon l'une des revendications 2 à 29, caractérisé en ce qu'au moins l'une des lignes (12) de bus contient une ligne (272) ainsi que des fiches multipolaires (273) disposées en parallèle dans l'espace, et en ce que le module de fonction (11) se compose d'un bloc de bornes (274) et d'un bloc d'électronique (275), le bloc de bornes (274) possédant des raccords (276) pour des liaisons câblées (13) et des fiches (277) pour enficher le bloc d'électronique (275), tandis que le bloc d'électronique (275) possède lui-même des premières fiches (278) pour l'enfichage du bloc de bornes (274) et des deuxièmes fiches (279) pour l'enfichage du bloc d'électronique (275) dans les fiches (273) de la ligne (12) de bus, toutes les fiches (273, 277 et 279) étant disposées dans l'espace d'une manière telle que le bloc d'électronique (275) peut être retiré à peu près simultanément du bloc de bornes associé (274) et de la ligne de bus (12), sans qu'il soit nécessaire de démonter alors le bloc de bornes (274) et sans que la liaison (13) câblée doive être détachée.

# Fig. 1

# Fig. 2

# Fig. 3

# Fig. 4

Fig.5

Fig. 7

Fig. 6

Fig. 8

# Fig. 9

Fig. 10

# Fig. 11

# Fig. 12

# Fig.13

# Fig.14

# Fig.15

Fig. 16

Fig. 17

# Fig. 18

# Fig. 19

# Fig. 20

# Fig. 21

# Fig.22

EDG

CLK

116

230  231  233  234

232  D  Q

4 MHz

# Fig.23

88

87

235

85

86  236

13

44

# Fig.24

238  44

86  D / A  240  241  13

I

237  D / A  240  241  13

II

239

# Fig.25

# Fig.26

# Fig.27

## Fig. 28

## Fig. 29

EP 0 345 493 B1

Fig. 30

Fig. 31

62

**Fig.32**

280

10;11

281

282

283

284

285

286

13

9

**Fig. 33**

280

14

10

11

12

276

13

9

# Fig. 34